(19) Europäisches Patentamt
European Patent Office
Office européen des brevets

(11) **EP 1 634 351 B1**

(12) **EUROPÄISCHE PATENTSCHRIFT**

(45) Veröffentlichungstag und Bekanntmachung des Hinweises auf die Patenterteilung:
**30.04.2008  Patentblatt 2008/18**

(51) Int Cl.:
*H01Q 1/36* (2006.01)     *G01R 33/035* (2006.01)
*H01L 39/12* (2006.01)

(21) Anmeldenummer: **04738661.0**

(22) Anmeldetag: **14.06.2004**

(86) Internationale Anmeldenummer:
**PCT/DE2004/001209**

(87) Internationale Veröffentlichungsnummer:
**WO 2004/114463 (29.12.2004 Gazette 2004/53)**

(54) **SUPRALEITENDE QUANTENANTENNE**

SUPERCONDUCTIVE QUANTUM ANTENNA

ANTENNE QUANTIQUE SUPRACONDUCTRICE

(84) Benannte Vertragsstaaten:
**AT BE BG CH CY CZ DE DK EE ES FI FR GB GR HU IE IT LI LU MC NL PL PT RO SE SI SK TR**

(30) Priorität: **13.06.2003  DE 10327061**

(43) Veröffentlichungstag der Anmeldung:
**15.03.2006  Patentblatt 2006/11**

(73) Patentinhaber: **QEST Quantenelektronische Systeme GmbH**
**72768 Reutlingen (DE)**

(72) Erfinder:
• **OPPENLÄNDER, Jörg**
  **72138 Kirchentellinsfurt (DE)**
• **HÄUSSLER, Christoph**
  **72762 Reutlingen (DE)**
• **SCHOPOHL, Nils**
  **72766 Reutlingen (DE)**
• **FRIESCH, Alexander**
  **72072 Tübingen (DE)**
• **TOMES, Jörg**
  **72076 Tübingen (DE)**

(74) Vertreter: **Dobler, Markus**
**Karlstrasse 8**
**88212 Ravensburg (DE)**

(56) Entgegenhaltungen:
WO-A-01/25805          WO-A-99/06777
JP-A- 2003 023 362     US-B1- 6 363 268

• PATENT ABSTRACTS OF JAPAN Bd. 0161, Nr. 47 (P-1336), 13. April 1992 (1992-04-13) & JP 4 002979 A (SEIKO INSTR INC), 7. Januar 1992 (1992-01-07)

**Beschreibung**

Die vorliegende Erfindung betrifft eine aktive hochsensitive Antenne für elektromagnetische Wellen gemäß dem Oberbegriff des Anspruch 1.

Stand der Technik:

Die Funktionsweise konventioneller elektrischer Empfangsantennen beruht im wesentlichen darauf, dass eine einfallende elektromagnetische Welle einen Spannungsabfall über die Antenne induziert, welcher das Eingangssignal für die Empfangselektronik darstellt. Im Allgemeinen ist der induzierte Spannungsabfall jedoch so klein, dass er zunächst mit Hilfe von Resonanzeffekten verstärkt werden muss. Die konventionelle Antenne wird dabei entweder selbst derart ausgelegt, dass bei der Empfangsfrequenz eine geometrische Resonanz auftritt, oder die Antenne wird mit einem elektrischen Anpassungsnetzwerk versehen, so dass Antenne und Anpassungsnetzwerk einen resonanten Schwingkreis bilden.

Durch die für die Erzielung einer ausreichenden Sensitivität notwendige Resonanzverstärkung ist die Frequenzbandbreite, innerhalb derer ein Empfang möglich ist, bei konventionellen Antennen stark eingeschränkt. Typischerweise ist die Bandbreite kleiner als 20% der Resonanzfrequenz. Eine größere Bandbreite kann mit sogenannten "frequenzunabhängigen" logarithmischen Spiralantennen erreicht werden. Die Ausdehnung der Antenne muss jedoch auch hier im Bereich der Wellenlänge der zu empfangenden elektromagnetischen Welle liegen und die Sensitivität solcher Antennen ist meist klein.

Magnetische Rahmenantennen können im Prinzip zwar breitbandiger ausgelegt werden als elektrische Antennen, bei höheren Frequenzen sind sie jedoch wegen des Auftretens induktiver Effekte und wegen des Skin-Effekts nicht einsetzbar. Zudem kann bei konventionellem Betrieb die Impedanz magnetischer Rahmenantennen nur schwer an die Impedanz konventioneller Elektronikschaltungen angepasst werden und die Effizienz der Antennen nimmt dadurch stark ab.

Ein weiteres Problem tritt bei konventionellen Antennensystemen dann auf, wenn elektromagnetische Wellen sehr kleiner Signalstärke empfangen werden sollen. Die Eingangsempfindlichkeit konventioneller Antennensysteme ist prinzipiell durch das Rauschen des auf die Antenne folgenden Vorverstärkers limitiert. Das von der Antenne kommende Eingangssignal muss über der Rauschschwelle des Vorverstärkers liegen, damit es nutzbar verstärkt werden kann. Zum Empfang sehr kleiner Signale ist es bei konventionellen Empfangssystemen daher notwendig, dass die Antenne dem elektromagnetischen Feld ausreichend viel Energie entzieht. Dies kann bei sehr kleinen Signalstärken konventionell nur dadurch erreicht werden, dass z.B. sehr große Antennen, Parabolspiegel oder ganze Felder von Antennen verwendet werden. In jedem Fall nimmt die räumliche Ausdehnung der Antenne dabei stark zu. Eine typische Anwendung, bei der kleine Signalstärken vorliegen, ist z.B. der Empfang von Satellitensignalen. Hier liegt die Ausdehnung der Antenne typischerweise im Bereich von einem Meter.

Insbesondere für den mobilen Einsatz, etwa in Fahrzeugen, Schiffen oder Flugzeugen, sind Parabolantennen oder Antennenfelder wegen ihrer großen Abmessungen nicht oder nur sehr eingeschränkt geeignet.

Da konventionelle Antennensysteme dem elektromagnetischen Feld Energie entziehen müssen, um die im Feld enthaltene Information zu verarbeiten, ist bei einer gegebenen Sendeleistung die Reichweite von Sendeantennen durch die Zahl der Empfänger zudem prinzipiell begrenzt.

Aus der japanischen Offenlegungsschrift JP 2003023362 A ist eine tieftemperaturtaugliche aktive Schaltung für ein Antennensystem bekannt. In der internationalen Patentanmeldung PCT/DE 00/03034 ist eine Vorrichtung zur hochauflösenden Messung von magnetischen Feldern offenbart, die einen supraleitenden Quanten-Interferenz-Filter umfasst. Der supraleitende Quanten-Interferenz-Filter besitzt ein Netzwerk von Übergängen zwischen Supraleitern, die Josephson-Effekte zeigen.

Der Erfindung liegt das Problem zugrunde, die Limitierungen konventioneller Empfangsantennen hinsichtlich ihrer Empfindlichkeit und ihrer Abmessungen zu überwinden.

Dieses Problem wird durch die im Patentanspruch 1 aufgeführten Merkmale gelöst.

Die Erfindung geht von einer Antenne für elektromagnetische Wellen hoher Frequenz aus, die eine normalleitende und/oder supraleitende elektrische Verschaltung von wenigstens einem tieftemperaturtauglichen Transistor und primären Antennenstrukturen besitzt. Des weiteren sind zur Versorgung der Verschaltung mit elektrischer Energie Mittel zur Versorgung der Verschaltung mit einem Steuerstrom und/oder einer Steuerspannung und Mittel zur Ableitung einer elektromagnetischen Welle von der Verschaltung vorgesehen. Der Kern der Erfindung liegt darin, dass ein aktiver Kühler vorgesehen ist, welcher wenigstens einem Teil der Verschaltung während des Betriebs Wärme entziehen kann. Des weiteren ist ein Vakuumgefäß vorhanden, welches wenigstens einen Teil der Verschaltung und der primären Antennenstruktur enthält und mit welchem dieser Teil gegenüber der Umgebung thermisch isoliert werden kann, wobei der Transistor als aktives Bauelement wirkt, das Vakuumgefäß den Kühlfinger des aktiven Kühlers enthält, der Kühlfinger thermisch an mindestens einen normalleitenden und/oder supraleitenden Hohlleiterabschluss der primären Antennenstruktur angekoppelt ist, das aktive Bauelement thermisch an den Kühlfinger angekoppelt ist, das aktive Bauelement an den Hohlleiterabschluss elektromagnetisch angekoppelt ist, das Vakuumgefäß ein für elektromagnetische Wellen durchlässiges Fenster besitzt und geometrisch derart ausgebildet ist, dass eine elektromagnetische Welle in den Hohlleiterabschluss eingespeist werden kann, und der aktive Kühler dazu ausgelegt ist, zumindest einen Teil der Verschaltung unter eine vergleichsweise tiefe Temperatur von z.B. 150 Kelvin herunterzukühlen.

Die mit der Erfindung erzielten Vorteile liegen darin, dass aufgrund ihres Funktionsprinzips unter Nutzung die Antenne dem elektromagnetischen Feld keine oder nur eine sehr geringe Menge an Energie entzieht und damit den Empfang sehr kleiner Signale bei sehr kleiner Abmessung der Antenne selbst ermöglicht. Um die Empfindlichkeit einer Parabolantenne von ca. 60 cm Durchmesser zu erreichen, reicht typischerweise eine erfindungsgemäße Antenne von ca. 1 cm x 1 cm aus. Zudem kann die Antenne so ausgelegt werden, dass ihre Bandbreite nur durch die Grenzfrequenz des verwendeten supraleitenden Quanten-Interferenz-Filters begrenzt wird. Diese Grenzfrequenz liegt typischerweise im Bereich von 20 GHz bis 100 GHz, so dass entsprechende Bandbreiten erreichbar sind.

Vorzugsweise umfasst die Antenne einen supraleitenden Quanten-Interferenz-Filter, wobei der supraleitende Quanten-Interferenz-Filter und der Transistor als aktive Bauelemente wirken, die aktiven Bauelemente thermisch an den Kühlfinger angekoppelt sind, und wenigstens ein aktives Bauelement an den Hohlleiterabschluss elektromagnetisch angekoppelt ist.

Ein supraleitender Quanten-Interferenz-Filter weist folgende grundlegende Merkmale auf:

Geschlossene supraleitende eine Stromschleife bildende Zellen, die jeweils mehrere, vorzugsweise zwei Josephson-Kontakte enthalten,

wenigstens drei dieser Zellen stehen supraleitend oder nicht supraleitend in Verbindung,

die Kontakte der wenigstens drei Zellen sind derart bestrombar, dass jeweils über mindestens zwei Kontakte einer Zelle eine zeitveränderliche Spannung abfällt, deren zeitliches Mittel nicht verschwindet,

die wenigstens drei Zellen sind auf eine Weise geometrisch unterschiedlich ausgestaltet, dass die bei einem vorhandenen magnetischen Feld von den Zellen eingeschlossenen magnetischen Flüsse sich derart unterscheiden, dass das Frequenzspektrum der Spannungsantwortfunktion in Bezug auf den magnetischen Fluss keinen signifikanten $\Phi_0$-periodischen Anteil besitzt, oder dass, falls ein diskretes Frequenzspektrum existiert, der Beitrag des $\Phi_0$-periodischen Anteils des diskreten Frequenzspektrums im Vergleich zu den nicht periodischen Anteilen des diskreten Frequenzspektrums nicht dominant ist.

In der deutschen Offenlegungsschrift DE 100 43 657 A1 ist nicht nur die beschriebene Grundform eines supraleitenden Quanten-Interferenz-Filters, im Folgenden auch als SQIF bezeichnet, beschrieben, sondern auch eine Vielzahl von Weiterbildungen entsprechend den nachstehenden Ausführungen A1) bis A12).

A1) Im Hinblick auf die Periodizität der Spannungsantwortfunktion kann für das SQIF auch der folgende funktionale Ansatz gewählt werden: Dass die wenigstens drei Zellen derart geometrisch unterschiedlich ausgestaltet sind, dass die bei einem vorhandenen magnetischen Feld von den Zellen eingeschlossenen magnetischen Flüsse derart in einem Verhältnis zueinander stehen, dass die Periode der Spannungsantwortfunktion des Netzwerks in Bezug auf den die Netzwerkzellen in ihrer Gesamtheit durchsetzenden magnetischen Fluss größer oder sehr viel größer als der Wert eines elementaren Flussquants ist bzw, die Spannungsantwort keinen $\Phi_0$-periodischen Anteil mehr aufweist. Im Idealfall besitzt die Spannungsantwortfunktion keine Periode mehr, wenn die von den Zellen eingeschlossenen magnetischen Flüsse in keinem rationalen Verhältnis zueinander stehen. Vorzugsweise sind zusätzlich die Flächenunterschiede der einzelnen Zellen vergleichsweise groß. Insbesondere in diesem Fall superpositionieren supraleitend verbundene Zellen in einer Weise, dass die Spannungsantwortfunktion keine Periode mehr aufweist.

Somit werden gezielt unterschiedliche Zellen miteinander verschaltet, was der Fachmann bei herkömmlichen SQUID-Anordnungen immer vermeiden möchte. Dies kommt beispielsweise in der Veröffentlichung von HANSEN, BINSLEV J., LINDELOF P.E.: Static and dynamic interactions between Josephson junctions. In: Reviews of Modern Physics, Vol. 56, No. 3, July 1984, S. 431 - 459; zum Ausdruck. In dieser Veröffentlichung wird auf S. 434, linke Spalte, letzter Absatz sowie folgend auf der rechten Spalte ein System mit identischen Zellen und identischen Kontakten favorisiert und dagegen Unsymmetrien als kontraproduktiv für die Funktion des diesbezüglich beschriebenen SQUIDs eingestuft.

Supraleitende Quanten-Interferenz-Filter zeigen den physikalischen Effekt der multiplen makroskopischen Quanten-Interferenz auf eine Weise, dass die Mehrdeutigkeit der Eichkurven herkömmlicher SQUID-Magnetometer und -Gradiometer beseitigt wird.

In einem supraleitenden Quanten-Interferenz-Filter interferieren die quantenmechanischen Wellenfunktionen, welche den Zustand des supraleitenden Festkörpers beschreiben, derart, dass eine eindeutige makroskopische Eichkurve $\left\langle V(\vec{B}; I_0) \right\rangle$ entsteht. Die Eichkurve $\left\langle V(\vec{B}; I_0) \right\rangle$ des supraleitenden Quanten-Interferenz-Filters besitzt im Idealfall keine Periodizität mit der Periode $\Phi_0$ und ist eine in einem bestimmten Messbereich monoton steigende Funktion des Betrags des äußeren magnetischen Feldes $\vec{B}$ am Ort des SQIF.

Die Eindeutigkeit der Eichkurve und die hohe Empfindlichkeit von supraleitenden Quanten-Interferenz-Filtern erlauben die direkte Messung zeitveränderlicher elektromagnetischer Felder in einem kontinuierlichen Frequenzbereich, dessen untere Schranke bei $\nu_{ext} \approx 0$ und dessen obere Schranke je nach Art der verwendeten Josephsonkontakte oder weak links zur Zeit bei mehreren hundert GHz bis THz liegt. Dieser gesamte Frequenzbereich ist mit einem einzigen entsprechend ausgelegten supraleitenden Quanten-Interferenz-Filter zugänglich. Bei der Detektion elektromagnetischer Wellen operiert der supraleitende Quanten-Interferenz-Filter simultan als Empfangsantenne, Filter und leistungsfähiger Verstärker. Das Eigenrauschen von geeignet ausgelegten Quanten-Interferenz-Filtern kann dabei um mehrere Größenordnungen kleiner sein als das Eigenrauschen konventioneller SQUID-Magnetometer. Ein weiterer Vorteil gegenüber herkömmlichen Antennen und Filtern liegt dabei unter anderem darin, dass bedingt durch das Messprinzip der Frequenzbereich nicht von der räumlichen Ausdehnung des supraleitenden Quanten-Interferenz-Filters abhängt. Die räumliche Ausdehnung kann lediglich die Empfindlichkeit beeinflussen.

Die Herstellung von supraleitenden Quanten-Interferenz-Filtern kann nach bekannten kostengünstigen technischen Verfahren erfolgen, wie sie etwa in der modernen Fertigung konventioneller SQUIDs angewandt werden. Da sich die räumliche Ausdehnung von supraleitenden Quanten-Interferenz-Filtern nicht wesentlich von der räumlichen Ausdehnung konventioneller SQUID-Systeme unterscheiden muss, können die für konventionelle SQUID-Systeme entwickelten Kryotechnologien direkt übernommen werden. Spezielle Entwicklungen auf dem Gebiet der Kryotechnologie sind nicht nötig.

A2) Vorzugsweise sind in einem System aus oben beschriebenen Zellen zumindest für eine Zelle, günstigerweise für den größten Teil der Zellen genau zwei Kontakte pro Zelle vorgesehen, welche supraleitend verbunden und elektrisch parallel geschaltet sind. Durch genau zwei Kontakte lassen sich die soeben beschriebenen Effekte vergleichsweise einfach und gut erreichen.

A3) Die gewünschten Effekte lassen sich jedoch auch in günstiger Weise erzielen, wenn in einer Zelle mehr als zwei Kontakte vorgesehen sind, die supraleitend verbunden und elektrisch parallel geschaltet sind, und zwar in Form einer Serienschaltung von Kontakten, die mit einem Einzelkontakt parallel geschaltet ist, oder in Form von zwei parallel geschalteten Serienschaltungen von Kontakten.

A4) Die erfindungsgemäßen Effekte lassen sich jedoch auch durch Strukturen wenigstens einer Zelle eines Netzwerks erreichen, bei denen neben einer Grundform von mindestens zwei Kontakten, an welchen eine im zeitlichen Mittel nicht verschwindende, zeitveränderliche Spannung abfällt, insbesondere neben einer Grundform von zwei elektrisch parallel geschalteten Kontakten, ein weiterer Kontakt oder mehrere weitere Kontakte vorgesehen sind, welche Kontakte nicht direkt bestromt werden und daher an diesen Kontakten im Mittel keine Spannung abfällt. Die Verbindungen aller Kontakte in den einzelnen Zellen ist dabei weiterhin supraleitend. Solche Ausführungsformen können von Vorteil sein, da durch zusätzliche Kontakte die von einem magnetischen Feld in den einzelnen Zellen induzierten Abschirmströme reduziert werden können. Der Einfluss von Eigen- und Gegeninduktivitäten kann dadurch vermindert werden.

A5) In einer besonders bevorzugten Ausführungsform bilden mehrere Zellen ein Netzwerk oder einen Netzwerkabschnitt, in welchem alle Kontakte elektrisch parallel geschaltet sind, so dass die Kontakte gleich gerichtet bestrombar sind. Insbesondere, wenn in diesem Zusammenhang die Zellen supraleitend miteinander in Verbindung stehen, lassen sich durch eine derartige Anordnung besonders große Empfindlichkeiten für die Messung eines Magnetfeldes erzielen.

A6) Mehrere Zellen oder Netzwerkabschnitte lassen sich vorteilhafterweise jedoch auch elektrisch in Reihe schalten, so dass wiederum die Kontakte im Netzwerk in der gleichen Richtung bestrombar sind. Durch diese Maßnahme kann die Größe des Messsignals erhöht werden, da sich in der Reihenschaltung die Spannungen an den Kontakten addieren.

A7) Eine besonders hohe Empfindlichkeit kann auch durch die Parallelschaltung von Serienanordnungen mehrerer Zellen oder Netzwerkabschnitte erreicht werden. Vorzugsweise sind in dieser Ausführungsform die Netzwerkabschnitte oder Zellen supraleitend verschaltet, insbesondere durch supraleitende twisted-pair-Kabel. Das Auflösungsvermögen von supraleitenden Quanten-Interferenz-Filtern kann dabei bis in den Bereich von aT ($10^{-18}$ Tesla) und darunter reichen. Die Eichkurve bleibt auch für solche Messbereiche eindeutig, so dass absolute quantitative Messungen von extrem kleinen Feldern möglich werden.

A8) Das Netzwerk kann spannungsgetrieben oder stromgetrieben eingesetzt werden.

A9) Um möglichst ideale Josephson-Effekte zu erzielen, wird überdies vorgeschlagen, dass die Kontakte als Punktkontakte ausgeführt sind.

A10) Um die Empfindlichkeit eines SQIF zu erhöhen, kann außerdem die Geometrie der Zellenanordnung derart ausgeführt werden, dass ein magnetisches Übersprechen einer Zelle auf eine benachbarte Zelle aufgrund des durch einen in den Zellen fließenden Stroms hervorgerufenen magnetischen Eigenfeldes reduziert wird.

A11) In einer weiteren bevorzugten Ausgestaltung sind die Zellen des Netzwerkes und/oder Netzwerkabschnitte räumlich, insbesondere räumlich zwei- oder dreidimensional ausgerichtet. Durch diese Maßnahme wird es möglich, zusätzlich zum Betrag des Magnetfeldes einzelne Magnetfeldkomponenten zu bestimmen. Bei einer räumlich dreidimensionalen Anordnung lässt sich somit die Richtung des Magnetfelds messen.

A12) Im Weiteren ist es bevorzugt, wenn der die Kontakte treibende Strom durch ohmsche Widerstände, welche insbesondere als bus-bar-Widerstände ausgeführt sind, eingespeist und/oder wieder abgeführt wird. Denn Messungen haben gezeigt, dass die Einspeisung des treibenden Stroms durch ohmsche Widerstände die Performance des SQIF erheblich verbessern kann.

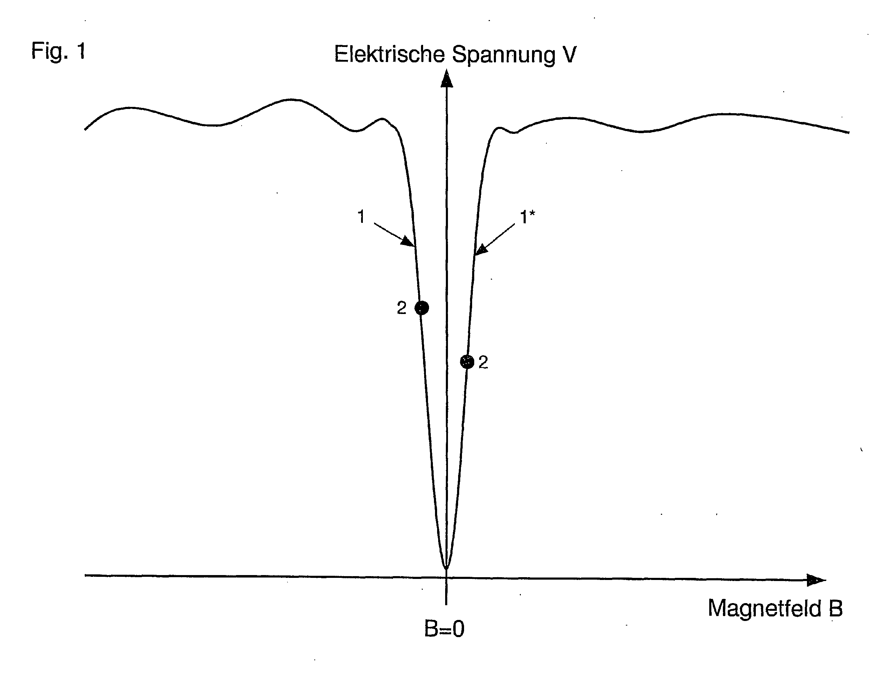

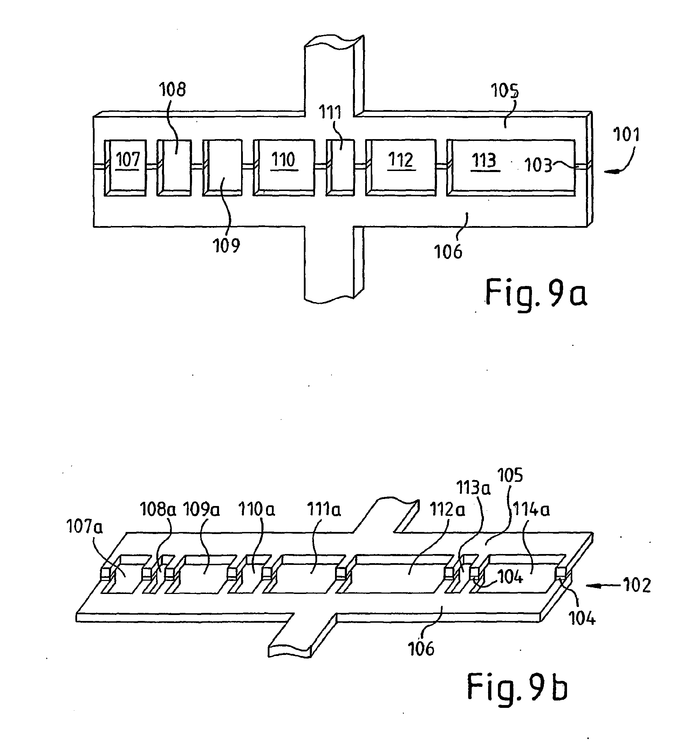

Für weitere Ausgestaltungen von SQIFs wird auf die Figuren 9a bis 20 und deren dazugehörigen Beschreibungsteile im Anschluss an die Figurenbeschreibung zu den Figuren 1 bis 8 verwiesen.

Wird der supraleitende Quanten-Interferenz-Filter in Hochtemperatur-Supraleitungstechnologie gefertigt, können problemlos Miniaturkühler zur dauerhaften und zuverlässigen Bereitstellung der Betriebstemperatur verwendet werden. Diese Miniaturkühler besitzen typischerweise Abmessungen im Bereich von 10 cm und benötigen Leistungen kleiner 20 W, so dass kompakte Antennensysteme realisiert werden können, die auch den mobilen Einsatz der Antenne in verschiedensten Anwendungen erlauben.

Die Antenne benutzt zur Steigerung der Sensitivität das physikalische Phänomen der multiplen makroskopischen Quanteninterferenz. Dieses Phänomen tritt in supraleitenden Schaltkreisen auf, welche eine spezielle Geometrie besitzen. Beim supraleitenden Quanten-Interferenz-Filter wird es dazu verwendet einen hochleistungsfähigen, rauscharmen Breitbandverstärker zu realisieren. Im einfachsten Fall wird dieser Verstärker induktiv an eine primäre, passive Antennenstruktur angekoppelt. Beim Einfall einer elektromagnetischen Welle fließt in dieser primären Antennenstruktur ein Antennenstrom. Dieser Antennenstrom erzeugt ein magnetisches Feld, welches den supraleitenden Quanten-Interferenz-Filter durchsetzt. Wird der supraleitende Quanten-Interferenz-Filter geeignet mit elektrischem Strom versorgt und auf einem geeigneten Arbeitspunkt betrieben, dann fällt über dem supraleitenden Quanten-Interferenz-Filter eine Spannung ab, die von der Stärke des magnetischen Felds und damit von der Stärke des Antennenstroms abhängt. Da die Erregung des supraleitenden Quanten-Interferenz-Filters durch die quantenmechanische Zwangsbedingung der sogenannten Flussquantisierung hervorgerufen wird, wird bei diesem Vorgang keine oder nur eine sehr geringe Menge an Energie von der primären Antennenstruktur auf den supraleitenden Quanten-Interferenz-Filter übertragen. Die Leistung, die notwendig ist, um den Spannungsabfall über den supraleitenden Quanten-Interferenz-Filter zu erzeugen, wird der Stromquelle entzogen, welche den supraleitenden Quanten-Interferenz-Filter mit Betriebsstrom versorgt. Im Gegensatz zu konventionellen Antennen muss der Antenne und damit der einfallenden Welle keine Energie entzogen werden, um den supraleitenden Quanten-Interferenz-Filter zu erregen. Reine Blindströme reichen für eine Erregung bereits aus. Die Primärantenne wird bei der Übertragung der in der elektromagnetischen Welle enthaltenen Information an den supraleitenden Quanten-Interferenz-Filter nicht belastet. Da keine Energie von der Primärantenne zum supraleitenden Quanten-Interferenz-Filter fließt, ist keine Impedanzanpassung erforderlich. Dies ermöglicht bei der Verwendung entsprechender primärer Antennenstrukturen die Realisierung von extrem breitbandigen Empfangsantennen sehr hoher Sensitivität.

Die primäre Antennenstruktur kann dabei aus supraleitenden Leiterstücken oder aus normalleitenden Leiterstücken bestehen. Auch eine Kombination aus beiden ist möglich. Supraleitende Leiterstücke haben den Vorteil, dass ein sehr hoher Antennenstrom fließt, im Resonanzfall ist die Resonanz jedoch in der Regel sehr schmalbandig. In normalleitenden Leiterstücken fließt typischerweise ein geringerer Antennenstrom, die Resonanzen sind jedoch breitbandiger. Je nach Anwendung und erforderlicher Empfindlichkeit kann damit eine jeweils optimale primäre Antennenstrukturen konzipiert werden.

Um eine hohe Empfindlichkeit der Antenne zu erzielen, muss die primäre Antennenstruktur genügend stark an den supraleitenden Quanten-Interferenz-Filter angekoppelt sein. Im einfachsten Fall kann dies bei einer einlagigen Schichtstruktur dadurch erreicht werden, dass der Teil der primären Antenne, der in den supraleitenden Quanten-Interferenz-Filter eingekoppelt werden soll, möglichst dicht an den Schlaufen des supraleitenden Quanten-Interferenz-Filter vorbeiführt und einen möglichst kleinen Leiterquerschnitt besitzt. Das vom Antennenstrom erzeugte magnetische Feld hat dann am Ort der Schlaufen einen maximal großen Wert. Allgemein ist die Einkopplung immer dann besonders vorteilhaft, wenn die Stromdichteverteilung der primären Antennenströme am Ort möglichst vieler Schlaufen des supraleitenden Quanten-Interferenz-Filters oder in deren Nähe sehr groß bzw. maximal ist. Um die bei Anwesenheit eines zeitveränderlichen Antennenstroms über dem supraleitenden Quanten-Interferenz-Filter abfallende Spannungsoszillation (Ausgangssignal der Antenne) abzuleiten bzw. an einen Verbraucher (Empfänger) weiterzuleiten, ist eine Auskoppelstruktur vorgesehen. Mit Hilfe dieser Auskoppelstruktur wird die Spannungsoszillation in eine elektromagnetische Welle umgewandelt und mit einem geeigneten Wellenleiter an den Verbraucher weitergeleitet, so dass parasitäre Verluste möglichst klein gehalten werden.

Supraleitende Quanten-Interferenz-Filter sind wegen ihrer intrinsischen Robustheit und Fehlertoleranz in besonderer Weise als sekundäre Antennenstrukturen bzw. integrierte Vorverstärker geeignet. Sie bieten gegenüber herkömmlichen supraleitenden Magnetfeld-Spannungswandlern eine Reihe von wesentlichen Vorteilen. Insbesondere besitzen supraleitende Quanten-Interferenz-Filter im Gegensatz zu herkömmlichen SQUIDs oder SQUID-Arrays eine eindeutige Kennlinie. Während bei SQUIDs oder SQUID-Arrays wegen der Periodizität der Kennlinie besondere Vorkehrungen zur Abschirmung parasitärer magnetischer Felder getroffen werden müssen, ist dies bei supraleitenden Quanten-Interferenz-Filtern prinzipiell nicht notwendig. Auch kann der Transferfaktor zwischen magnetischem Feld und abfallender Spannung grundsätzlich beliebig der zu lösenden Verstärkeraufgabe angepasst werden. Wegen der Robustheit supraleitender Quanten-Interferenz-Filter muss das von den primären Antennenstrukturen in den supraleitenden Quanten-Interferenz-Filter eingekoppelte magnetische Feld keine Homogenitätsbedingung erfüllen. Der supraleitende Quanten-Interferenz-Filter kann ohne Leistungsverlust auch durch stark inhomogene magnetische Felder erregt werden. Zudem sind supraleitende Quanten-Interferenz-Filter wegen ihrer hohen intrinsischen Toleranz gegenüber Parameterimperfektionen sehr viel einfacher herzustellen als etwa SQUID-Arrays. Die intrinsische Fehlertoleranz hat auch zur Folge, dass die verschiedensten supraleitenden Materialen verwendet werden können.

Eine vorteilhafte Ausgestaltung der Erfindung sieht vor, dass die Antenne zusätzliche Mittel zur Ansteuerung eines geeigneten Arbeitspunkts auf der Kennlinie des supraleitenden Quanten-Interferenz-Filters enthält (z.B. bestrombare Steuerleitungen, Magnetfeldspulen). Dies ermöglicht es, den supraleitenden Quanten-Interferenz-Filter in einem Bereich der Kennlinie zu betreiben, in dem dieser das Signal optimal verstärkt. Zudem kann ein Bereich hoher Linearität der Kennlinie angesteuert werden, um unerwünschte Intermodulationsprodukte zu minimieren. An einem solchen Arbeitspunkt ist die Frequenz der über den supraleitenden Quanten-Interferenz-Filter abfallenden Spannung mit der Frequenz des Antennenstroms identisch.

Für den Empfang elektromagnetischer Wellen hoher Frequenz ist es von Vorteil, wenn der Ausgang des supraleitenden Quanten-Interferenz-Filters möglichst unmittelbar, d.h. mit möglichst kleiner Leitungslänge, mit der konventionellen Elektronik des Antennensystems verbunden ist. Dies kann mit Hilfe tieftemperaturtauglicher Transistoren, wie z.B. HEMT oder MOS-FET Transistoren, erreicht werden. Diese können im kalten Teil des Antennensystems, d.h. dort wo die für den Betrieb des supraleitenden Quanten-Interferenz-Filters notwendige tiefe Temperatur herrscht, betrieben werden. Eine solche Verschaltung muss zumindest teilweise thermisch isoliert werden, etwa dadurch, dass sie wenigstens zum Teil in einem Vakuumgefäß angeordnet wird, damit sie durch aktive oder passive Kühlelemente auf die geeignete Betriebstemperatur gebracht werden kann. Als Kühlelemente sind insbesondere sowohl Flüssiggase, wie z.B. flüssiger Stickstoff oder flüssiges Helium, wie auch aktive Kühler, wie z.B. Sterling-, Joule-Thomson-, oder Pulsröhrenkühler, geeignet. Diese Kühlelemente können mit nach dem Stand der Technik bekannten Verfahren so ausgelegt werden, dass sie dem thermisch isolierten Teil der Verschaltung und/oder Teilen der primären Antennenstruktur während des Betriebs ausreichend viel Wärme entziehen können.

Der thermisch isolierte Teil der primären Antennenstruktur ist mindestens an einer Stelle derart beschaffen, dass er für eine elektromagnetische Welle der erwünschten Frequenz durchlässig ist. Dieses sogenannte Fenster kann je nach Frequenzbereich in dem die Antenne wirken soll aus verschiedenen Materialien, wie etwa Teflon, Quarzglas, Aluminiumoxid, Keramik etc., bestehen.

Für den Betrieb des supraleitenden Quanten-Interferenz-Filters und des tieftemperaturtauglichen Transistors sind die entsprechenden elektrischen Versorgungs- und Steuerleitungen vorgesehen. In den Bereich des thermisch isolierten Teils der Schaltung sollten diese Leitungen vorzugsweise derart geführt werden, dass der Wärmeeintrag durch diese Leitungen nicht zu groß wird.

Zudem sind Mittel zur Ableitung der elektromagnetischen Welle von der Verschaltung vorgesehen. Für hohe Frequenzen erfolgt diese Ableitung typischerweise zunächst mit Hilfe von Mikrostreifenleitungen und dann mit Koaxialkabeln oder anderen geeigneten Wellenleitern. Bei der Durchführung der Welle durch die thermische Isolation können aber auch kontaktfreie Übergänge zum Einsatz kommen, etwa kapazitive Koppler.

Für die funktionelle Verschaltung von primärer Antennenstruktur, supraleitendem Quanten-Interferenz-Filter und tieftemperaturtauglichen Transistor sind vorzugsweise supraleitende Hochfrequenzleitungen vorgesehen, da diese nicht oder nur minimal verlustbehaftet sind. Es kann jedoch auch von Vorteil sein, z.B. aus Kostengründen, normalleitende Leitungen oder Hohlleiter zu verwenden da diese einfacher zu fertigen sind. Da diese Leitungen sich mindestens teilweise im Bereich des thermisch isolierten Teils der Verschaltung und damit auf einer sehr tiefen Temperatur befinden, besteht auch bei normalleitenden Leitungen im Hinblick auf dissipative Verluste ein erheblicher Vorteil gegenüber konventionellen Verschaltungen.

Auch Ausführungen, bei denen die Leitungen normalleitend und supraleitend ausgeführt sind, können von Vorteil sein. Werden supraleitende Streifenleitungen mit einer zusätzlichen normalleitenden Beschichtung versehen, dann können die Leitungen so dimensioniert werden, dass im Fall einer Überlastung oder eines Kurzschlusses der Strom über den normalleitenden Teil abfließt und der Supraleiter dadurch keinen Schaden nimmt.

Da Antennensysteme typischerweise eine sehr hohe Dynamik besitzen müssen, kann es überdies von Vorteil sein, wenn supraleitende Quanten-Interferenz-Filter und tieftemperaturtaugliche Transistoren unabhängig voneinander in verschiedenen Zweigen der Schaltung betrieben werden können. Beim Vorliegen großer Eingangssignale, bei denen der supraleitende Quanten-Interferenz-Filter in die Sättigung gehen würde, kann dessen Zweig dann abgeschaltet und nur der Transistorzweig betrieben werden. Beim Vorliegen sehr kleiner Eingangssignale hingegen wird der Zweig der Verschaltung verwendet, welcher den supraleitenden Quanten-Interferenz-Filter enthält.

Somit ist auch ein Antennensystem vorstellbar, das nur die Vorteile eines tieftemperaturtauglichen Transistors nutzt und damit keinen supraleitenden Quanten-Interferenz-Filter umfasst.

Auch kann das Antennensystem, wenn es aus normalleitenden oder aus normalleitenden und supraleitenden Hochfrequenzleitern aufgebaut ist und einen Zweig aus tieftemperaturtauglichen Transistoren ohne supraleitenden Quanten-Interferenz-Filter enthält, bereits bei Temperaturen betrieben werden, welche höher sind als die Sprungtemperatur der verwendeten Supraleiter. Dies hat den Vorteil, dass bei größeren Eingangssignalen weniger Kühlleistung erforderlich ist und dennoch eine gegenüber bei Normaltemperatur betriebenen Transistoren höhere Sensitivität erreicht wird. Durch einen variabel einstellbaren Wärmeentzug, wie dies etwa mit aktiven Kühlern problemlos möglich ist, kann damit die Sensitivität des Antennensystems über die Temperatur variabel eingestellt werden.

Da ein erheblicher Teil der dissipativen Verluste bei herkömmlichen Verschaltungen durch Leistungsverluste bedingt ist, ist es zudem von Vorteil, mindestens die Hochfrequenzleitungen, welche von der primären Antennenstruktur zum jeweils ersten aktiven Bauelement, d.h. supraleitender Quanten-Interferenz-Filter oder tieftemperaturtauglicher Transistor, ebenfalls zu kühlen.

Eine sehr effektive Form der thermischen Isolierung ist beispielsweise die Unterbringung der Verschaltung oder Teile der Verschaltung in einem evakuierbaren Gefäß. Solche Gefäße können derart konstruiert werden, dass sie das Vakuum und damit die thermische Isolierung über mehrere Jahre aufrechterhalten. Insbesondere beim Einsatz aktiver Kühler kann ein Kühlfinger kostengünstig und raumsparend in einem Vakuumgefäß montiert werden.

Vorteilhafterweise wird die thermische Isolierung der Verschaltung oder von Teilen der Verschaltung selbst bereits als Teil der primären Antennenstruktur ausgelegt. Dies kann etwa dadurch erfolgen, dass die thermische Isolierung mit dielektrischem Material erfolgt (z.B. Teflonschaum) und geometrisch so gestaltet wird, dass die einfallende elektromagnetische Welle auf den supraleitenden Quanten-Interferenz-Filter oder eine andere Einkopplungsstruktur fokussiert wird. Auch kann die thermische Isolierung durch ein metallisches Vakuumgefäß erfolgen. Das metallische Vakuumgefäß selbst kann dann wiederum als Teil der primären Antennenstruktur ausgelegt werden. Z.B. kann das metallische Vakuumgefäß als Wellenleiter oder Wellenleiterabschluss ausgelegt werden, in den von einer Primärapertur eingespeist wird. Auch kann vorteilhafterweise das Vakuumgefäß mit Hochfrequenzfenstern versehen werden, welche als primäre Aperturantennen wirken.

In einer bevorzugten Ausführungsform können durch thermische Isolierung und Kühlung der gesamten Verschaltung aus supraleitendem Quanten-Interferenz-Filter, tieftemperaturtauglichem Transistor und primärer Antennenstruktur die gesamten dissipativen Verluste und damit das Eigenrauschen des Systems minimiert werden. Damit entsteht eine Vorrichtung mit maximaler Leistungsfähigkeit.

In einer, insbesondere für den GHz-Frequenzbereich, besonders vorteilhaften Ausführungsform ist der Auskopplungsteil der primären Antennenstruktur als Hohlleiterabschluss ausgebildet, in welchen ein längliches Antennenelement, z.B. ein Antennenstift hineinragt. Mit Hilfe dieses, gegenüber dem Hohlleiter elektrisch isolierten Antennenstifts wird die elektromagnetische Welle, insbesondere dann, wenn sich der Hohlleiterabschluss auf einer tiefen Temperatur befindet, verlustarm ausgekoppelt direkt, oder mit Hilfe einer geeigneten Leitung, zum Eingang eines aktiven Bauelements transportiert. Durch die Hintereinanderschaltung mehrerer aktiver Bauelemente bereits im kalten Teil der Verschaltung kann eine sehr rauscharme Verstärkung des Antennensignals erreicht werden. Vorteilhafterweise erfolgt die thermische Isolierung der Verschaltung und des Hohlleiterabschlusses durch ein evakuierbares Gefäß.

In einer Weiterbildung der im letzten Absatz beschriebenen Ausführungsform ist der Hohlleiterabschluss mit zwei insbesondere stiftförmigen Antennenelementen versehen, welche gegeneinander versetzt angebracht sind. Dies hat den Vorteil, dass aus dem Hohlleiter zwei unabhängige Polarisationen getrennt voneinander ausgekoppelt werden können. Die separate Ankopplung an jeweils ein aktive Bauelement erlaubt die getrennte Verarbeitung der beiden Polarisationen.

Für Anwendungen, bei denen der Bauraum des Antennensystems möglichst klein sein soll, ist es insbesondere im Bereich von GHz-Frequenzen von Vorteil als primäre Antennenstruktur Felder von Apertur- oder Schlitzantennen zu verwenden.

Wegen der hohen Sensitivität supraleitender Quanten-Interferenz-Filter ist die Größe der gesamten Apertur allgemein bei Antennenfeldern nur durch die gewünschte Richtcharakteristik des Antennensystems gegeben. Die physikalische Apertur kann deshalb sowohl aus ein-, zwei- als auch aus dreidimensionalen Feldern von Primärantennen bestehen. Die Zusammenführung der Ausgangssignale der einzelnen Antennen des Antennenfeldes kann durch eine Struktur von Hohlleitern oder Mikrostreifenleitungen erfolgen. Besonders leistungsfähige Antennesysteme ergeben sich auch dann, wenn die primäre Antennenstruktur aus Supraleitern besteht, insbesondere, wenn die Ausgangssignale der einzelnen Antennen des Feldes mit Hilfe supraleitender Hochfrequenzleitungen zusammengeführt werden. Werden in solchen Feldern zusätzliche aktive Bauelemente wie etwa Phasenschieber zur Steuerung der Richtcharakteristik verwendet, entsteht ein weiterer Vorteil, da auch diese Bauelemente bei tiefen Temperaturen sehr viel weniger rauschen und effizienter arbeiten.

Auch mit primären Antennenstrukturen die als Felder von Patch-Antennen ausgebildet sind, lässt sich die Richtcharakteristik des Antennensystems sehr effektiv modellieren. Insbesondere kann bei entsprechender Auslegung der einzelnen Antennen des Antennenfeldes bereits auf der Ebene der einzelnen Antennen eine Polarisationstrennung erfolgen.

Die Verwendung von elektromagnetischen Linsen als primäre Antennenstruktur ist von Vorteil, wenn gleichzeitig Signale unterschiedlicher Polarisation oder Signale mit sich zeitlich verändernder Polarisation durch das Antennensystem empfangen werden sollen. Da elektromagnetische Linsen die Polarisation der einfallenden Welle erhalten, entfällt bei zeitlichen Änderungen der Polarisation der einfallenden Welle eine Nachführung auf der Ebene der primären Antennenstruktur.

Für Anwendungen, bei denen sehr große instantane Bandbreiten erforderlich sind, ist es von Vorteil Hornantennen als primäre Antennenstruktur zu verwenden. Das Ausgangssignal der Hornantennen kann, etwa durch entsprechend dimensionierte Hohlleiterstrukturen, sehr effizient an einen supraleitenden Quanten-Interferenz-Filter angekoppelt werden.

Auch durch die Verwendung von Parabolantennen können sehr große instantane Bandbreiten erzielt werden. Bei gleicher effektiver Apertur ist eine so ausgebildete Quantenantenne, insbesondere im GHz-Frequenzbereich, um ein mehrfaches leistungsfähiger als ein konventionelles Parabolantennensystem gleicher Größe. Mit Feldern von Parabolantennen kann zudem eine sehr hohe Richtwirkung des Antennensystems erreicht werden.

In einer weiteren vorteilhaften Ausgestaltung der Erfindung sind die Elektroden des supraleitenden Quanten-Interferenz-Filters selbst als primäre Antennenstrukturen ausgelegt. Diese Ausgestaltung hat den Vorteil, dass das Magnetfeld des in diesen Strukturen fließenden Antennenstroms direkt in die Schlaufen des supraleitenden Quanten-Interferenz-Filters einkoppelt. Die Ausdehnung der Antenne lässt sich damit weiter reduzieren.

Da das supraleitende Quanten-Interferenz-Filter je nach Art der verwendeten Josephson-Kontakte verschiedene Impedanzen besitzen kann, ist es zudem vorteilhaft die Antennenschaltung mit einem Impedanzwandler auszustatten, welcher die Impedanz des supraleitenden Quanten-Interferenz-Filters auf die Impedanz eines das Signal ableitenden Wellenleiters transformiert.

Es ist bekannt, dass die Josephson-Kontakte, welche der supraleitende Quanten-Interferenz-Filter enthält, nichtlineare Oszillatoren sind, in denen ein hochfrequenter Wechselstrom fließt. Ebenso ist bekannt, dass solche Josephson-Oszillatoren sich auf die Frequenz einer extern eingestrahlten Welle synchronisieren können (einlocken). Wegen der Josephson-Relation ist dann die über den Kontakten abfallende Gleichspannung streng proportional zur Frequenz der eingestrahlten Welle. Ist die zu empfangende Information in der einfallenden Welle über die Frequenz kodiert (Frequenzmodulation) dann entspricht der Zeitverlauf der über den Kontakten und damit der über dem supraleitenden Quanten-Interferenz-Filter abfallenden Gleichspannung dem Informationsgehalt der einfallenden Welle. Wegen der Eindeutigkeit der Kennlinie des supraleitenden Quanten-Interferenz-Filters kann durch entsprechende Wahl des den supraleitenden Quanten-Interferenz-Filters versorgenden Betriebsstroms und eines magnetischen Steuerfeldes die Frequenz des Josephson-Oszillation im supraleitenden Quanten-Interferenz-Filter sehr genau eingestellt werden. Damit ist zum einen sichergestellt, dass der supraleitende Quanten-Interferenz-Filter auf die Trägerfrequenz der einfallenden Welle einlockt, und zum anderen kann diese Frequenz sehr leicht gewechselt werden.

In allen Fällen, bei denen die Trägerfrequenz im Vergleich zur Modulationsfrequenz schnell oszilliert wird in diesem Betriebsmodus der Antenne das empfangene Signal automatisch demoduliert und kann direkt weiterverarbeitet werden. Die in Anspruch 5 angegebene Ausführungsform ist daher insbesondere für den Frequenzbereich zwischen 1 GHz und 100 GHz geeignet und sehr vorteilhaft, weil das konventioneller Weise erforderliche Heruntermischen des Signals mit Hilfe von Lokaloszillatoren entfällt.

Wegen des einfacheren Herstellungsverfahrens ist es zudem vorteilhaft, wenn sich die primäre Antennenstruktur und der supraleitende Quanten-Interferenz-Filter auf einem gemeinsamen Träger (Chip) befinden. Dies ermöglicht die Fabrikation von integrierten Antennenchips mit bekannten Verfahren der Dünnschichttechnologie.

In bestimmten Wellenlängenbereichen und bei der Verwendung von Materialien, welche keine Mehrlagentechnologie erlauben, kann es jedoch auch von Vorteil sein, die beiden funktionalen Elemente der Antenne auf verschiedenen Trägern aufzubringen. Diese Träger können dann mit Hilfe von elektrischen Drähten gekoppelt werden. Diese Anordnung ist auch dann von Vorteil, wenn wegen des Bauraums, wegen der Verminderung von externen Störungen oder wegen sonstiger Gründe die primäre Antennenstruktur anders räumlich ausgerichtet sein soll als der supraleitende Quanten-Interferenz-Filter. Ein weiterer Vorteil besteht darin, dass unterschiedliche Materialen für die verschiedenen Träger verwendet werden können.

Wenn die Antenne eine sehr hohe Sensitivität besitzen muss und keine Mehrlagentechnologie zur Verfügung steht, kann eine effiziente Kopplung zwischen primärer Antennenstruktur und supraleitendem Quanten-Interferenz-Filter auch dadurch erzielt werden, dass die Träger beider funktionaler Elemente direkt übereinander angebracht und z.B. miteinander verklebt werden.

Supraleitende elektronische Bauelemente benötigen sehr tiefe Betriebstemperaturen. Der zur Herstellung und Aufrechterhaltung dieser Temperaturen notwendige Aufwand steigt sehr stark an je tiefer die Betriebstemperatur der verwendeten Supraleiter ist. Prinzipiell können für die Antenne alle bekannten Supraleiter, aus denen sich Josephson-Kontakte herstellen lassen, verwendet werden. Es ist jedoch vorteilhaft Materialen zu verwenden bei denen die Betriebstemperatur so hoch wie möglich ist. Diese bekannten Materialien sind sogenannte Hochtemperatursupraleiter, deren Betriebstemperaturen über ca. -200˚ C reichen und die mit flüssigem Stickstoff preisgünstig gekühlt werden können. Die bekanntermaßen einfachste und preisgünstigste Methode aus solchen Materialien Josephson-Kontakte herzustellen ist die Methode der Korngrenzenkontakte. Diese Kontakte besitzen zwar sehr inhomogene Parameter und sind daher für quantenelektronische Schaltkreise ansonsten sehr wenig geeignet, wegen der konstruktionsbedingten sehr hohen Fehlertoleranz von supraleitenden Quanten-Interferenz-Filtern sind sie bei der Antenne jedoch problemlos verwendbar.

Von Vorteil ist zudem, wenn auch die primären Antennenstrukturen aus Hochtemperatursupraleitern bestehen. Da ein Supraleiter die Eigenschaft, hat dass in seinem Innern elektrische Felder vollständig verschwinden, fließen in solchen Strukturen in der Regel höhere Antennenströme als in normalleitenden Strukturen. Dies erhöht die Sensitivität der Antenne.

Besteht die Antenne aus Supraleitern oder aus Supraleitern und Normalleitern, dann kann sie auch aktiv, d.h. mit Hilfe eines Kühlers, ohne den Einsatz von flüssigen Kühlmitteln betrieben werden. Während flüssige Kühlmittel regelmäßig ersetzt werden müssen und die Betriebszeiten damit sehr eingeschränkt sind, können Kühler die notwendigen Betriebstemperaturen dauerhaft und zuverlässig zur Verfügung stellen. Wegen der Verwendung von supraleitenden Quanten-Interferenz-Filtern, welche eine sehr große Dynamik besitzen, führen die durch den Kühler verursachten elektromagnetischen Störungen nicht zu einem Performanceverlust der Antenne. Bei der Verwendung von Hochtemperatursupraleitern sind die typischen Leistungen, die zum Betrieb eines Kühlers benötigt werden sehr gering und liegen im Bereich von 20 W - 40 W. Solche Leistungen können auch im mobilen Einsatz meist ohne Probleme zur Verfügung gestellt werden.

Beim Betrieb der Antenne in einem Kühler ist es günstig, wenn sich die Antenne auf einen Chip befindet, welcher direkt auf dem Kühlfinger des Kühlers angebracht wird. Die erforderliche Kühlleistung reduziert sich dadurch erheblich und es können sehr kleine Kühler verwendet werden. Die erforderliche Kühlleistung reduziert sich weiter, wenn das Ausgangssignal der Antenne mit einem Wellenleiter, welcher schlecht wärmeleitend ist vom Antennenchip abgeleitet wird.

Außerdem ist es von Vorteil, wenn der Wellenleiter gleichzeitig zur Versorgung der Antenne mit elektrischer Energie verwendet wird. Dies erspart zusätzliche Kabel, welche die Wärmelast und damit die erforderliche Kühlleistung erhöhen würden.

Insbesondere bei Empfangsfrequenzen im GHz Bereich ist es von Vorteil die primäre Antennenstruktur resonant auszulegen. Dies erfolgt am einfachsten dadurch, das Antennenstäbe oder Felder verwendet werden, deren Länge im Bereich der halben Wellenlänge der einfallenden Welle liegt. In diesem Fall fließen in den Antennenstrukturen große Blindströme, was die Sensitivität der Antenne stark erhöht. Dabei können auch Patch- oder patchähnliche Antennen verwendet werden, deren Abmessungen im Bereich der halben Wellenlänge der einfallenden Welle liegen.

Da keine Impedanzanpassung der primären Antennenstruktur notwendig ist, können auch magnetische Schlaufenantennen als primäre Antennenstrukturen verwendet werden. Da der supraleitende Quanten-Interferenz-Filter extrem rauscharm ist, können solche Schlaufenantennen auch bis zu sehr hohen Frequenzen zum Einsatz kommen. Der Vorteil von Schlaufenantennen liegt dabei darin, dass ihre Abmessungen sehr viel kleiner als die Wellenlänge der einfallenden Welle sein können. Da es nur auf die Antennenströme ankommt, können sowohl offene als auch geschlossene Schlaufenantennen verwendet werden.

Wegen der sehr hohen Empfindlichkeit von supraleitenden Quanten-Interferenz-Filtern können auch einzelne oder Felder von elektrisch kleinen Antennen zum Einsatz kommen. Die Abmessungen solcher Primärantennen sind zwar viel kleiner als die Wellenlänge der einfallenden Welle, auch ohne Anpassungsnetzwerk reichen die in ihnen induzierten Antennenströme in der Regel jedoch aus den supraleitenden Quanten-Interferenz-Filter genügend zu erregen.

Für bestimmte Anwendungen, insbesondere bei sehr hohen Frequenzen, kann es auch von Vorteil sein als primäre Antennenstruktur eine dielektrische Schicht zu verwenden. In solchen Schichten treten ebenfalls Resonanzen auf und es fließen Oberflächenströme, die in den supraleitenden Quanten-Interferenz-Filter eingekoppelt werden können. Auch Kombinationen von dielektrischen Schichten mit leitenden Strukturen sind möglich.

Die primäre Antennenstruktur kann auch aus einer resonanten Kavität bestehen innerhalb derer der supraleitenden Quanten-Interferenz-Filter an einer geeigneten Stelle maximaler magnetischer Feldstärke angebracht ist. Je nach Position des supraleitenden Quanten-Interferenz-Filters innerhalb der Kavität können dann bestimmte Moden selektiert werden. Dies kann insbesondere zur Polarisationstrennung und zur weiteren Erhöhung der Sensitivität von Vorteil sein.

Werden in der primären Antennenstruktur oder zwischen primärer Antennenstruktur und supraleitendem Quanten-Interferenz-Filter zusätzlich Frequenzfilterelemente angebracht, dann können entsprechende Frequenzbänder gezielt selektiert werden. Damit kann eine Multiband-Antenne realisiert werden. Dies kann dann von großem Vorteil sein, wenn gleichzeitig in verschiedenen Frequenzbändern sehr große Unterschiede in den Signalstärken der einfallenden Wellen herrschen. Zu starke Signale in bestimmten Bändern, welche die schwachen zu empfangenden Signale überdecken würden, können damit gezielt eliminiert werden.

Durch den Einbau zusätzlicher aktiver und/oder passiver elektronischer Bauelemente kann die Leistungsfähigkeit der Antenne erhöht werden. Dies ist insbesondere dann der Fall, wenn die Übergabe des Ausgangsignals der Antenne an die konventionelle Empfangselektronik zur Vermeidung von parasitären Verlusten direkt am Ausgang des supraleitenden Quanten-Interferenz-Filters erfolgen soll. Insbesondere bei sehr hohen Frequenzen können Laufzeitverluste damit minimiert werden. Da die Antenne selbst nur sehr wenig Bauraum in Anspruch nimmt, können die zusätzlichen elektronischen Bauelemente im kalten Teil der Schaltung untergebracht werden. Bei entsprechender Wahl der Bauelemente reduziert sich damit das thermische Rauschen erheblich und die Sensitivität des Gesamtsystems Antenne-Empfänger steigt an.

Auch durch die Verwendung von zwei oder mehr erfindungsgemäßer Antennen in einem Antennenfeld lässt sich die Empfindlichkeit erhöhen. Solche Antennenfelder können von einem Kühler gemeinsam gekühlt werden, oder jede Antenne verfügt über einen eigenen Kühler. Antennenfelder haben den Vorteil, dass die Empfindlichkeit des Gesamtsystems mit der Zahl der verwendeten Antennen stark ansteigt ("supergain"). Zudem lassen sich durch entsprechende Anordnung der einzelnen Antennen im Feld stark ausgeprägte Richtcharakteristiken erzeugen ("superdirectivity").

Werden erfindungsgemäße Antennen in einem Antennenfeld angeordnet und die Ausgangsignale der einzelnen Antennen mit geeigneten Mittel wie z.B. elektronisch steuerbaren Phasenschiebern oder Verzögerungsleitungen, phasensensitiv zu einem Gesamtsignal überlagert, dann hat dies außerdem den Vorteil, dass die räumliche Position des Senders der empfangenen elektromagnetischen Welle sehr genau bestimmt werden kann. Ist der Ort des Senders bekannt, können mit diesem Verfahren andererseits verschiedene Sender diskriminiert werden. Da erfindungsgemäße Antennen dem elektromagnetischen Feld keine oder nur eine sehr geringe Menge an Energie entziehen, ist die Bestimmung der Position erfindungsgemäßer Antennen hingegen äußerst schwierig.

Eine besonders kostengünstige und effektive Fertigungsmethode für die Antenne kann dann verwendet werden, wenn die Schaltung in der bekannten Mikrostreifenleitungstechnologie konzipiert wird. Bei dieser Technologie werden Elektrode und Gegenelektrode des Schaltkreises nicht beide auf der Oberfläche eines Trägers (Chips) angebracht, sondern der Träger wird mit einer Grundplatte versehen welche die Gegenelektrode bildet. Auf der Oberseite des Trägers befinden sich dann nur die Leiterbahnen der Elektrode. Diese Methode erlaubt eine sehr hohe Integrationsdichte auf dem Träger und minimiert, weil die elektrischen Felder im wesentlichen im Substrat des Trägers konzentriert sind, die Verluste. Wird der Antennenchip auf dem Kühlfinger eines aktiven Kühlers betrieben, dann kann auch dieser Kühlfinger selbst als Grundplatte (Gegenelektrode) verwendet werden.

Insbesondere bei Frequenzen kleiner 1 GHz ist es vorteilhaft den supraleitenden Quanten-Interferenz-Filter mit einer Rückkoppelsteuerung auszustatten (feed back loop). Das Ausgangsignal des supraleitenden Quanten-Interferenz-Filters wird dabei entweder positiv - zur Erhöhung der Empfindlichkeit - oder negativ - zur Stabilisierung des Arbeitspunkts - auf den supraleitenden Quanten-Interferenz-Filter zurückgekoppelt. Bei negativer Rückkopplung (negative feed back) kann die Schaltung dabei so betrieben werden, dass der Arbeitspunkt auf der Kennlinie des supraleitenden Quanten-Interferenz-Filters konstant bleibt. In diesem Fall enthält der Rückkoppelstrom bzw. die Rückkoppelspannung die Information der einfallenden Welle.

Wegen der Reziprozität von Empfangen und Senden elektromagnetischer Wellen kann die Antenne auch derart ausgelegt werden, dass sie eine elektromagnetische Welle aussendet. Wird die Impedanz des supraleitenden Quanten-Interferenz-Filters auf die Strahlungsimpedanz des primären Antennenfeldes abgestimmt, dann prägt der supraleitenden Quanten-Interferenz-Filter eine ihm eingespeiste Spannungsoszillation dem primären Antennenfeld auf. Das primäre Antennenfeld strahlt dann eine elektromagnetische Welle ab. Bedingt durch das Funktionsprinzip der Antenne ist die abgestrahlte Leistung im allgemeinen zwar klein, diese Ausführungsform kann jedoch von Vorteil sein, wenn neben dem Empfang noch zusätzliche Aufgaben, z.B. die Synchronisation räumlich voneinander getrennt operierender Antennen, erfüllt werden sollen.

Zum Stand der Technik können folgende Literaturstellen angegeben werden:

J.D. Kraus, Antennas, 2nd Edition, Mc Graw-Hill, 1988.

S. Ramo, J.R. Whinnery, T. VanDuzer, Fields and waves in communication electronics, 3rd edition, John Wiley, 1994.

A. Barone and G. Paterno, Physics and Applications of the Josephson Effect, John Wiley, 1982.

J. Hinken, Superconducting Electronics, Springer, 1988.

K.K. Likharev, Dynamics of Josephson junctions and circuits, Gordon and Breach, 1991.

R.D. Parmentier and N.F. Pedersen, Nonlinear superconducting devices and High-Tc materials, World Scientific, 1995.

J.C. Gallop et al., SQUIDS, the Josephson Effect and superconducting electronics, Hilger, 1991.

H. Weinstock (editor), SQUID Sensors: Fundamentals, Fabrication and Applications, Kluwer Academic Publishers, 1996.

J. Oppenländer, Ch. Häußler, and N. Schopohl, Phys. Rev. B63, 024511 (2001).

Ch. Häußler, J. Oppenländer, and N. Schopohl, J. Appl. Phys. 89, 1875 (2001) .

**EP 1 634 351 B1**

J. Oppenländer, T. Träuble, Ch. Häußler, and N. Schopohl, IEEE Trans. Appl. Supercond.11, 1271 (2001).
J. Oppenländer, Ch. Häußler, T. Träuble, and N. Schopohl, Physica C 368, 119 (2002).
V. Schultze, R. Ijsselsteijn, H.-G. Meyer, J. Oppenländer, Ch. Häußler, and N. Schopohl, IEEE Trans. Appl. Supercond 13, (to appear June 2003).

Zeichnungen:

Mehrere Ausführungsbeispiele sind in den Zeichnungen dargestellt und unter Angabe weiterer Vorteile und Einzelheiten näher erläutert.

Es zeigen

Figur 1 die typische Magnetfeld-Spannungskennlinie eines supraleitenden Quanten-Interferenz-Filters und die Definition eines geeigneten Arbeitspunkts,
Figur 2a das typische Schaltungsdesign einer erfindungsgemäßen Antenne mit supraleitendem Quanten-Interferenz-Filter und angekoppelter primärer Antennenstruktur,
Figur 2b eine erfindungsgemäße Antenne bei der die Elektroden des supraleitenden Quanten-Interferenz-Filters selbst als primäre Antennenstrukturen ausgelegt sind,
Figur 2c eine Antennenschaltung bei der das Ausgangssignal der Antenne über einen koplanaren Impedanzwandler ausgekoppelt wird,
Figur 2d eine Antenne in Hochtemperatursupraleiter-Technologie mit Korngrenzen-Josephsonkontakten,
Figur 3 die schematische Darstellung des Betriebs einer erfindungsgemäßen Antenne in einem aktiven Kühlsystem,
Figur 4a ein primäres Antennenfeld mit geometrischer Resonanz,
Figur 4b eine erfindungsgemäße Antenne bei der die primäre Antennenstruktur als resonante Kavität ausgelegt ist,
Figur 4c eine Antennenschaltung im Mikrostreifentechnologie, Figur 5 die stark schematisierte Darstellung einer Antennenstruktur für elektromagnetische Wellen hoher Frequenz,
Figur 6 in schematischer Darstellung eine Antennenstruktur mit einem Vakuumgefäß,
Figur 7a eine zu Figur 5 vergleichbare Ausführungsform jedoch mit einem Feld von Aperturantennen,
Figur 7b eine Ausführungsform in einer zu Figur 7a entsprechenden Darstellung eine Antenne mit Parabolspiegel,
Figur 8 eine Ausführungsform einer Antenne in schematischer Darstellung mit einem Feld von Patch-Antennen,
Fig. 9a und b ein mehrzelliges SQIF aus parallel geschalteten Josephsonkontakten in räumlicher Darstellung,
Fig. 10 das Schaltbild eines äquivalenten supraleitenden Stromkreises eines Quanten-Interferenz-Filters mit $N = 10$ Kontakten,
Fig. 10a bis f Schaltbilder von weiteren supraleitenden Stromkreisen,
Fig. 11 eine Spannungsantwortfunktion für einen SQIF mit N = 30 Kontakten,
Fig. 12a und b periodische Spannungsantwortfunktionen für herkömmliche SQUIDs,
Fig. 12c die Spannungsantwortfunktion eines supraleitenden Quanten-Interferenz-Filters,
Fig. 12d die Spannungsantwortfunktion eines SQUID und eines SQIF,
Fig. 13 eine symbolisch dargestellte räumliche Anordnung eines supraleitenden Quanten-Interferenz-Filters mit angedeuteter vektorieller Basis des dreidimensionalen Raumes,
Fig. 14 ein schematisch dargestelltes, ebenes supraleitendes Quanten-Interferenz-Filter mit einer Magnetfeldkompensationseinrichtung,
Fig. 15 ein supraleitendes Quanten-Interferenz-Filter mit einer parallel geschalteten Steuerleitung in schematischer Ansicht,
Fig. 16 eine schematisch dargestellte Vernetzung von SQIF-Abschnitten,
Fig. 17a bis c schematisch dargestellte, ebene, supraleitende Quanten-Interferenz-Filter mit einer geometrischen Anordnung zur Minimierung des Einflusses von Eigenfeldern,
Fig. 18a ein Netzwerk aus in Serie geschalteten Zellen,
Fig. 18b eine zu einem Netzwerk gemäß Fig. 18a entsprechende Spannungsantwortfunktion bei einer Serienschaltung für N = 100 Zellen,
Fig. 18c eine Stromspannungskennlinie eines Netzwerks gemäß Fig. 18a, wenn es als Stromverstärker mit Hilfe eines Kompensationsstromkreises betrieben wird,
Fig. 19a im oberen Bild die typische Spannungsantwortfunktion eines herkömmlichen SQUID mit dem zugehörigen Frequenzspektrum im unteren Bild,
Fig. 19b im oberen Bild eine typische Spannungsantwortfunktion eines Netzwerks aus identischen Zellen und das zugehörige Frequenzspektrum im unteren Bild,
Fig. 19c im oberen Bild die Spannungsantwortfunktion eines supraleitenden Quanten-Interferenz-Filters ohne Periodizität und das dazugehörige Spektrum im unteren Bild,
Fig. 19d im oberen Bild eine Spannungsantwortfunktion und im unteren Bild das zugehörige Spektrum eines Quanten-Interferenz-Filters, welcher eine technisch bedingte, vergleichsweise große Periodizität besitzt und

Fig. 20 ein schematisch dargestelltes, ebenes supraleitendes Quanten-Interferenz-Filter mit einer das primäre magnetische Feld am Ort des Filters verstärkenden supraleitenden Einkoppelschlaufe (pick-up-loop).

Beschreibung der Ausführungsbeispiele:

In Figur 1 ist eine typische Kennlinie eines supraleitenden Quanten-Interferenz-Filters (SQIF) dargestellt. Wird der SQIF mit einem elektrischen Strom geeigneter Stärke versorgt, dann fällt über dem SQIF eine vom magnetischen Feld welches den SQIF durchsetzt abhängige Spannung ab. Im Gegensatz zu den bekannten, herkömmlichen SQUIDs ist die Kennlinie nicht periodisch, sondern besitzt ein eindeutiges Minimum bei verschwindendem magnetischem Feld B=0. Da die Kennlinie nicht sinusförmig ist, wie bei herkömmlichen SQUIDs oder SQUID-Arrays, ist die Linearität ihrer Flanke 1 bzw. 1* sehr hoch.

Durch Einstellung eines geeigneten Arbeitspunkts 2, was z.B. durch das Anlegen eines konstanten Magnetfelds (Steuerfelds) erfolgen kann, kann der SQIF als Verstärker bzw. als StromSpannungswandler mit hoher Linearität betrieben werden.

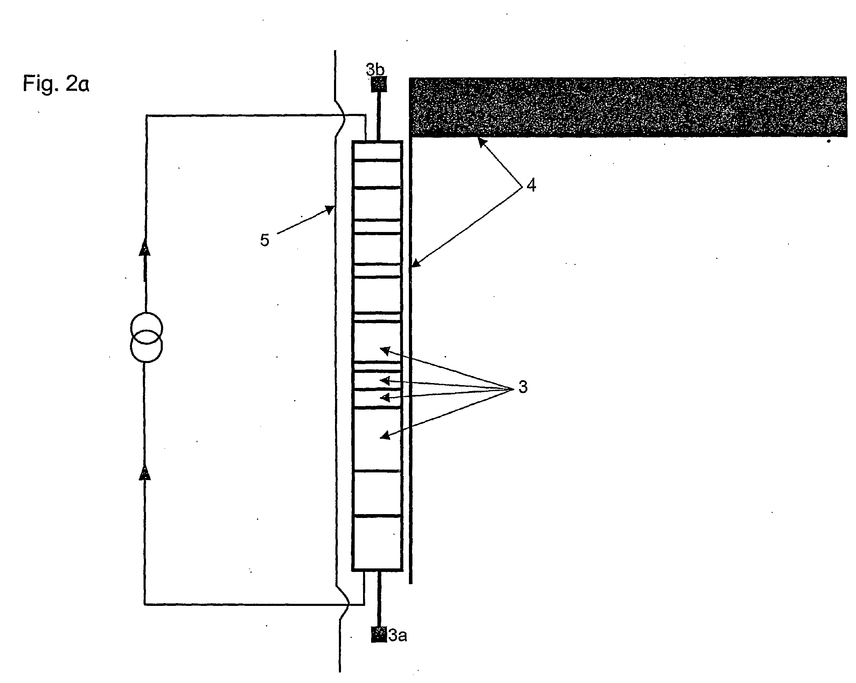

In Figur 2a ist eine typische Antennenschaltung mit den Merkmalen des Anspruchs 1 dargestellt. Der SQIF 3 ist induktiv an eine primäre Antenne 4 angekoppelt. Beim Einfall einer elektromagnetischen Welle fließt durch die primäre Antenne 4 ein Antennenstrom. Da die Antenne in einem bestimmten Bereich räumlich dicht am SQIF entlang führt, erzeugt dieser Antennenstrom am Ort der SQIF-Schlaufen ein magnetisches Feld. Wird der SQIF auf einem geeigneten Arbeitspunkt 2 betrieben, dann fällt über den SQIF eine Spannung ab, deren Richtung von der Richtung des Antennenstroms abhängt. In dieser Weise erzeugt der SQIF eine Spannungsoszillation welche der Oszillation des Antennenstroms eindeutig entspricht. Durch geeignete Wahl der Zahl der SQIF-Schlaufen 3 kann der Spannungshub der über den SQIF abfallenden Spannung grundsätzlich beliebig eingestellt und damit der Dynamikbereich des Strom-Spannungswandlers beliebig gewählt werden. Das zur Steuerung des SQIF erforderliche magnetische Feld kann durch eine Feldspule oder durch eine mit einem geeigneten Strom beschickte Steuerleitung 5 erfolgen. Diese Leitung kann auch dazu verwendet werden, den Arbeitspunkt zu stabilisieren oder das vom SQIF erzeugte Spannungssignal, etwa mit Hilfe eines elektrischen Widerstands, in den SQIF rückzukoppeln. Damit die über dem SQIF abfallende Spannungsoszillation an einen Empfänger weitergeleitet werden kann, sind am SQIF die Elektroden 3a und 3b angebracht. Diese Elektroden werden mit einem für den jeweiligen Frequenzbereich geeigneten Wellenleiter verbunden, der das Ausgangssignal des SQIF möglichst verlustfrei an den Empfänger weiterleitet.

Im einfachsten Fall wird der SQIF ohne Steuerung des Arbeitspunkts im Minimum der Kennlinie betrieben. Dass vom SQIF erzeugte Spannungssignal besitzt dann die doppelte Frequenz der Oszillation des Antennenstroms. In diesem Operationsmodus der Antenne können insbesondere binär phasenkodierte Signale sehr einfach und zuverlässig empfangen werden.

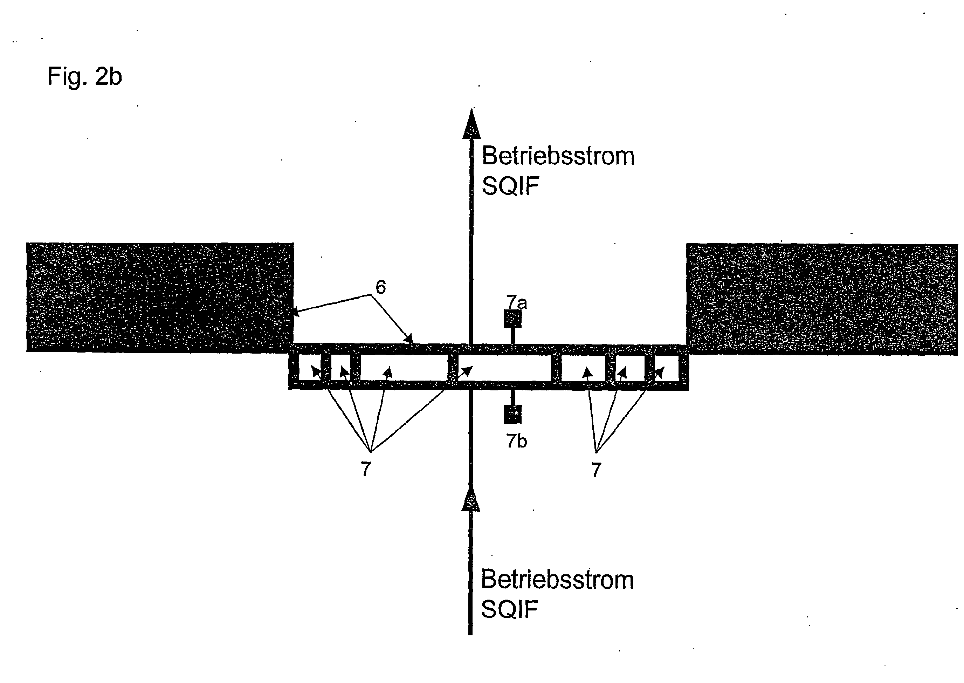

In Figur 2b ist ein paralleler SQIF derart ausgelegt, dass die Elektroden des SQIF selbst die primäre Antennenstruktur darstellen. Bei Einfall einer elektromagnetischen Welle entsprechender Polarisation wird in der Elektrode 6 ein Antennenstrom induziert. Dieser Antennenstrom koppelt in die Schlaufen 7 des SQIF unmittelbar ein magnetisches Feld ein. Mit Hilfe der Elektroden 7a und 7b wird das Ausgangssignal des SQIF abgeleitet. Die Elektrode 6 kann dabei auch als geschlossene Schlaufe ausgelegt werden (nicht dargestellte Ausführungsform). In einer ebenfalls nicht dargestellten Ausführungsform sind die Elektroden der einzelnen SQIF Schlaufen oder von Gruppen von Schlaufen als jeweils einzelne Antennenstäbe bzw. Antennenstrukturen ausgebildet. Diese Ausführungsform hat den Vorteil, dass die einzelnen Antennenstrukturen unterschiedlich ausgelegt werden können und so eine Einstellung der Bandbreite der Antenne erlauben.

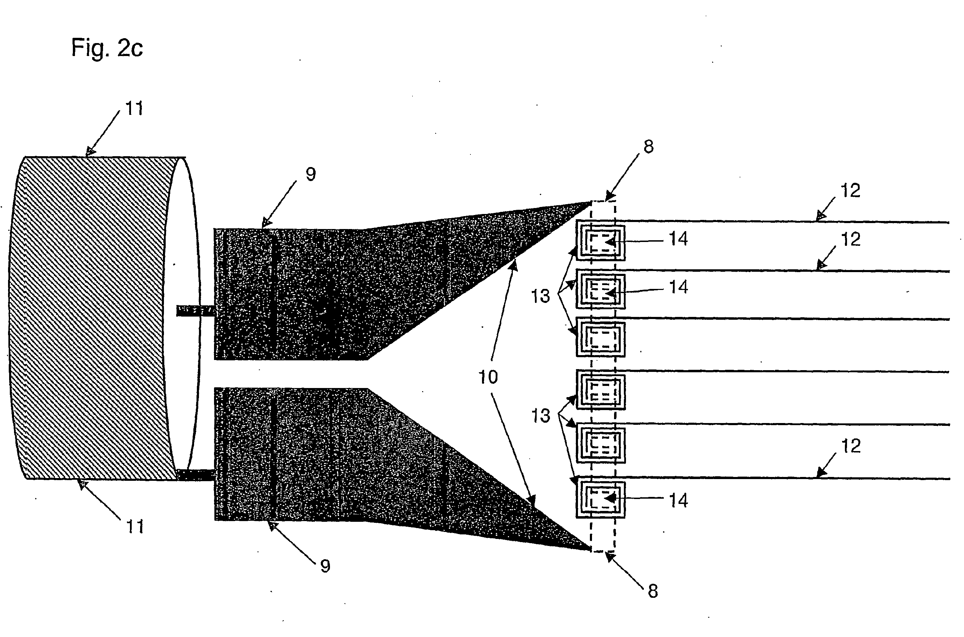

In Figur 2c ist eine Antennenschaltung dargestellt, bei der das Ausgangssignal des SQIF 8 über eine koplanare Streifenleitung 9 ausgekoppelt wird. Am Ende der koplanaren Streifenleitung 9 befindet sich eine koplanare Impedanzwandlerstruktur 10, welche die Impedanz des SQIF auf die Impedanz des angeschlossenen Wellenleiters 11 transformiert. Verluste durch eine Impedanzfehlanpassung von SQIF und Wellenleiter bzw. Verbraucher (Empfängerschaltung) können dadurch vermieden werden.

Die primäre Antennenstruktur besteht in Figur 2c aus Antennenstäben 12, an deren Ende eine spiralförmige Wicklung 13 angebracht ist. Die spiralförmige Wicklungen 13 sind direkt über den Schlaufen des SQIF 14 angebracht, was z.B. in Mehrlagen-Dünnschichttechnologie problemlos möglich ist. Das durch die Antennenströme erzeugte magnetische Feld wird in solchen Anordnungen sehr effektiv in den SQIF eingekoppelt.

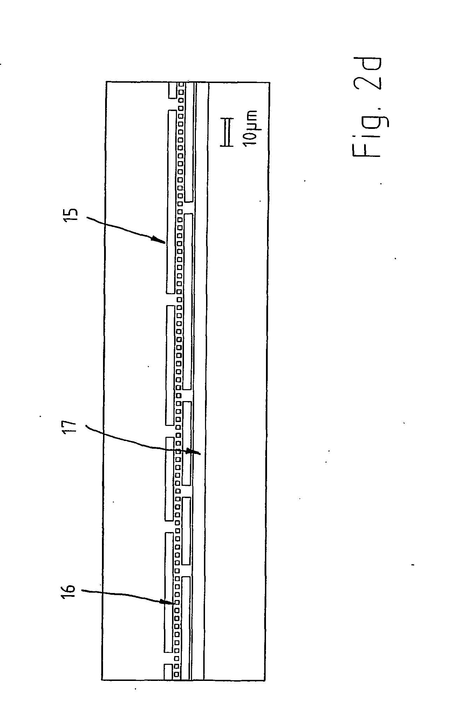

In Figur 2d ist eine Antennenschaltung dargestellt, bei der SQIF und primäre Antennenstruktur aus Hochtemperatursupraleitern (hier YBCO) hergestellt wurden. Die Josephson-Kontakte sind hier Korngrenzenkontakte. Diese Korngrenzenkontakte entstehen, wenn eine Leiterbahn 15 die Korngrenze 16 überquert. Wegen der einfachen Bauform der Kontakte sind die Streuungen der Kontaktparameter sehr hoch. Im Gegensatz zu herkömmlichen quantenelektronischen Schaltungen beeinflusst dies die Leistungsfähigkeit des SQIF jedoch nicht. Die Leitung 17 ist Teil der primären Antennenstruktur und induktiv an den SQIF angekoppelt.

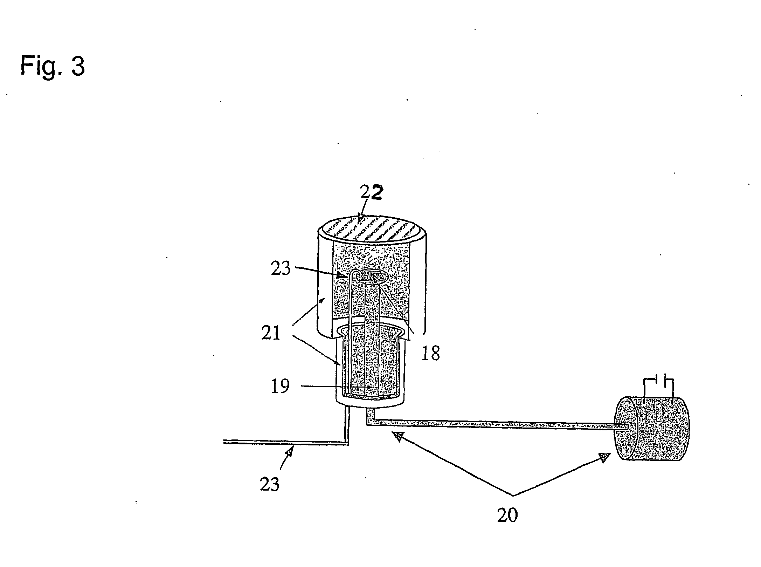

Figur 3 zeigt ein Ausführungsbeispiel, bei dem ein Antennenchip in einem Kleinkühler betrieben wird. Die Antennenschaltung 18 befindet sich on-chip. Der Chip selbst ist thermisch an den Kühlfinger 19 des Kleinkühlers 20 angekoppelt. Zur thermischen Isolation befinden sich Antennenchip und Kleinkühler in einem Vakuumdewar 21. Das Vakuumdewar 21 verfügt über ein für elektromagnetische Wellen durchlässiges Fenster 22. Das Ausgangssignal der Antenne wird durch einen vakuumdichten, schlecht wärmeleitenden Wellenleiter 23 vom Antennenchip abgeleitet. Wegen des großen Dynamikbereichs von SQIFs können Kühler verschiedenster Bauart verwendet werden.

In einer nicht dargestellten Ausführungsform ist der Kühlfinger auf dem sich der Antennenchip befindet selbst als primäre Antennenstruktur ausgelegt. Da durch den Träger (Substrat) der Kühlfinger ohnehin magnetisch und elektrisch an den SQIF gekoppelt ist, hat diese Ausführungsform den Vorteil, das sich nicht unbedingt eine primäre Antennenstruktur auf dem Chip befinden muss.

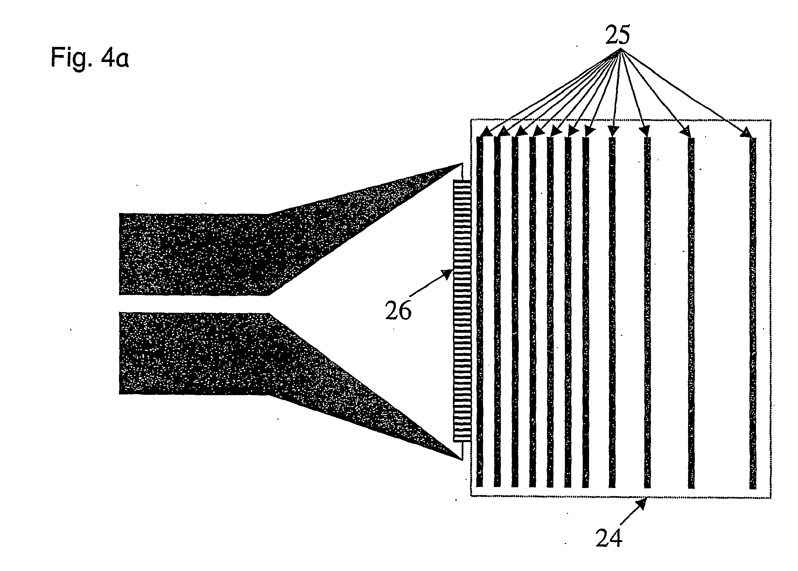

In Figur 4a besteht das primäre Antennenfeld 24 aus Leitungsstücken 25, deren Länge zur halben Wellenlänge der zu empfangenden elektromagnetischen Welle gewählt wurde. Diese Ausführungsform hat den Vorteil, dass im Resonanzfall hohe Blindströme in der Antennenstruktur fließen und den SQIF 26 damit optimal erregen. Durch entsprechende Auslegung des Antennenfelds mit Antennenstücken leicht unterschiedlicher Länge oder leicht unterschiedlichen Abstands untereinander kann ein Frequenzband modelliert werden, innerhalb dessen die Antenne besonders sensitiv ist.

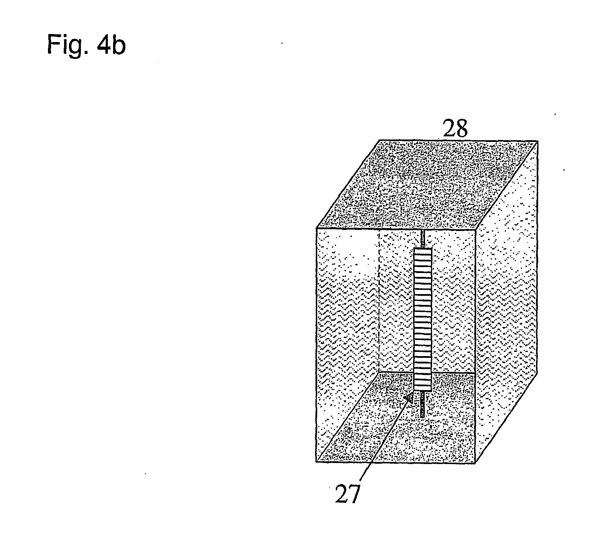

In Figur 4b ist eine Ausführungsform dargestellt, bei der sich der SQIF 27 in einer resonanten Kavität 28 (einseitig offener Wellenleiter) befindet. Dies hat neben der Erhöhung der Empfindlichkeit den Vorteil, dass durch die Lage des SQIF relativ zur Kavität bestimmte elektromagnetische Moden selektiert werden können, etwa zur Polarisationstrennung.

In einer nicht dargestellten Ausführungsform sind mehrere oder viele Antennen in Antennenfeldern angeordnet. Dies hat den Vorteil das die Empfindlichkeit mit der Zahl der Antennen anwächst, supergain Effekte genutzt werden können, und eine bestimmte Richtcharakteristik modelliert werden kann.

In einer ebenfalls nicht dargestellten Ausführungsform werden die Elemente eines solchen Antennenfeldes phasengesteuert betrieben (phased array Antenne). Hierzu werden mit geeigneten Phasenschiebern die Ausgangssignale der verschiedenen Antennen mit unterschiedlichen Phasenlagen überlagert. Dies hat den Vorteil, dass damit die räumliche Position des Senders der empfangenen elektromagnetischen Welle selektiert werden kann. Insbesondere, wenn die Abstände zwischen den Antennen im Antennenfeld inkommensurabel gewählt werden, lässt sich durch eine phasensensitive Überlagerung der Ausgangssignale der verschiedenen Antennen des Antennenfelds die räumliche Position des Senders der elektromagnetischen Welle bestimmen. Wegen des auf einem quantenmechanischen Effekt beruhenden Funktionsprinzips, der sehr hohen Linearität der aktiven Antenne und den niedrigen Betriebstemperaturen ist das Phasenrauschen erfindungsgemäßer Antennen sehr gering. Neben der sehr hohen Sensitivität im Vergleich zu konventionellen Antennen ist dieses geringe Phasenrauschen eine weiterer großer Vorteil erfindungsgemäßer Antennen.

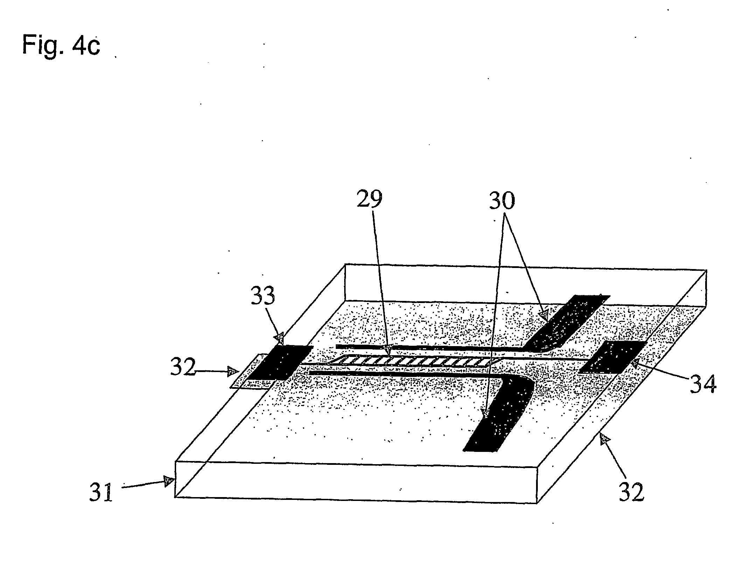

In Figur 4c ist ein Ausführungsbeispiel der Antenne in Mikrostreifenleitungstechnologie dargestellt. Der SQIF 29 und die primäre Antennenstruktur 30 befinden sich auf der Oberseite eines Substrats 31. Die elektrisch leitende Grundplatte 32 bildet die Gegenelektrode. Die am SQIF 29 bei Erregung abfallende Spannung wird zwischen der Elektrode 33 und der Grundplatte 32 abgegriffen. Die Elektrode 34 dient der Stromversorgung des SQIF und/oder der Verbindung zur Grundplatte. Bei Substraten, die dies zulassen, können auch Durchkontaktierungen auf die Grundplatte (vias) hierzu verwendet werden. Bei der Verwendung von Mehrlagentechnologien kann die Grundplatte (Gegenelektrode) auch durch leitende Schichtstrukturen auf der Oberfläche des Substrats gebildet werden.

Wird die aktive Antenne oder der Antennenchip in einem aktiven Kühlsystem betrieben, dann kann auch der Kühlfinger selbst auf welchem die aktive Antenne angebracht ist, als Gegenelektrode (Grundplatte) verwendet werden. Da der Kühlfinger typischerweise aus sehr gut wärmeleitenden Metallen und damit in der Regel auch sehr gut elektrisch leitenden Materialen besteht, hat ein solcher Aufbau große herstellungstechnische Vorteile.

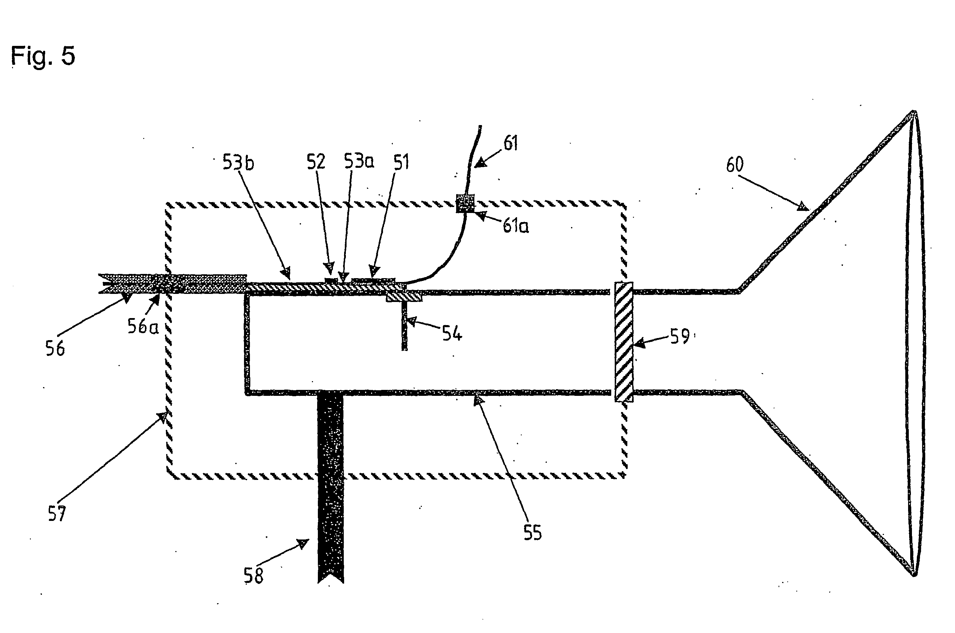

In Figur 5 ist ein Ausführungsbeispiel für elektromagnetische Wellen hoher Frequenz dargestellt. Die primäre Antennenstruktur besteht aus einer Hornantenne 60 und einem Hohlleiterabschluss 55 mit Antennenstift 54. Durch den Antennenstift 54 wird die einfallende Welle aus dem Hohlleiterabschluss ausgekoppelt. Der Antennenstift 54 ist direkt mit dem Eingang eines supraleitenden Quanten-Interferenz-Filters 51 verbunden. Eine weitere Verstärkung des Signals wird durch einen tieftemperaturtauglichen Transistor 52, welcher als Verstärker verschaltet ist, erreicht. Der supraleitende Quanten-Interferenz-Filter 51 und der Transistor 52 sind über eine Mikrostreifenleitung 53a miteinander verbunden. Das verstärkte Signal wird über eine weitere Mikrostreifenleitung 53b in einen Wellenleiter 56 eingespeist. Der Hohlleiterabschluss 55 und die Verschaltung aus Antennenstift, supraleitendem Quanten-Interferenz-Filter und tieftemperaturtauglichem Transistor befinden sich innerhalb einer thermischen Isolierung 57, welche über ein Hochfrequenzfenster 59 verfügt. Der Wellenleiter 56 verlässt die thermische Isolierung 57 über eine Durchführung 56a. Die Steuer- und Versorgungsleitungen 61 der Verschaltung werden durch die Durchführung 61a geführt. Die Verschaltung 51, 52, 53a, 53b ist über den Hohlleiterabschluss 55 und einen thermischen Leiter 58 an ein Kältereservoir (nicht dargestellt) (passive Kühlung, z.B. durch Flüssiggas) oder an einen aktiven Kühler (aktive Kühlung, z.B. Sterling- oder Pulsröhrenkühler) gekoppelt.

Der Antennenstift 54 und die Mikrostreifenleitungen 53 können normalleitend und/oder supraleitend ausgeführt werden. Zur weiteren Erniedrigung des Eigenrauschens kann auch der Hohlleiterabschluss 55 aus supraleitenden Materialien aufgebaut sein. Die aktiven bzw. passiven Kühlelemente sollten vorzugsweise bezüglich ihrer Kühlleistung so ausgelegt sein, dass mindestens am Ort der aus Supraleitern aufgebauten Bauteile die supraleitende Sprungtemperatur erreicht werde kann.

Die thermische Isolierung 57 kann als Vakuumgefäß ausgeführt werden. Das Hochfrequenzfenster 59 wirkt dann gleichzeitig als Vakuumfenster und die Durchführungen 56a und 61a sind als vakuumfeste Durchführungen ausgelegt. Vakuumgefäße haben den Vorteil sehr guter thermischer Isolierung und Erlauben den Betrieb der Antenne bei sehr tiefen Temperaturen.

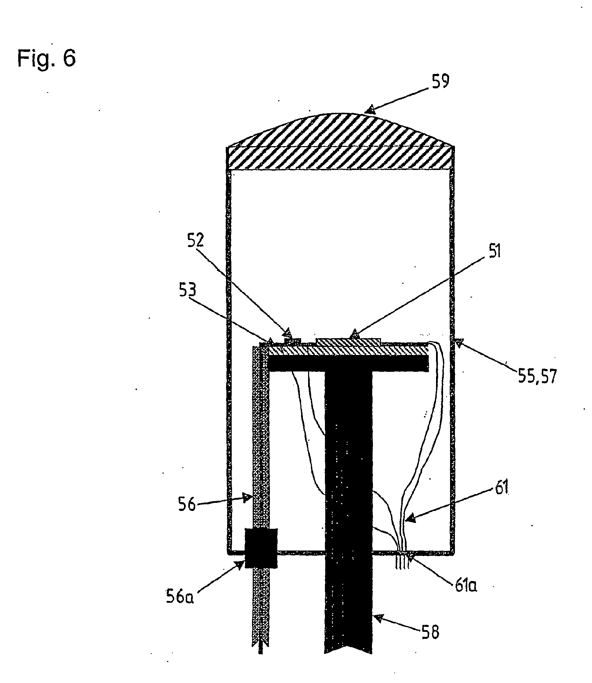

Figur 6 zeigt ein Ausführungsbeispiel, bei dem die thermische Isolierung 57 als metallisches Vakuumgefäß 55 ausgeführt ist. Der supraleitende Quanten-Interferenz-Filter befindet sich auf einem Chip, welcher auf dem Kühlfinger 58 eines aktiven Kühler montiert ist. Er ist über eine Mikrostreifenleitung mit einem tieftemperaturtauglichen Transistor 52 verbunden. Über die Mikrostreifenleitung 53 wird das verstärkte Signal in einem Wellenleiter 56 eingespeist und zum Verbraucher geleitet. Die Leitungen 61 dienen der Versorgung der Schaltung mit Betriebs- und Steuerströmen bzw. -spannungen. Die Vakuumdurchführung 61a ist als verglaste Durchführung ausgeführt.

Der erste Teil der primären Antennestruktur besteht aus einer dielektrischen Linse 59, welche gleichzeitig als Vakuumfenster dient. Die einfallende Welle wird direkt auf eine on-chip Antennenstruktur fokussiert, welche direkt an den supraleitenden Quanten-Interferenz-Filter angekoppelt ist. Bei entsprechender Auslegung des Vakuumgefäßes als Wellenleiter und damit als weiterer Teil der primären Antennenstruktur, kann so die Ausbreitung parasitärer Moden verhindert werden. Die Integration des tieftemperaturtauglichen Transistors direkt beim supraleitenden Quanten-Interferenz-Filter hat neben dem sehr geringen Eigenrauschen des Systems den zusätzlichen Vorteil, dass die bei der Vakuumdurchführung 56a des Wellenleiters 56 zwangsläufig auftretenden Verluste keine Verschlechterung des Signal-Rauschverhältnisses bewirken.

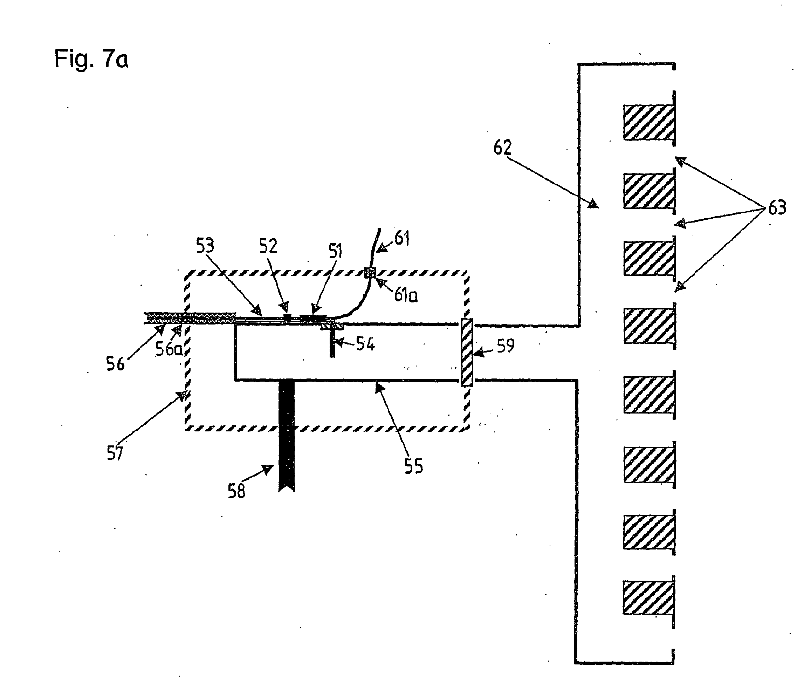

In Figur 7a ist eine Ausführungsform skizziert, bei der die primäre Antennenstruktur aus einem Feld von Aperturantennen 63, einer Hohlleiterstruktur 62, welche die Signale der einzelnen Aperturantennen zusammenführt, und einem Hohlleiterabschluss 55 mit Auskopplungsstift 54 besteht. Der Bauraumbedarf dieser Ausführung ist typischerweise erheblich kleiner als der Bauraumbedarf des Ausführungsbeispiels von Figur 5.

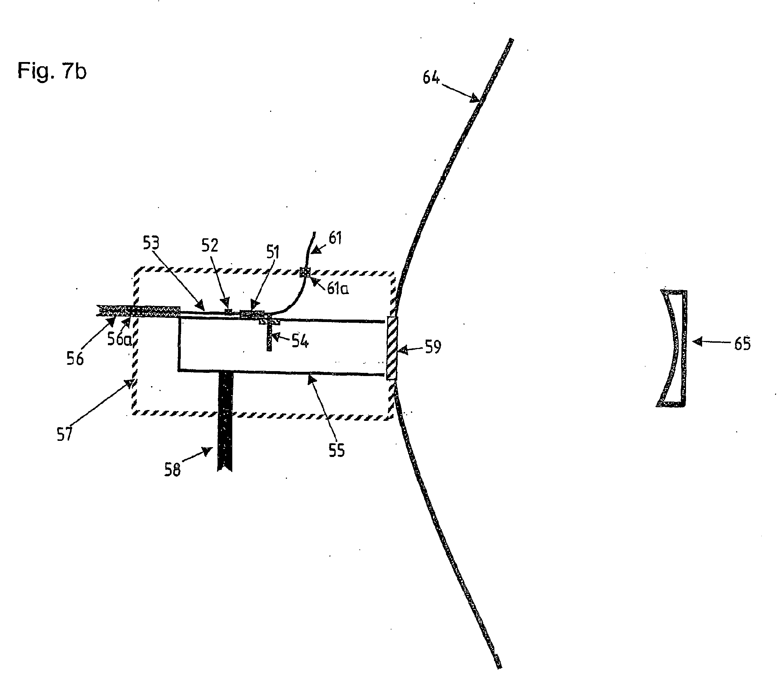

In Figur 7b ist ein Teil der primären Antennenstruktur als Parabolspiegel 64 ausgeführt, in dessen Brennpunkt sich ein weiterer, kleiner Spiegel 65 befindet, der die einfallende Welle auf den Hohlleiterabschluss 55 fokussiert. Das Hochfrequenzfenster 59 befindet sich im Zentrum des Parabolspiegels 64. Diese Ausführungsform hat den Vorteil, dass Abschattungs- und Beugungseffekte durch den Sekundärspiegel 65 sehr klein gehalten werden können. Es sind jedoch auch Ausführungsformen möglich, bei denen die Verschaltung und der Hohlleiterabschluss selbst entsprechend im Brennpunkt des Parabolspiegels montiert sind.

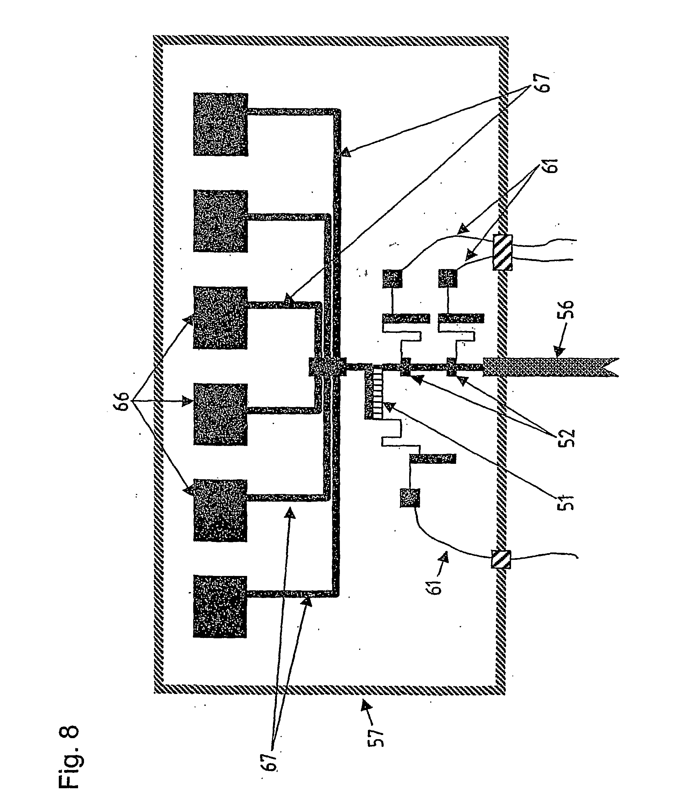

Figur 8 zeigt ein Ausführungsbeispiel, bei dem die primäre Antennenstruktur aus einem Feld von Patch-Antennen 66 und Mikrostreifeleitungen 67, welche die Signale der einzelnen Patch-Antennen zusammenführen, besteht. Die gesammelten Signale werden in einen supraleitenden Quanten-Interferenz-Filter 51 eingespeist, dessen Ausgang mit einem zweistufigen Transistorverstärker 52 verbunden ist. Das Ausgangssignal der Verschaltung wird in einen Wellenleiter 56 eingespeist. Die Betriebsströme und -spannungen werden über die Leitungen 61 und Kapazitäten und Induktivitäten den aktiven Bauelementen zugeführt. Bei diesem Ausführungsbeispiel befindet sich die gesamte Verschaltung und die gesamte primäre Antennenstruktur in einer thermischen Isolierung 57. Die Ankopplung an das Kältereservoir erfolgt typischerweise von unten, das Hochfrequenzfenster befindet sich über dem Antennenfeld.

Die in Fig. 9 skizzierten Ausführungsbeispiele für einen SQIF werden im Folgenden näher erläutert. Die Abbildungen gemäß Fig. 9a und 9b zeigen die physikalischen Realisierungen von einfachen Mehrschlaufen-Netzwerken 101, 102 mit Josephsonkontakten 103, 104, deren Geometrie und Detektionsverhalten supraleitende Quanten-Interferenz-Filter konstituieren. Die Netzwerke 101, 102 bestehen aus supraleitenden Bereichen 105, 106, die durch die Josephsonkontakte 103, 104 miteinander verbunden sind. Die supraleitenden Bereiche können dabei sowohl aus tieftemperatur-supraleitenden Materialen als auch aus hochtemperatur-supraleitenden Materialien bestehen. Auch von der speziellen Ausführung der Josephsonkontakte (z.B. breakjunctions, step-junctions, Mikrobrücken etc.) hängt die Funktionsfähigkeit des Netzwerks nicht ab. Die quantitativen Angaben zu den Ausführungsbeispielen beziehen sich beispielhaft auf die Parameterspezifikationen der dem Stand der Technik entsprechenden typischen Josephsonkontakte aus konventionellen Supraleitern, zum Beispiel solche mit der *Nb/Al0$_x$/Nb*-Technologie hergestellten Josephsonkontakten, wie sie in herkömmlichen SQUID-Magnetometer zum Einsatz kommen. Solche Kontakte besitzen typische kritische Ströme $i_c$ von etwa 200 $\mu$ A und einen Normalwiderstand $r_n$, der durch einen extern parallelgeschalteten Ohmschen Widerstand definiert ist von z.B. etwa 1Ω, sowie eine geometrische shunt-Kapazität $c_\pi$ im Bereich von Pikofarad. Die räumliche Ausdehnung des Netzwerks kann vergleichbar mit der herkömmlicher SQUIDs sein. Die Abmessungen der Zellen der Netzwerke liegen dann im Bereich von $\mu$m bis mm. SQIF-Netzwerke können je nach Anwendung aber auch Zellen mit größeren oder kleineren Abmessungen aufweisen.

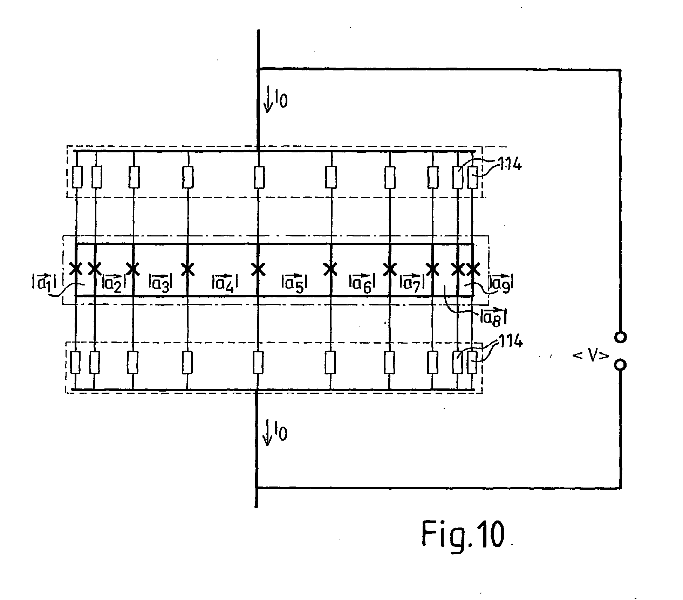

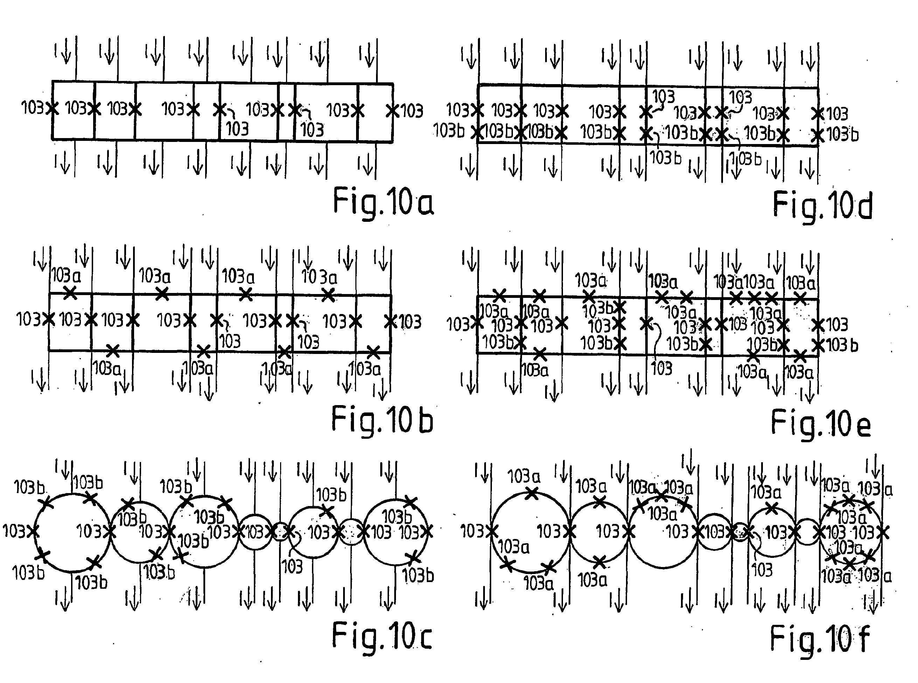

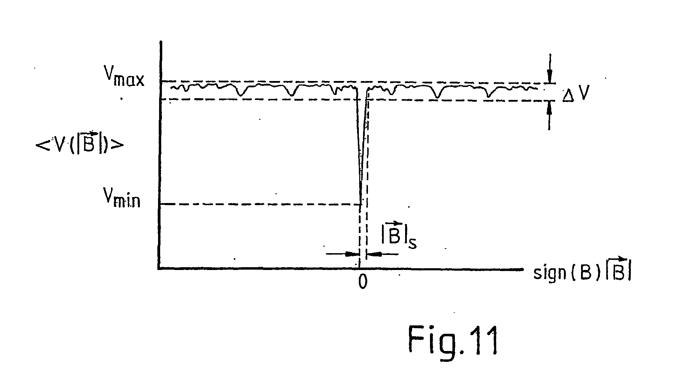

In den Fig. 9a und 9b wird der supraleitende Quanten-Interferenz-Filter konstituiert durch ein ebenes Netzwerk 101, 102 aus den Josephsonkontakten 103, 104, das Zellen 107 bis 113 bzw. 107a bis 114a besitzt, welche jeweils zwei Kontakte in Stromrichtung besitzen. Das Schaltbild des äquivalenten supraleitenden Stromkreises eines SQIF mit $N = 10$ Kontakten ist in Fig. 10 dargestellt. Das Netzwerk ist dadurch gekennzeichnet, dass die einzelnen Flächen der Zellen 101 bis 109 eine unterschiedliche Größe besitzen und die Flächeninhalte $|a_j|$ der verschiedenen Netzwerkzellen in keinem rationalen Verhältnis zueinander stehen. Mit 114 sind Ersatzwiderstände bezeichnet. Das Kreuz kennzeichnet die Josephsonkontakten 101 bis 110. Durch den strichpunktierten Kasten um die Josephsonkontakte wird der supraleitend verbundene Bereich verdeutlicht. Die fett durchgezogenen Linien innerhalb dieses Kastens symbolisieren supraleitende Verbindungen. Insbesondere unter diesen Voraussetzungen entsteht der physikalische Effekt der multiplen makroskopischen Quanten-Interferenz derart, dass die quantenmechanischen Wellenfunktionen, welche den Zustand der einzelnen supraleitenden Bereiche des Netzwerks beschreiben, nur dann konstruktiv interferieren, wenn der das Netzwerk durchsetzende magnetische Fluss identisch verschwindet. Der makroskopische Gesamtzustand des Netzwerks kann dadurch ausgelesen werden, dass das Netzwerk durch einen konstanten oder einen zeitveränderlichen überkritischen Strom $I_0$ getrieben wird. Dann ergibt sich eine Spannungsantwortfunktion $\left\langle V(\vec{B};I_0) \right\rangle$, die nur ein globales absolutes Minimum bei $|\vec{B}| = 0$ besitzt und bei anwachsendem $|\vec{B}|$ monoton ansteigt, bis schließlich ein annähernd konstant bleibender Wert $V_{\max}(\vec{B};I_0)$ erreicht wird, der sich bei weiter anwachsendem $|\vec{B}|$ nicht mehr wesentlich ändert, wie dies in Fig. 11 für ein Netzwerk mit $N = 30$ Kontakten schematisch dargestellt ist. Für ein am Ort des Netzwerks vorhandenes magnetisches Feld $\vec{B}$ mit $0 < |\vec{B}| < |\vec{B}|_s$ ist die Spannungsantwortfunktion des supraleitenden Quanten-Interferenz-Filters daher eindeutig. Für $|\vec{B}| > |\vec{B}|_s$ ergibt sich eine nahe bei $V_{\max}$ schwankende Spannungsantwort, deren Varianz mit anwachsendem N schnell kleiner wird, wobei $V_{\max}$ das globale absolute Maximum der Spannungsantwortfunktion ist (vgl. Fig. 11). Der Messbereich des supraleitenden Quanten-Interferenz-Filters wird bestimmt durch den Abstand zwischen dem globalen Minimum und $V_{\max}-\Delta V$, wobei $\Delta V$ den Abstand zwischen dem kleinsten lokalen Minimum für $|\vec{B}| > |\vec{B}|_s$ und $V_{\max}$ bezeichnet. Der Wert $|\vec{B}| = 0$ definiert damit die untere Grenze des Messbereichs und der Wert von $|\vec{B}|$, an dem die Spannungsantwort den Wert $V_{\max}-\Delta V$ erreicht, definiert die obere Grenze $|\vec{B}|_s$ des Messbereichs (vgl. Fig. 11). Die Größe von $\Delta V$ hängt dabei von der Zahl der Zellen, welche das Netzwerk besitzt, und von der Wahl der Flächeninhalte der einzelnen Netzwerkzellen, bzw. von deren Verhältnissen zueinander ab. Dies wird in der im nächsten Absatz folgenden theoretischen Beschreibung des supraleitenden Quanten-Interferenz-Filters näher erläutert.

In den Fig. 10b bis f sind Ausführungsformen von Netzwerken skizziert, bei welchen die einzelnen Netzwerkzellen zusätzlich zu den zwei funktional notwendigen Kontakten 103 gemäß Fig. 10a einen weiteren Kontakt oder mehrere weitere Kontakte umfassen. Die Kontakte sind dabei als Kreuze gekennzeichnet. Die dick durchgezogenen Linien kennzeichnen supraleitende Verbindungen. Die dünn durchgezogenen Linien können normalleitend oder supraleitend sein. Die zusätzlichen Kontakte können dabei derart in den einzelnen Netzwerkzellen angebracht werden, dass durch sie kein oder nur ein geringer Teil des treibenden Stroms fließt (nicht direkt bestromte Kontakte 103a) und im Mittel auch keine zeitveränderliche Spannung abfällt. Durch solche Ausführungsformen können die von einem magnetischen Feld in den einzelnen Zellen induzierten Abschirmströme reduziert werden. Des Weiteren kann daher der Einfluss von Eigen- und Gegeninduktivitäten dadurch vermindert werden. Die zusätzlichen Kontakte können jedoch auch so angebracht sein, dass sie vom treibenden Strom I durchflossen werden (direkt bestromte Kontakte 103b). Auch eine Kombination von einem Kontakt 103a oder mehreren Kontakten 103a und einem Kontakt 103b oder mehreren Kontakten 103b in einzelnen oder mehreren Zellen des Netzwerks ist möglich.

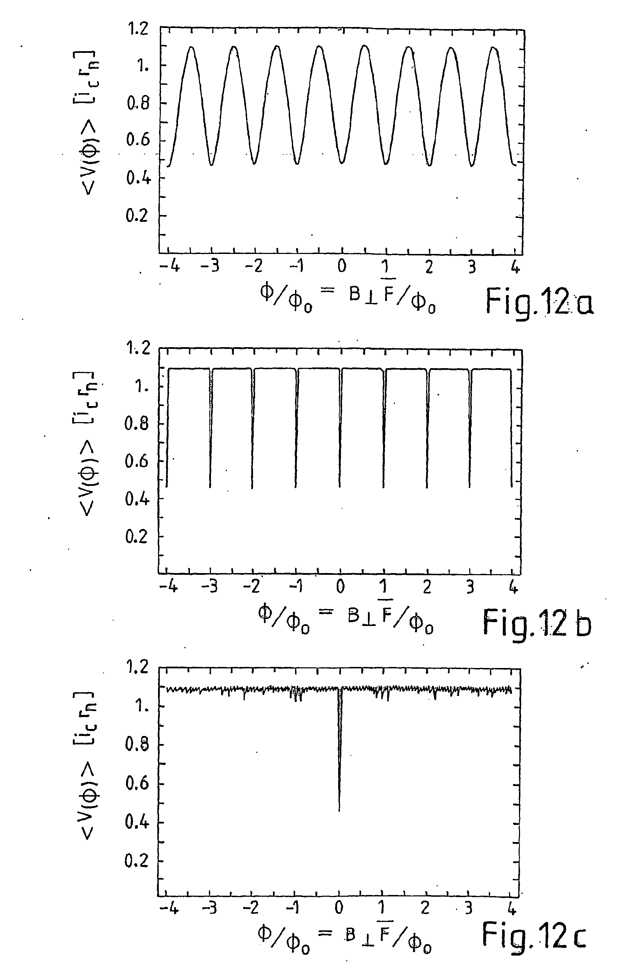

In den Fig. 12a bis 12c ist zum direkten Vergleich die Spannungsantwortfunktion eines konventionellen Einschlaufen-SQUIDs (Fig. 12a), eines konventionellen Mehrschlaufen-SQUID mit regelmäßigen Einheitszellen identischer Größe (Fig. 12b) und eines supraleitenden Quanten-Interferenz-Filters (Fig. 12c) dargestellt. Besagtes Beispiel zum Einschlaufen-SQUID besteht aus einer einzelnen supraleitenden Schlaufe bzw. Zelle mit zwei Josephsonkontakten, der Mehrschlaufen-SQUID aus einer Parallelanordnung solcher identischer Einschlaufen-SQUIDs ("Zeiterarray") mit $N=30$ Kontakten, und der supraleitende Quanten-Interferenz-Filter besitzt ebenfalls $N=30$ Kontakte. Der treibende Strom

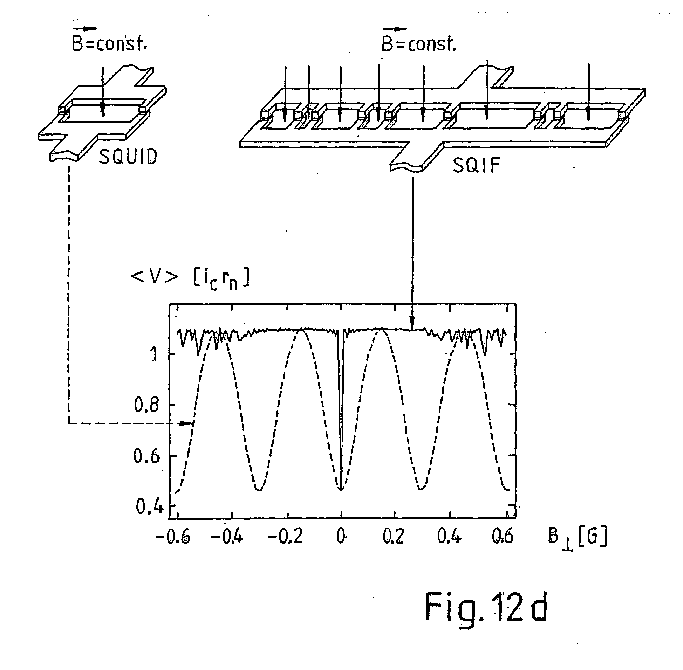

$I_0$ ist für alle drei Anordnungen so gewählt, dass für $|\vec{B}|=0$ der Strom pro Kontakt den Wert 1.1 $i_c$ besitzt, so dass der Spannungshub $V_{max}$-$V_{min}$ für alle drei Vorrichtungen gleich ist. In Fig. 12d sind die Spannungsantwortfunktionen eines konventionellen SQUIDs und eines SQIFS noch einmal anhand eines konkreten Ausführungsbeispiels dargestellt. Während Einschlaufen-SQUIDs und Mehrschlaufen-SQUIDs eine periodische Spannungsantwortfunktion $\langle V \rangle$ mit der Periode $\Phi_0$ derart besitzen, dass keine absolute Messung des magnetischen Feldes möglich ist, besitzt der ebene supraleitende Quanten-Interferenz-Filter eine eindeutige Spannungsantwortfunktion. Diese Spannungsantwortfunktion des SQIFs ermöglicht dadurch die absolute quantitative Messung des magnetischen Feldes. Im gewählten Beispiel liegt der Messbereich zwischen $\Phi$=0 und $\Phi \equiv B_\perp \overline{F} \approx 0.02\,\Phi_0$. Bei einer mittleren Netzwerkzellenfläche $\overline{F}$ im Bereich von $\mu$m$^2$ entspricht dies Magnetfeldstärken zwischen $B_\perp$=0 und $B_\perp$=10$^{-4}$ T und für $\overline{F}$ im Bereich von mm$^2$ Magnetfeldstärken zwischen $B_\perp$=0 T und $B_\perp$=10$^{-10}$ T. Die Auflösungsgrenze kann bei diesen Beispielen im Bereich von 10$^{-13}$ T bis 10$^{-16}$ T liegen.

Durch Verwendung einer Kompensationsschaltung, mit deren Hilfe ein magnetischer Fluss bekannter Stärke kontrolliert in den supraleitenden Quanten-Interferenz-Filter eingekoppelt werden kann, lässt sich der Messbereich der erfindungsgemäßen Vorrichtung bei gleichbleibender Empfindlichkeit beliebig variieren.

Die elektrotechnische theoretische Beschreibung des supraleitenden Quanten-Interferenz-Filters kann mit Hilfe des sogenannten RCSJ -Modells (RCSJ = resistively and capacitively shunted junction) für die einzelnen Josephsonkontakte unter Berücksichtigung der Netzwerktheorie für supraleitende Schaltungen erfolgen. Im RCSJ-Modell wird der einzelne Josephsonkontakt durch eine nichtlineare Induktivität beschrieben, der ein ohmscher shunt-Widerstand $r_n$ und eine geometrische, die Tunnelbarriere charakterisierende shunt-Kapazität $c_n$ parallelgeschaltet sind. Die Beschreibung des makroskopischen Zustands der Josephsonkontakte erfolgt durch die eichinvariante Differenz der makroskopischen quantenmechanischen Phasen an den beiden gegenüberliegenden supraleitenden Elektroden des jeweiligen Kontakts. Diese Phasendifferenz wird mit $\phi_j$ bezeichnet, wobei $j=1...N$ die einzelnen Kontakte des Netzwerks indiziert. Die der Netzwerkdynamik zugrundeliegenden Relationen sind dann durch

$$I_j = i_c \sin(\phi_j) + \frac{v_j(t)}{r_n} + c_n\, \partial_t v_j(t), \qquad (1)$$

$$v_j(t) = \frac{\hbar}{2e} \partial_t \phi_j, \qquad (2)$$

$$\phi_{j+1} - \phi_j = 2\pi\, \frac{\Phi_j}{\Phi_0} \qquad (3)$$

gegeben, wobei $I_j$ den durch den Kontakt mit Index $j$ fließenden Strom mit $\Sigma_{j=1}^{N} I_j = I_0$ und $\Phi_j$ den die Netzwerkzelle mit Index $j$ durchsetzenden magnetischen Fluss bezeichnet. Gleichung 1 beschreibt die nichtlineare Relation zwischen dem Strom $I_j$ und der über dem Kontakt abfallenden Spannung $v_j(t)$ im RCSJ Modell. Gleichung 2 entspricht der zweiten Josephson-Relation, nach der die über dem Kontakt abfallende Spannung $v_j(t)$ direkt proportional der zeitlichen Ableitung $\partial_t \phi_j$ der Phasendifferenz $\phi_j$ ist. Gleichung 3 ist Ausdruck der Quantisierung des magnetischen Flusses durch eine geschlossene supraleitende Schlaufe.

Der Einfachheit halber wird bei der theoretischen Beschreibung angenommen, dass die Netzwerkkontakte identisch sind, d.h. dass sowohl die kritischen Ströme $i_c$ als auch die parallelgeschalteten shunt-Widerstände $r_n$ und shunt-Kapazitäten $c_n$ nicht statistisch oder systematisch streuen. Das Auftreten von typischen fertigungsbedingten Parameterstreuungen beeinträchtigt die Funktionsfähigkeit des supraleitenden Quanten-Interferenz-Filters jedoch nicht. Die theoretische Beschreibung im Rahmen des RCSJ-Modells beschränkt sich zudem auf sogenannte Punktkontakte, d.h. auf Kontakte, die so klein sind, dass die Phasendifferenzen über die Ausdehnung der Kontaktbarriere nicht variieren. Dies ist eine auch bei der theoretischen Beschreibung konventioneller SQUIDs übliche Annahme. Bei supraleitenden Quanten-Interferenz-Filtern ist diese Annahme in besonderer Weise gerechtfertigt, da im Gegensatz zu konventionellen SQUIDs die auftretenden Interferenzmuster mit wachsender Zahl der Netzwerkzellen von der Netzwerkdynamik dominiert werden und daher nur äußerst schwach von der speziellen Geometrie der einzelnen Kontakte abhängen.

Die aus der Stromerhaltung und den Gleichungen 1 bis 3 folgenden Netzwerkgleichungen verknüpfen das am Ort des Netzwerks wirkende Magnetfeld $\vec{B}$ und den treibenden Strom $I_0$ mit der über der Schaltung abfallenden Spannung $V(t)$. Für statische oder im Vergleich zur Netzwerkfrequenz langsam variierende Magnetfelder $\vec{B}$ kann die Netzwerkgleichung für den SQIF dieses Ausführungsbeispiels und allgemein für SQIFs, die aus parallel geschalteten Netzwerkzellen bestehen, als nichtlineare Differentialgleichung der Form

$$\frac{\hbar}{2e}\frac{c_n}{i_c}\partial_t^2 \phi_1 + \frac{\hbar}{2e i_c r_n}\partial_t \phi_1 + \left|S_N(\vec{B})\right|\sin(\phi_1 + \delta_N) = \frac{I_0}{N i_c} \qquad (4)$$

$$v_1(t) = \frac{\hbar}{2e}\partial_t \phi_1 \qquad (5)$$

geschrieben werden, wobei sich das Magnetfeld $\vec{B} = \vec{B}_{ext} + \vec{B}_c$ aus dem zu messenden, primärem äußeren Feld $\vec{B}_{ext}$ und eventuell einem kontrolliert erzeugten, sekundären magnetischen Kompensationsfeld $\vec{B}_c$ zusammensetzt. Der in Gleichung 4 auftretende komplexe $(i=\sqrt{-1})$ Strukturfaktor $S_N(\vec{B}) = \left|S_N(\vec{B})\right|\exp\left[i\,\delta_N(\vec{B})\right]$ beschreibt die geometrischen und dynamischen Eigenschaften des aus N-1 Zellen zusammengesetzten supraleitenden Quanten-Interferenz-Filters. Er bestimmt die räumlichen und zeitlichen Interferenzeigenschaften des Netzwerks in Abhängigkeit von der Stärke des zu messenden Magnetfelds. Die Phasenverschiebung $\delta_N$ hängt ebenfalls von der speziellen Geometrie der Anordnung ab, hat jedoch keinen Einfluss auf die zeitlich gemittelte Spannungsantwortfunktion $\left\langle V(\vec{B};I_0)\right\rangle$.

Der komplexe Strukturfaktor $S_N(\vec{B})$ ist zu

$$S_N(B) = \frac{1}{N}\sum_{n=0}^{N-1}\exp\left(\frac{2\pi i}{\Phi_0}\sum_{m=0}^{n}\left\langle \vec{B},\vec{a}_m\right\rangle\right) \qquad (6)$$

definiert, wobei die Vektoren $\vec{a}_m$ die orientierten Flächenelemente ( $\frac{\vec{a}_m}{|\vec{a}_m|}$ = Flächennormale, $\left|\vec{a}_m\right|$ = Flächeninhalt der m-ten Schlaufe) der einzelnen Netzwerkschlaufen bezeichnen und $\vec{a}_0$ = 0 gilt. Für den die einzelnen Netzwerkschlaufen durchsetzenden magnetischen Fluss gilt damit $\Phi_m = \left\langle \vec{B}, \vec{a}_m\right\rangle$, wobei für zwei beliebige Vektoren $\vec{a}, \vec{b}$ das Skalarprodukt durch $\left\langle \vec{a}, \vec{b}\right\rangle = \left|\vec{a}\right|\left|\vec{b}\right|\cos\angle(\vec{a},\vec{b})$ definiert ist. Variiert das Magnetfeld $\vec{B}$ über die Ausdehnung der Schlaufe, dann tritt an die Stelle dieses Skalarprodukts die entsprechende Integraldarstellung. Die Periodizität des Netzwerks wird durch die akkumulierten magnetischen Flüsse

$$\alpha_n = \sum_{m=0}^{n}\left\langle \vec{B},\vec{a}_m\right\rangle \qquad (7)$$

mit $n$ = 0...$N$-1 bestimmt.

Für konventionelle Einschlaufen-SQUIDs, bei denen nur eine orientierte Fläche $\vec{a}_1$ existiert, nimmt $S_N$ mit $N$ = 2 den Wert $S_2 = \frac{1}{2}\left(1 + \exp\left[\frac{2\pi i}{\Phi_0}\Phi\right]\right)$ und $|S_2| = \cos\left(\frac{\pi \Phi}{\Phi_0}\right)$ an. Für ebene periodische Mehrschlaufen-SQUIDs mit identischen Schläufenflächen $\vec{a}_1 = \vec{a}_2 = \vec{a}_3 = ... = \vec{a}_{N-1}$ ist $\alpha_n = n\Phi$ mit $\Phi = B_\perp|\vec{a}_1|$, so dass $S_N = \frac{1}{N}\sum_{n=0}^{N-1}\exp\left[\frac{2\pi i}{\Phi_0}n\Phi\right]$ eine geometrische Reihe ist, mit dem Ergebnis $|S_N| = \frac{\sin(N \pi \Phi/\Phi_0)}{N\sin(\pi \Phi/\Phi_0)}$. Die Strukturfaktoren für solche dem derzeitigen Stand der Technik entsprechenden konventionellen SQUIDs besitzen somit unabhängig von der Zahl der Kontakte periodische Strukturfaktoren. Diese periodischen Strukturfaktoren sind die Ursache für die ebenfalls streng $\Phi_0$-periodischen Spannungsantwortfunktionen $\langle V(\vec{B};I_0)\rangle$ solcher Vorrichtungen, und damit die Ursache dafür, dass mit solchen dem Stand der Technik entsprechenden Vorrichtungen eine absolute Messung des magnetischen Feldes nicht möglich ist. Supraleitende Quanten-Interferenz-Filter besitzen demgegenüber keine periodischen Strukturfaktoren, da $S_N(\vec{B})$ nach Gleichung 6 für inkommensurable akkumulierte magnetische Flüsse $\alpha_n$ keine Periodizität aufweisen kann. Supraleitende Quanten-Interferenz-Filter besitzen damit auch keine periodischen Spannungsantwortfunktionen $\langle V(\vec{B};I_0)\rangle$ und ermöglichen dadurch die absolute Messung magnetischer Felder.

Nach Gleichung 3 gilt für statische oder im Vergleich zur Netzwerkfrequenz langsam variierende äußere Felder $v_j(t)=V_1(t)$ für alle j = 1 ...N, d.h. $v_1(t)$ definiert die über den supraleitenden Quanten-Interferenz-Filter abfallende Wechselspannung. Die Netzwerkfrequenz $\Phi$ hängt über die Einstein-Relation $h\nu = 2e\langle V(\vec{B};I_0)\rangle$ mit dem zeitlichen Mittelwert dieser Wechselspannung, der Spannungsantwortfunktion $\langle V(\vec{B};I_0)\rangle = \frac{1}{T}\int_0^T v_1(t)\,dt$ zusammen, wobei $T = \frac{1}{\nu}$ gilt. Für typische $Nb/AlO_x/Nb$-Josephsonkontakte liegt die Netzwerkfrequenz $\Phi$ bei etwa 100 GHz, so dass die Frequenz $\Phi_{ext}$ des äußeren Feldes in einem Bereich zwischen $\Phi_{ext}$=0 bis etwa 20 GHz liegen kann. Als einfach zugängliche Messgröße kann wie bei konventionellen SQUIDs die im zeitlichen Mittel über das Netzwerk abfallende Gleichspannung $\langle V(\vec{B};I_0)\rangle$ dienen. Der Einfluss von Induktivitäten und durch den Treiberstrom verursachten Eigenfelder wird in Gleichung 4 und 5 der besseren Verständlichkeit halber vernachlässigt. Tatsächlich können Induktivitäten und Eigenfelder bei geeigneter Auslegung des supraleitenden Quanten-Interferenz-Filters so minimiert werden, dass deren Funktionsfähigkeit durch diese Einflüsse nicht beeinträchtigt wird. Entsprechende Vorrichtungen werden in den weiteren Ausführungsbeispielen vorgestellt.

Die Vernachlässigung der shunt-Kapazitäten $c_n$, die für typische Josephsonkontakte in sehr guter Näherung gerechtfertigt ist, ermöglicht eine analytische Lösung für die Spannungsantwortfunktion:

$$\langle V(B;I_0)\rangle = i_c r_n \sqrt{\left(\frac{I_0}{N i_c}\right)^2 - |S_N(B)|^2} \qquad (8)$$

Für alle dem derzeitigen Stand der Technik entsprechenden SQUIDs ist diese Spannungsantwortfunktion periodisch mit Periode $\Phi_0$, wie dies in Fig. 12a skizziert ist. Für SQIFs hingegen ist die Spannungsantwortfunktion nicht periodisch. Dies ist in Fig. 12c dargestellt. Die Spannungsantwortfunktion des supraleitenden Quanten-Interferenz-Filters besitzt wie die Spannungsantwortfunktion konventioneller SQUIDs ein Minimum für $\Phi$=0. Im Gegensatz zu konventionellen SQUIDs wiederholt sich dieses Minimum bei anwachsendem äußerem Feld jedoch nicht. Damit ist die Spannungsantwort für $\Phi$=0 eindeutig ausgezeichnet und ermöglicht je nach Auslegung direkt oder mit Hilfe einer geeigneten Kompensationsschaltung für das magnetische Feld die absolute quantitative Messung des äußeren magnetischen Feldes. Da der Betrag des Strukturfaktors $S_N$ in Gl. 8 quadratisch eingeht, schwankt die Spannungsantwortfunktion für die SQIFs auf dem oberen Teil des Graphen nur sehr leicht um den Wert $V_{max}$ und es ergibt sich eine ausgeprägt steile Flanke zwischen $V_{min}$ und $V_{max}$ (vgl. Fig. 12c).

Der Strukturfaktor $S_N(\vec{B})$ des supraleitenden Quanten-Interferenz-Filters kann derart optimiert werden, dass die Spannungsantwortfunktion $\langle V(\vec{B};I_0) \rangle$ einen maximalen Messbereich $0 < |\vec{B}| < |\vec{B}|_s$ besitzt. Dies ist dann der Fall, wenn der Abstand $\Delta V$ zwischen dem kleinsten lokalen Minimum von $V$ und dem maximalen Spannungswert $V_{max}$ für gegebene Gesamtfläche $\sum_{m=1}^{N-1} |\vec{a}_m|$ (vgl. auch Fig. 11) und gegebene Zahl der Netzwerkkontakte N im Operationsbereich minimal wird. Der maximale Operationsbereich eines supraleitenden Netzwerkes ist dabei durch die maximal erreichbare Kompensationsfeldstärke bestimmt.

Für ebene Netzwerke kann der Fall eintreten, dass eine durch den Fertigungsprozess verursachte minimal mögliche Längenvariation $l_0$ der Leiterbahnen auftritt. Die Flächeninhalte $|\vec{a}_m|$ der Netzwerkschlaufen können dann durch $|\vec{a}_m| = q_m l_0^2$ definiert werden, wobei die Zahlen $q_m$ positive ganze Zahlen sind. Im ungünstigsten Fall dürfen sich damit zwei Flächenelemente fertigungsbedingt nur um den Betrag von $l_0^2$ unterscheiden. Dies führt dazu, dass der Strukturfaktor $S_N(\vec{B})$ und damit die Spannungsantwortfunktion $\langle V(\vec{B};I_0) \rangle$ des supraleitenden Quanten-Interferenz-Filters rein theoretisch betrachtet periodisch variieren könnte. Die möglicherweise auftretende Periode ist allerdings in Bezug auf $\Phi_0$ sehr groß und entspricht $\frac{\Phi_0}{GGT} A_{tot}$, wenn GGT der größte gemeinsame Teiler der Beträge $|\vec{a}_m|$ der orientierten Flächenelemente eines planaren Netzwerks ist und $A_{tot}$ die Gesamtfläche des SQIF, $A_{tot} = \sum_{m=1}^{N-1} |\vec{a}_m|$ bezeichnet. Ein typischer, dem Stand der Technik entsprechender Wert für $l_0$ beträgt etwa hundert $nm$ (Niob-Prozess). Die minimale Flächendifferenz $l_0^2$ liegt damit in der Größenordnung von $10^{-2}$ $\mu m^2$ bei einer angenommenen Netzwerkzellenfläche des supraleitender Quanten-Interferenz-Filters von $10^{-2} mm^2$. Sind die Zahlen $q_m$ nun selbst teilerfremd, etwa dadurch, dass sie zu (verschiedenen) Primzahlen gewählt werden, dann ist die Periode der Spannungsantwortfunktion zu $\frac{\Phi_0}{l_0^2} A_{tot}$ gegeben. Diese Periode liegt für typische Gesamtflächen $A_{tot}$ von mehreren 1000 $\mu$ $m^2$ weit außerhalb des praktisch relevanten Mess- oder Operationsbereichs. Für einen in einer bestimmten Anwendung gegebenen Operationsbereich existiert damit immer ein supraleitender Quanten-Interferenz-Filter mit optimaler Fläche, Kontaktanzahl und zugehörigem Strukturfaktor.

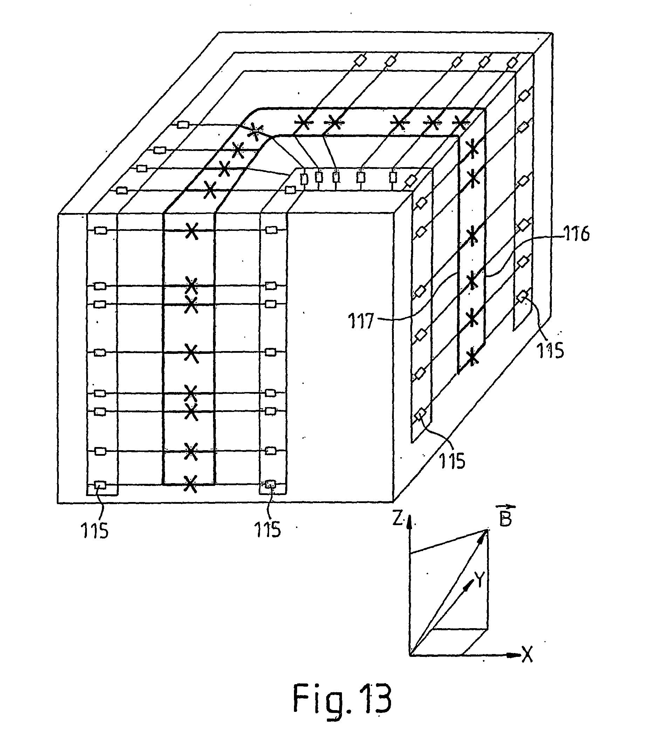

Ein weiteres Ausführungsbeispiel der Erfindung ist in Fig. 13 dargestellt. Die Netzwerkzellen zerfallen hier in drei Gruppen derart, dass aus den orientierten Flächenelementen $\vec{a}_m$ eine vollständige vektorielle Basis des dreidimensionalen Raumes gebildet werden kann. Diese Ausführung der Erfindung, die im Folgenden als Vektor-SQIF bezeichnet wird, hat den Vorteil, dass durch entsprechend ausgelegte Kompensationsfelder, die zum Beispiel jeweils ein kontrollierbares sekundäres Feld parallel zu jedem der aus den $\vec{a}_m$ gebildeten Basisvektoren erzeugen, sowohl die Stärke als auch die Richtung des zu messenden primären magnetischen Feldes eindeutig und mit sehr hoher Genauigkeit bestimmt werden kann. Dies ermöglicht die eindeutige quantitative Rekonstruktion des primären Magnetfeldvektors $\vec{B}_{ext}$ nach Betrag, Richtung und Phase, und erlaubt eine Vielzahl neuartiger Anwendungen. Schon mit zwei solcher Anordnungen ist es z.B. möglich, die Quellen eines magnetischen Feldes exakt zu lokalisieren und ihre Stärke zu bestimmen. Hierzu kann das drahtlose Auslesen von Detektorfeldern gehören, wenn die einzelnen Detektorsignale aus temporären elektrischen Strömen bestehen. Auch das Auslesen oder die Verarbeitung von elektronischen oder magnetischen Datenspeichern ist durch solche Anordnungen berührungslos und praktisch ohne Leistungsaufnahme oder -abgabe durch den SQIF bei einer sehr hohen zeitlichen Auflösung und damit einer extrem schnellen Verarbeitungsgeschwindigkeit im GHz bis THz Bereich möglich. Weitere Beispiele für die Anwendung solcher Vektor-SQIFs sind die räumlich und zeitlich hochaufgelöste Messung von Stoffwechselvorgängen, etwa im menschlichen Gehirn, von Signalen der Kernspin-Resonanz oder der Magnetfeldverteilung in der oberen Erdkruste, wie etwa in der Geoexploration. In Fig. 13 sind durch die Kreuze die Josephsonkontakte symbolisiert, mit dem Bezugszeichen 115 sind bus-bar-Widerstände bezeichnet. Die dicken durchgezogenen Linien stellen supraleitende Verbindungen dar. Die beiden dicken durchgezogenen Linien 116, 117 begrenzen zudem den supraleitend verbundenen Teil des Netzwerks.

In einem nicht dargestellten Ausführungsbeispiel ist der Vektor-SQIF aus drei unabhängig voneinander operierenden einzelnen ebenen SQIFs, deren Flächennormalen eine vektorielle Basis des dreidimensionalen Raumes bilden, aufgebaut. Diese Vorrichtung hat den Vorteil, dass die einzelnen ebenen SQIFs mit den dem derzeitigen Stand der Technik entsprechenden Standardmethoden der Dünnschichttechnologie problemlos gefertigt werden können.

Die quantitative Messung kann hier entweder durch simultane Kompensation der drei Komponenten des äußeren Magnetfelds wie im Ausführungsbeispiel des letzten Abschnitts oder durch direkte Messung der an jedem einzelnen SQIF abfallenden Spannung erfolgen. Letztere Messmethode ist für bestimmte Anwendungen ein weiterer Vorteil solcher Anordnungen, da dann keine Kompensationsvorrichtungen notwendig sind.

In zwei weiteren nicht dargestellten Ausführungsbeispielen ist der Vektor-SQIF entsprechend dem letzten oder vorletzten Abschnitt so aufgebaut, dass die Flächennormalen der einzelnen SQIFs oder die orientierten Flächenelemente $\vec{a}_m$ derart angeordnet sind, dass aus ihnen eine vollständige vektorielle Basis eines zweidimensionalen Unterraumes des dreidimensionalen Raumes gebildet werden kann. Diese Ausführung kann dann von Vorteil sein, wenn das magnetische Feld nur in einer Ebene gemessen werden soll, z.B. wenn es sich um ebene Detektorfelder oder Speicher handelt.

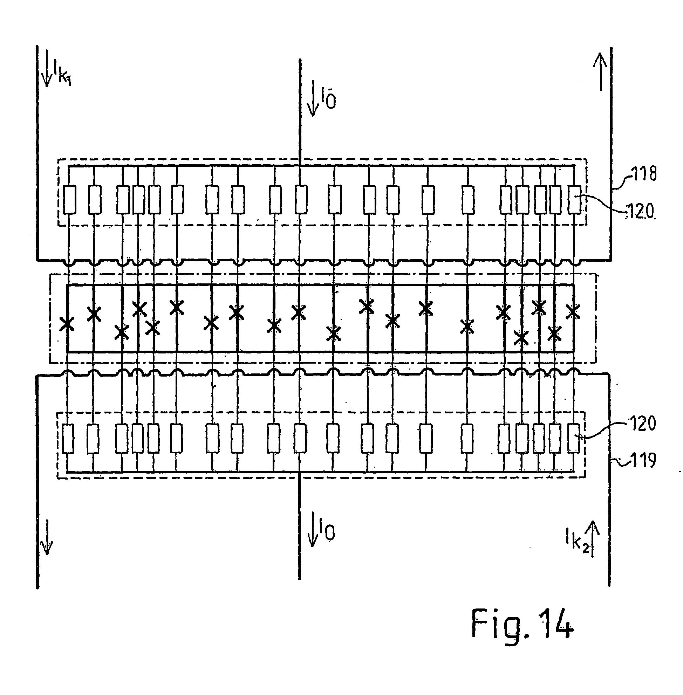

In Fig. 14 ist ein Ausführungsbeispiel eines ebenen SQIFs dargestellt, bei dem das magnetische Kompensationsfeld durch zwei Steuerleitungen 118, 119, welche parallel zum Netzwerk und damit senkrecht zur Richtung des treibenden Stromes liegen, erzeugt wird. Fließt in einer solchen erfindungsgemäßen Anordnung ein Strom $I_{k1}$, $I_{k2}$ durch eine oder beide Steuerleitungen 118, 119, so wird in die Zellen des SQIF ein durch diesen Strom sehr genau kontrollierbarer magnetischer Fluss bekannter Stärke eingekoppelt. Dieser Fluss kann den durch ein äußeres magnetisches Feld verursachten Fluss derart kompensieren, dass die über den SQIF abfallende Spannung minimal wird. Dieser sogenannte Arbeitspunkt liegt dann immer im absoluten Minimum der Eichkurve $\left\langle V(\vec{B}; I_0) \right\rangle$ des SQIF. Über den Wert des Kompensationsstroms kann, da der Abstand zwischen Steuerleitung und Netzwerk bekannt ist, die Stärke des äußeren Magnetfelds direkt bestimmt werden. Auch die Wahl eines anderen Arbeitspunkts innerhalb des Messbereichs des SQIF ist möglich. Diese Ausführung hat den Vorteil, dass der Operationsbereich des SQIF, d.h. der Bereich der Magnetfeldstärken, die mit der Vorrichtung gemessen werden können, prinzipiell nur durch Feldstärken, die die Phasenkohärenz zwischen den durch Tunnelbarrieren getrennten supraleitfähigen Bereichen zerstören, nach oben hin begrenzt ist. Ein weiterer Vorteil ist, dass in dieser Ausführung SQIFs auch dann noch voll funktionsfähig betrieben werden können, wenn der eigentliche Messbereich, d.h. der Bereich in dem die Spannungsantwortfunktion ein-eindeutig ist, sehr klein wird. Dies kann dann auftreten, wenn durch fertigungsbedingte Toleranzen Nebenminima der Spannungsantwortfunktion auftreten, deren Spannungswerte sich nicht sehr stark vom Spannungswert des absoluten Minimums unterscheiden. Solange der Messbereich jedoch größer als die Auflösungsgrenze des SQIF, die typischerweise bei einigen nV liegt, bleibt die Vorrichtung erfindungsgemäß in einer Ausführung mit Kompensationsschaltung voll funktionsfähig. Vorteilhaft an einer Ausführung mit Steuerleitungen ist auch, dass die Kompensationsschaltung on-chip angebracht ist und keine zusätzlichen Fertigungsschritte erfordert. Entsprechend dem derzeitigen Stand der Technik können die Steuerleitungen bei Dünnschichtaufbauten in den über oder den unter den Netzwerk-Zuführungsleitungen liegenden Schichten angebracht werden. Auch das Anbringen von mehreren Steuerleitungen kann von Vorteil sein, etwa wenn zu Präzisionsmessungen einem statischen Kompensationsfeld ein zeitlich variierendes Kompensationsfeld überlagert werden soll.

Für Operationsmodi, bei denen zeitlich variierende Kompensationsfelder verwendet werden, sollten SQIFs ihre maximale Empfindlichkeit erreichen. In solchen Modi ist darüber hinaus nicht nur die simultane Bestimmung der Stärke und der Richtung des zu messenden Feldes, sondern auch seiner Phasenlage möglich. Dies erlaubt die vollständige Rekonstruktion des gemessenen zeitveränderlichen Signals und damit die Erstellung einer identischen Kopie dieses Signals. Der Vorteil der Vorrichtungen liegt darin, dass solche Kopien ohne jeden Informationsverlust verstärkt und weitergeleitet werden können.

In Fig. 14 symbolisieren wiederum die Kreuze die Josephsonkontakte. Mit dem Bezugszeichen 120 sind symbolisch dargestellte bus-bar-Widerstände bezeichnet. Die strichpunktierte Linie beschreibt die Begrenzung des notwendigerweise supraleitenden Teils des Netzwerks.

In einer nicht dargestellten Ausführung für Präzisionsmessungen ist die Kompensationsschaltung außerhalb des SQIF angebracht und besteht aus einem Spulenpaar, welches derart orientiert ist, dass der SQIF in einer Ebene senkrecht zur Achse des Spulenpaars zwischen den beiden Spulen liegt. Solche Kompensationsschaltungen können den Vorteil haben, dass das magnetische Kompensationsfeld am Ort des SQIF eine sehr hohe Homogenität aufweist und dadurch äußerst präzise Messungen ermöglicht. Auch Ausführungen, bei denen lokal, d.h. durch Steuerleitungen, und durch außerhalb des SQIF angebrachte Kompensationsschaltungen, kompensiert wird, können von Vorteil sein, um den Einfluss von Störungen, wie etwa Rauschen und Fluktuationen, zu minimieren.

SQIF, welche über Kompensationsschaltungen, etwa in Form von Steuerleitungen verfügen, können auch als Logikbauelemente (Aktoren) für ultraschnelle Hochleistungsrechner verwendet werden. SQIFs mit zwei lokalen Steuerleitungen können ODER-Logikbausteine bereitstellen, die nur dann schalten, wenn durch beide Steuerleitungen ein exakt gleicher paralleler Strom fließt. Die Schaltzeiten solcher Aktoren liegen dabei im Bereich der Netzwerkfrequenz, d.h. im GHz bis THz Bereich. Ein Vorteil solcher Logikbausteine liegt dabei auch darin, dass sie gleichzeitig als Verstärker wirken, da sehr kleine Steuerströme bereits zur maximalen Spannungsantwort führen, die für heutzutage typische Josephsonkontakte mehrere hundert $\mu V$ bis $mV$ beträgt.

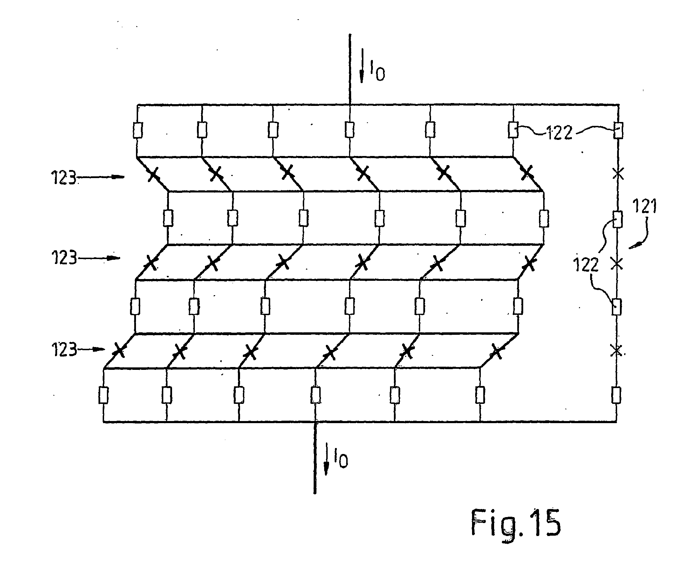

Durch eine Serienschaltung von SQIFs, wie dies in Fig. 15 dargestellt ist, die durch eine aktive Steuerleitung 121, welche ihrerseits wiederum Josephsonkontakte enthält, miteinander gekoppelt sind, kann die Empfindlichkeit bzw. der Verstärkungsfaktor der erfindungsgemäßen Anordnungen vervielfacht werden. Die Kreuze symbolisieren Josephsonkontakte. Mit dem Bezugszeichen 122 sind symbolisch dargestellte bus-bar-Widerstände bezeichnet. Die dick ausgezogenen Linien innerhalb des Netzwerks repräsentieren supraleitende Verbindungen und symbolisieren den supraleitenden Bereich 123, der auch die Josephsonkontakte enthält.

Die aktive Steuerleitung 121 bewirkt hierbei eine Synchronisation des eindimensionalen SQIF-arrays auch bei stark abweichenden Strukturfaktoren der verschiedenen SQIF-Abschnitte und Parameterinhomogenitäten. Sind die Fertigungstoleranzen klein, kann unter Umständen auf die aktive Steuerleitung auch verzichtet werden. Der Vorteil solcher SQIF-arrays, die auch zweidimensional ausgelegt sein können, liegt darin, dass die Auflösungsgrenze der Vorrichtung mit der Zahl der SQIF-Abschnitte 123 abnimmt und der Verstärkungsfaktor mit der Zahl der SQIF-Abschnitte anwächst. Im Bereich der Magnetfeldmessung sollten sich mit solchen Anordnungen bei optimaler Wahl des Operationsmodus zum Beispiel Auflösungsgrenzen erreichen lassen, die viele Größenordnungen niedriger sind als die bei konventionellen SQUID-Systemen. Auch SQIF-arrays lassen sich mit den dem Stand der Technik entsprechenden Fertigungsverfahren problemlos herstellen.

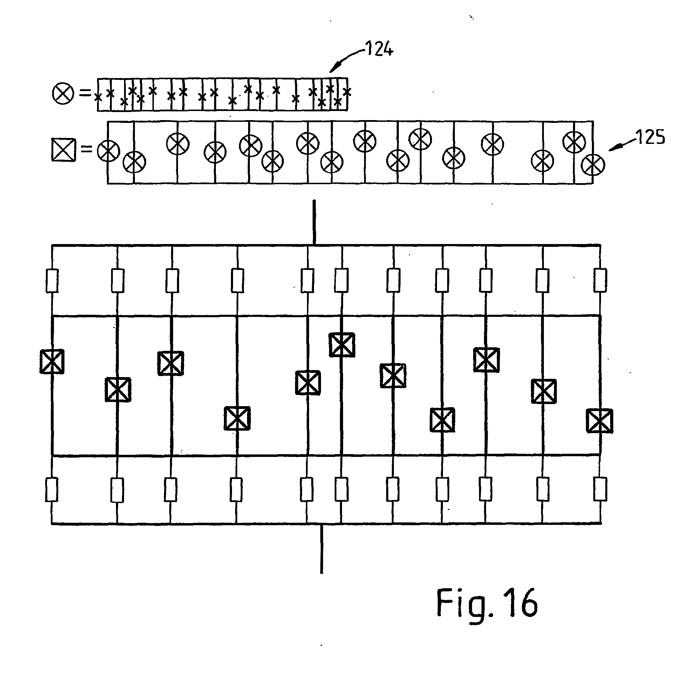

Ein Ausführungsbeispiel bei dem mehrere SQIF-Abschnitte 124 in einem hierarchisch gegliederten SQIF-array verschaltet sind, ist in Fig. 16 gezeigt. Die Basiselemente eines solchen hierarchischen SQIF-arrays sind hier identische Basis-SQIFs 124 mit identischem Strukturfaktor. Diese Basis-SQIFs sind auf einer zweiten Hierarchieebene wiederum in Form eines SQIFs 125 angeordnet, welcher erneut als Basis-SQIF 125 für eine dritte Hierarchieebene dient. Auch Anordnungen mit mehr als drei Hierarchieebenen ($k$=1,2,3,...) sind möglich. Der Vorteil solcher Anordnungen liegt darin, dass je nach den Verhältnissen der orientierten Flächenelemente des Basis-SQIF und dem oder der SQIFs höherer Hierarchieebenen, bedingt durch die im Allgemeinen verschiedenen Strukturfaktoren auf den verschiedenen Ebenen, die Interferenzmuster, die auf den verschiedenen Ebenen erzeugt werden, wiederum zu einem Gesamtmuster interferieren, was eine außerordentlich hohe Auflösung ermöglicht. Da die orientierten Flächenelemente $\vec{a}_m$ in den verschiedenen Hierarchieebenen unterschiedlich ausgerichtet werden können, ist das resultierende Interferenzmuster zudem extrem sensitiv bezüglich der Richtung des äußeren Feldes. Nach dem derzeitigen Stand der Fertigungstechnik können solche mehrdimensional ausgelegten SQIF-Systeme nicht on-chip realisiert werden. Es ist jedoch möglich, die einzelnen ebenen Bestandteile eines mehrdimensionalen SQIF-Systems mit herkömmlichen Methoden der Dünnschichttechnologie herzustellen und diese dann mit supraleitenden twisted-pair-Kabeln so zu verbinden, dass ein Gesamtsystem der beschriebenen Art entsteht. Solche supraleitenden twisted-pair-Kabel haben dabei den Vorteil, dass in sie kein effektiver Fluss eindringt. Die Verbindung verschiedener Teile eines SQIF-Systems mit solchen supraleitenden twisted-pair-Kabeln beeinflusst die Funktionsfähigkeit des Gesamt-SQIFs daher nicht, da in G1. 6 das Kabel lediglich als orientiertes Flächenelement mit verschwindend kleiner Fläche eingeht.

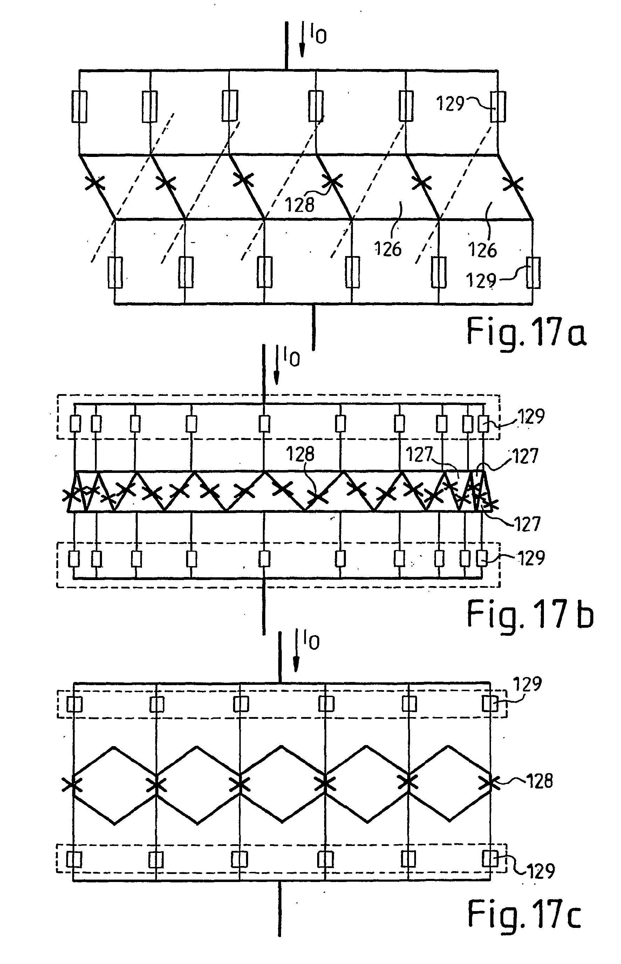

Ein Ausführungsbeispiel eines SQIF, das zeigt, wie die zwischen den verschiedenen Netzwerkzellen wirksamen induktiven Kopplungen minimiert werden können, ist in Fig. 17a dargestellt. Solche induktiven Kopplungen können die Empfindlichkeit der Vorrichtung vermindern, wenn das Netzwerk aus sehr vielen Zellen besteht. Da durch jeden Kontakt ein überkritischer Strom fließt, erzeugt die resultierende Stromverteilung in diesem Fall ein Eigenfeld, das unter Umständen nicht vernachlässigt werden kann. Durch erfindungsgemäße Ausführungen, wie sie etwa in Fig. 17b dargestellt sind, lässt sich der Einfluss der Eigenfelder stark reduzieren. In Fig. 17a und 17b sind die Leiterbahnen der Netzwerkzellen 126, 127 so ausgeführt, dass der durch einen Netzwerkkontakt 128 fließende Strom in der jeweils übernächsten Netzwerkzelle nur einen vernachlässigbaren Fluss induziert, da das magnetische Feld eines stromdurchflossenen kurzen Leiterstücks im Wesentlichen auf einen Bereich senkrecht zum Leiterstück beschränkt ist. Da für $\Phi$=0 jeder Kontakt von einem Strom gleicher Stärke durchflossen wird, verschwinden für diesen Fall alle Induktivitäten und das globale Minimum der Spannungsantwortfunktion entspricht dem nach G1. 8. Um die Eigenfelder der stromzuführenden und abführenden Leitungen zu minimieren, wird der Treiberstrom $I_0$ durch dem Stand der Technik entsprechende bus-bar-Widerstände 129, deren Entfernung zum Netzwerk groß genug gewählt werden kann, zu- und wieder abgeführt. Eine alternative, die gegenseitigen induktiven Einflüsse ebenfalls minimierende Ausführung eines SQIF ist in Fig. 17c dargestellt.

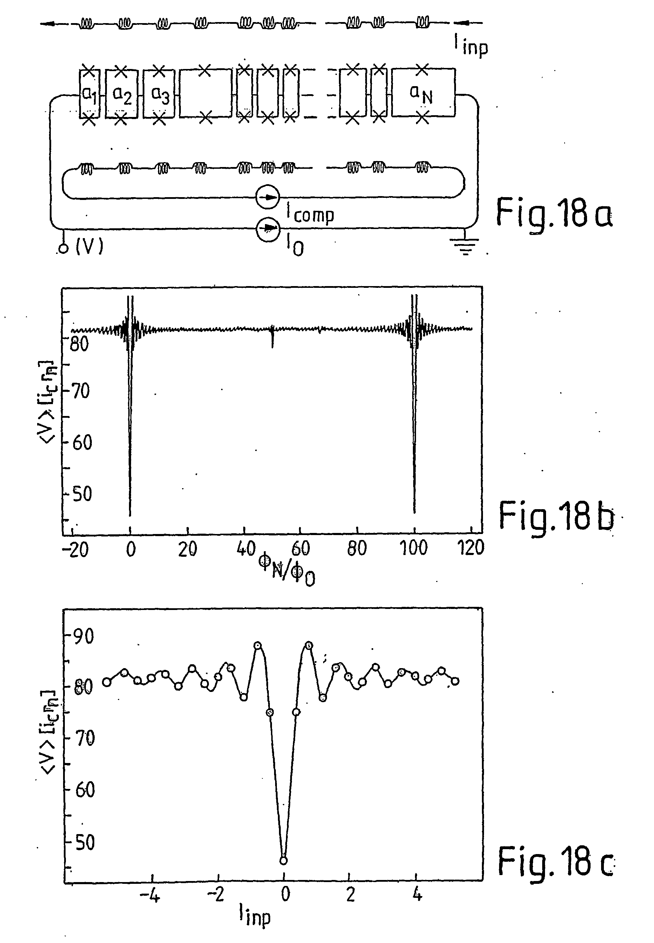

Ein Ausführungsbeispiel, bei dem die verschiedenen Netzwerkzellen in Serie geschaltet sind, ist in Fig. 18a dargestellt. Die orientierten Flächenelemente $\vec{a}_m$ sind auch hier so gewählt, dass die Spannungsantwortfunktion des Netzwerks nicht periodisch ist oder nur eine im Vergleich zu $\Phi_0$ sehr große Periode besitzt. Im Fall einer nichtperiodischen Spannungsantwortfunktion liegt genau bei $\vec{B} = 0$ das globale absolute Minimum dieser Spannungsantwortfunktion. In Fig. 18b ist eine typische Spannungsantwortfunktion einer Serienschaltung für $N$ =100 Netzwerkzellen $a_1$ bis $a_{100}$

und sehr großer Periode dargestellt.

Solche Ausführungen besitzen den Vorteil, dass sich bedingt durch die Serienschaltung die Spannungsantwortfunktionen der einzelnen Netzwerkzellen addieren. Dadurch entsteht ein Quanten-Interferenz-Filter mit einem sehr großen Spannungshub, der bis in den Bereich mehrerer mV oder gar V kommen kann. Im Gegensatz zur Parallelschaltung ergibt sich dabei jedoch keine Verminderung der Breite der Spannungsantwortfunktion (Varianz) um $\vec{B} = 0$ im Vergleich zu konventionellen zwei-Kontakt-SQUIDs. Da der Abstand benachbarter Netzwerkschlaufen in Serienanordnungen jedoch beliebig gewählt werden kann, ohne die Quanteninterferenzbedingung zu verletzen, können mit solchen Anordnungen die parasitären gegenseitigen Induktivitäten minimiert werden. Zudem können Serienschaltungen bei der Fertigung technisch bedingte Vorteile haben. Insbesondere ist eine erhöhte Packungsdichte möglich, was bei der Integration der Schaltungen auf einem Chip von Vorteil sein kann.

Die theoretische Beschreibung von Serien-SQIFs kann mit Hilfe von Gleichung 8 erfolgen, da ein Serien-SQIF die einfachste Realisierung eines zweidimensionalen SQIF-arrays darstellt. Für identische Netzwerkkontakte ist die über einer einzelnen Netzwerkzelle für einen überkritischen Treiberstrom $I_0 > 2i_c$ abfallende mittlere Gleichspannung durch

$$\langle V \rangle_n = i_c\, r_n \sqrt{\left(\frac{I_0}{2\,i_c}\right)^2 - \left|\cos\left(\pi\frac{\Phi_n}{\Phi_0}\right)\right|^2} \qquad (9)$$

gegeben, wobei $\Phi_n = \langle \vec{B}, \vec{a}_n \rangle$ gilt. Die über das gesamte Serienarray abfallende mittlere Gleichspannung $<V>$ ergibt sich daraus zu

$$\langle V \rangle = \sum_{n=1}^{N} \langle V \rangle_n \qquad . \qquad (10)$$

Zwar kann, bedingt durch die Serienanordnung der Netzwerkzellen $\vec{a}_n$, nicht direkt ein Strukturfaktor wie für die Parallelanordnung definiert werden, durch entsprechende Wahl der Folge $\{\vec{a}_n\}$ ist es jedoch auch hier möglich, den Verlauf der Spannungsantwortfunktion und insbesondere den Mess- bzw. Operationsbereich einzustellen.

Im Ausführungsbeispiel der Fig. 18b etwa wurden die orientierten Flächenelemente $\vec{a}_n$ in einer ebenen Serienanordnung entsprechend der arithmetischen Relation

$$a_n = \frac{n}{N} a_N \qquad (11)$$

gewählt, wobei $a_n = |\vec{a}_n|$ gilt und $\alpha_N$ die größte Fläche des Serien-SQIF mit $N$ Netzwerkzellen und $2N$ Kontakten bezeichnet. Eine solche Wahl hat z.B. den Vorteil, dass das Maximum der Spannungsantwortfunktion direkt auf das Minimum folgt (vgl. Fig. 18b) und so der Spannungshub maximal wird.

In Fig. 18a ist neben dem Serien-SQIF eine typische Ankoppel-und Steuerschaltung schematisch eingezeichnet. Bei entsprechender Auslegung wird durch den Kompensationsstrom $I_{comp}$ am Ort der einzelnen Netzwerkzellen ein magnetisches Kompensationsfeld erzeugt, das ein äußeres Feld und/oder das Feld, das durch den Strom $I_{inp}$ erzeugt wird, kompensiert. Dies ermöglicht den Betrieb des SQIF im extrem empfindlichen Nullabgleichmodus. Der Strom $I_{inp}$ ist dabei etwa der input-Strom einer pick-up-loop- oder einer anderen Signalquelle.

Serien-SQIFs können auch deshalb von großem Vorteil sein, weil das Eigenrauschen der Schaltung, etwa bei ihrer Verwendung als (Strom-) Verstärker, nur proportional zu $\sqrt{N}$ anwächst, während der Spannungshub proportional zu N anwächst. Dies ist deshalb der Fall, weil das Spannungsrauschen der unterschiedlichen Netzwerkzellen, bzw. der Josephsonkontakte in diesen Zellen, nicht korreliert ist (reine Stromkopplung), und sich daher nur inkohärent überlagert. Mit Serien-SQIFs oder allgemeinen SQIF-Arrays lassen sich dadurch etwa extrem rauscharme Verstärker realisieren. Eine typische Strom-Spannungskennlinie eines solchen Verstärkerbauteils, das durch einen SQIF realisiert werden kann, ist in Fig. 18c dargestellt. Je nach Auslegung das SQIF können in diesem Operationsmodus auch sehr kleine Ströme ($<10^{-12}A$) detektiert bzw. verstärkt werden. Weitere Vorteile solcher Verstärkerbauteile sind ihre sehr schnellen Schaltzeiten und ihre Anwendbarkeit bis zu sehr hohen Frequenzen.

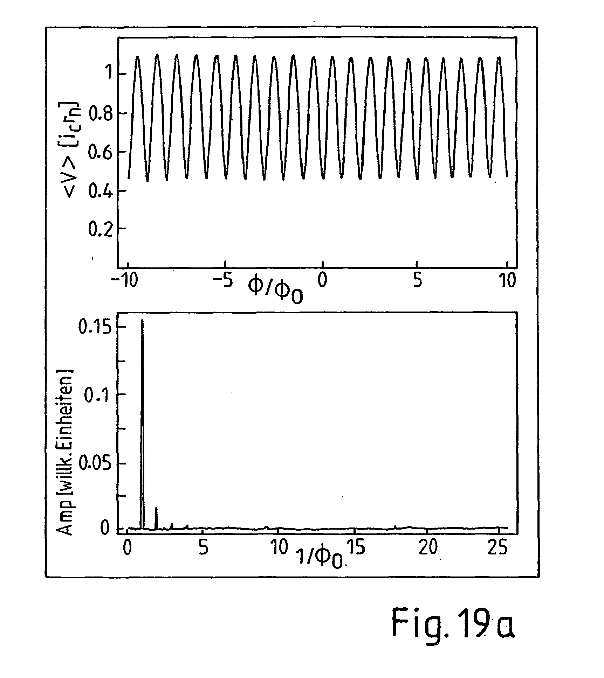

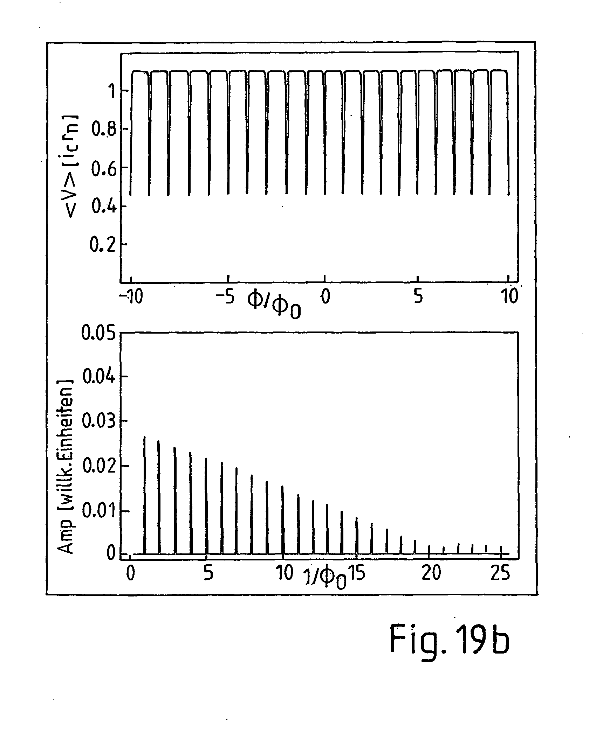

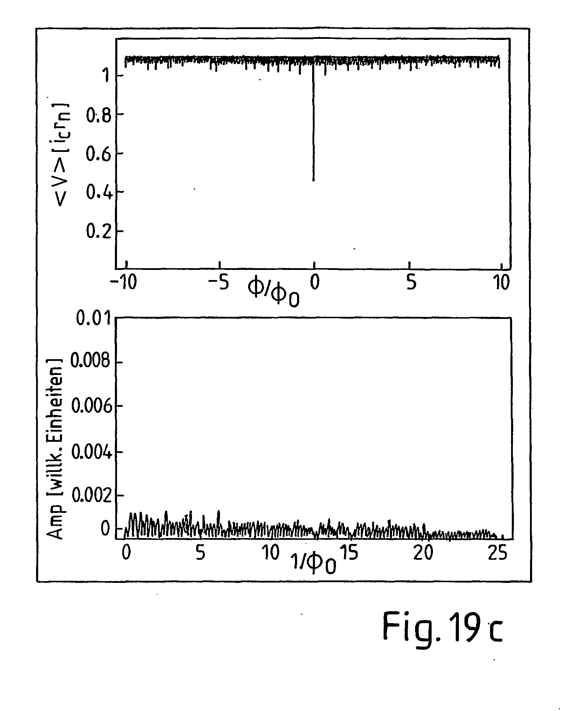

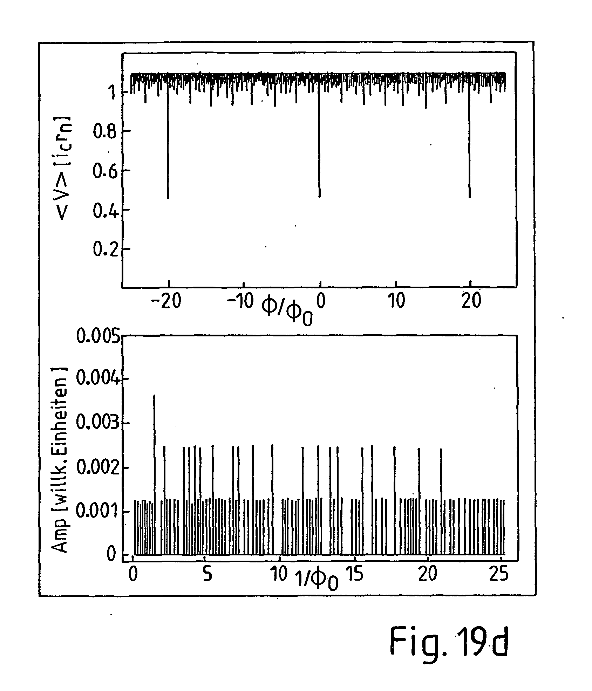

Die Periodizitätseigenschaften der Spannungsantwortfunktion sind ein wesentliches Merkmal von SQIFs. Das Frequenzspektrum der Spannungsantwortfunktionen von SQIFs in Bezug auf den magnetischen Fluss unterscheidet sich daher eindeutig von konventionellen SQUID-Interferometern. Dieser Sachverhalt ist in den Fig. 19a bis 19d anhand von typischen Frequenzspektren von SQUIDs (Fig. 19a und 19b) und von SQIFs (Fig. 19c und 19d) dargestellt.

Fig. 19a zeigt im oberen Bild die typische Spannungsantwortfunktion eines herkömmlichen SQUID. Die $<V(\Phi)>$-Kurve ist periodisch mit der Periode $\Phi_0$. Das zugehörige Frequenzspektrum im unteren Bild der Fig. 19a zeigt dementsprechend eine bei weitem dominierende Amplitude bei $1/\Phi_0$. Da die Spannungsantwortfunktion eines SQUID nicht harmonisch ist (vgl. G1.8), treten zusätzlich noch höhere harmonische Moden bei $2\Phi_0$ und $3\Phi_0$ auf, die jedoch lediglich eine sehr kleine Amplitude besitzen. Das Frequenzspektrum herkömmlicher SQUIDs wird damit vom $\Phi_0$-periodischen Beitrag dominiert. Wie Fig. 19b zeigt, ist dies auch bei Mehrschlaufenanordnungen, welche aus identischen Netzwerkzellen aufgebaut sind, der Fall, und zwar unabhängig davon, ob es sich um Serienanordnungen oder Parallelanordnungen identischer SQUID-Schlaufen handelt. Auch bei Parameterimperfektionen oder geometrischen Imperfektionen zeigen dem Stand der Technik entsprechende Quanten-Interferometer immer ein diskretes Frequenzspektrum, das vom $\Phi_0$-periodischen Beitrag dominiert wird. Bei Imperfektionen zusätzlich auftreten kann lediglich ein zusätzliches kontinuierliches Spektrum, das von den Imperfektionen herrührt und von der Art der Imperfektionen abhängt.

Quanten-Interferenz-Filter hingegen besitzen keinen dominanten $\Phi_0$-periodischen Beitrag im Frequenzspektrum ihrer Spannungsantwortfunktionen. Dieser Sachverhalt ist in Fig. 19c und Fig. 19d dargestellt. Die Frequenzspektren in den Fig. 19a bis 19c (untere Bilder) sind in den jeweils gleichen willkürlichen Einheiten aufgetragen, so dass ein direkter Vergleich möglich ist. Die Spannungsantwort und das zugehörige Frequenzspektrum eines Quanten-Interferenz-Filters, welche keine Periodizität besitzt, ist in Fig. 19c gezeigt. Das Spektrum ist praktisch kontinuierlich, ein diskretes Spektrum existiert nicht. Insbesondere existiert kein signifikanter $\Phi_0$ periodischer Beitrag. Die Amplituden des praktisch kontinuierlichen Spektrums sind um zwei bzw. eine Größenordnung kleiner als bei den herkömmlichen Anordnungen nach Fig. 19a bzw. Fig. 19b. In Fig. 19d ist die Spannungsantwortfunktion und das zugehörige Spektrum eines Quanten-Interferenz-Filters dargestellt, welcher eine technisch bedingte Periodizität besitzt. Die Spannungsantwortfunktion hat die Eigenschaft, dass ihre Periode sehr viel größer als $\Phi_0$ ist und das Frequenzspektrum besitzt einen diskreten Anteil mit einer sehr kleinen Amplitude bei der Periode $\Phi_0$. Diese Amplitude bei der Periode $\Phi_0$ ist nicht signifikant und liefert jedenfalls keinen dominanten Beitrag zum Frequenzspektrum. Das diskrete Spektrum ist zudem wiederum dadurch ausgezeichnet, dass dessen Amplituden im Vergleich zu den herkömmlichen Anordnungen um ein bis zwei Größenordnungen kleiner sind.

Die Frequenzspektren der Quanten-Interferenz-Filter sind im Hinblick auf den $\Phi_0$-periodischen Beitrag des Frequenzspektrums robust. Parameterimperfektionen oder geometrische Imperfektionen verändern die oben beschriebenen qualitativen Eigenschaften der Anordnungen nicht.

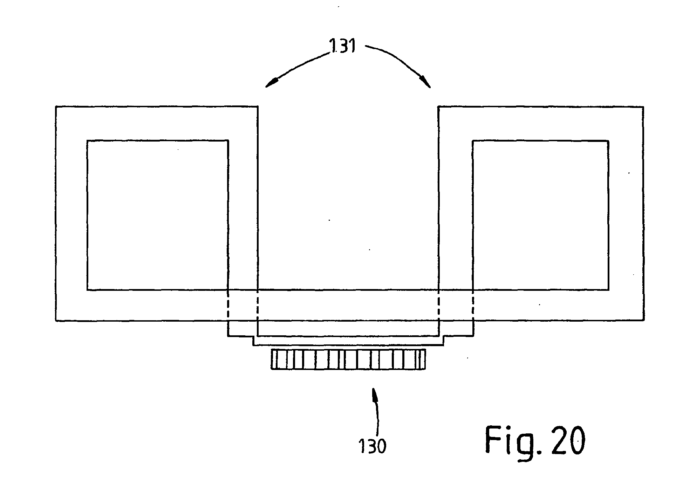

In Fig. 20 ist ein Ausführungsbeispiel eines ebenen SQIF 130 schematisch dargestellt, das mit einer supraleitenden Einkoppelschlaufe (pick-up-loop) versehen ist. Solche Einkoppelschlaufen verstärken das primäre magnetische Feld, indem sie den durch dieses Feld in ihrem Innern erzeugten Fluss nach außen verdrängen. Solche Vorrichtungen haben den Vorteil, dass durch eine geeignete Anordnung das primäre magnetische Feld am Ort des SQIF stark verstärkt werden kann. Ein weiterer Vorteil von SQIFs besteht darin, dass die Gesamtfläche von SQIFs so ausgelegt werden kann, dass die Impedanz-Fehlanpassung zwischen pick-up-loop und SQIF minimiert wird. Die Empfindlichkeit und die Auflösung von SQIFs kann durch solche Vorrichtungen erheblich gesteigert werden. Anstatt eines pick-up-loop können auch supraleitende Flächen (sog. washer) verwendet werden, welche ebenfalls zu den genannten Vorteilen führen. Auch die Ankopplung einer Gradiometerschlaufe ist möglich und führt zu den genannten Vorteilen bei der Messung von Magnetfeldgradienten. Bei der Detektion zeitveränderlicher elektromagnetischer Felder sind geeignet ausgelegt supraleitende Einkoppelschlaufen ebenfalls von Vorteil, da sie gleichzeitig als Empfangsantennen dienen können.

**Patentansprüche**

1. Antenne (60) für elektromagnetische Wellen hoher Frequenz, bestehend aus einer normalleitenden und/oder supraleitenden elektrischen Verschaltung von wenigstens einem tieftemperaturtauglichen Transistor (52) und primären Antennenstrukturen, Mittel (61) zur Versorgung der Verschaltung mit elektrischer Energie, Mittel zur Versorgung der Verschaltung mit einem Steuerstrom und/oder einer Steuerspannung, Mittel zur Ableitung einer elektromagnetischen Welle von der Verschaltung, **gekennzeichnet durch** einen aktiven Kühler, welcher wenigstens einem Teil der Verschaltung während des Betriebs Wärme entziehen kann und einem Vakuumgefäß (57), welches wenigstens einen Teil der Verschaltung und der primären Antennenstruktur enthält und mit welchem dieser Teil gegenüber der Umgebung thermisch isoliert werden kann, wobei der Transistor als aktives Bauelement wirkt, das Vakuumgefäß den Kühlfinger (58) des aktiven Kühlers enthält, der Kühlfinger thermisch an mindestens einen normalleitenden und/oder supraleitenden Hohlleiterabschluss der primären Antennenstruktur angekoppelt ist, das aktive Bauelement thermisch an den Kühlfinger angekoppelt ist, das aktive Bauelement an den Hohlleiterabschluss elektromagnetisch angekoppelt ist, das Vakuumgefäß ein für elektromagnetische Wellen durchlässiges Fenster (59) besitzt und geometrisch derart ausgebildet ist, dass eine elektromagnetische Welle in den Hohlleiterabschluss eingespeist werden kann, und der aktive Kühler dazu ausgelegt ist, zumindest einen Teil der Verschaltung unter eine vergleichsweise tiefe Temperatur von z.B. 150 Kelvin herunter zu kühlen.

2. Antenne nach Anspruch 1, **dadurch gekennzeichnet, dass** eine normalleitende und/oder supraleitende elektrische Verschaltung von wenigstens einem supraleitenden Quanten-Interferenz-Filter (51) vorgesehen ist, der geschlossene supraleitende eine Stromschleife bildende Zellen (107, 113, 107a, 114a), die jeweils mehrere, vorzugsweise zwei, Josephsohnkontakte (103, 104) enthalten, umfasst, wobei wenigstens drei dieser Zellen supraleitend und/oder nicht supraleitend in Verbindung stehen, die Kontakte der wenigstens drei Zellen derart bestrombar sind, dass jeweils über mindestens zwei Kontakte einer Zelle eine zeitveränderliche Spannung abfällt, deren zeitliches Mittel nicht verschwindet, die wenigstens drei Zellen auf eine Weise geometrisch unterschiedlich ausgestaltet sind, dass die bei einem vorhandenem magnetischen Feld von den Zellen eingeschlossenen magnetischen Flüsse sich derart unterscheiden, dass das Frequenzspektrum der Spannungsantwortfunktion in Bezug auf den magnetischen Fluss keinen signifikanten $\phi_0$-periodischen Anteil besitzt, oder dass, falls ein diskretes Frequenzspektrum existiert, der Beitrag des $\phi_0$-periodischen Anteils des diskreten Frequenzspektrums im Vergleich zu den nicht $\phi_0$-periodischen Anteilen des diskreten Frequenzspektrums nicht dominant ist, wobei der supraleitende Quanten-Interferenz-Filter und der Transistor als aktive Bauelemente wirken, die aktiven Bauelemente thermisch an den Kühlfinger angekoppelt sind, und wenigstens ein aktives Bauelement an den Hohlleiterabschluss elektromagnetisch angekoppelt ist.

3. Vorrichtung nach einem der Ansprüche 1 oder 2, **dadurch gekennzeichnet, dass** ein Teil der primären Antennenstruktur aus einem Hohlleiterabschluss besteht, in welchen wenigstens ein längliches Antennenelement, z.B. ein Antennenstift (54) hineinragt, der gegenüber dem Hohlleiter elektrisch isoliert ist, und das wenigstens eine Antennenelement mit dem Eingang wenigstens eines aktiven Bauelements elektrisch verbunden ist, und die Verschaltung mehrere aktive Bauelemente enthält, welche hintereinander geschaltet sind, und sich der Hohlleiterabschluss und der Teil der Verschaltung, welcher die aktiven Bauelemente enthält, in einem evakuierbaren Gefäß befinden und dem Hohlleiterabschluss und dem Teil der Verschaltung, welcher die aktiven Bauelemente enthält, Wärme entzogen werden kann.

4. Vorrichtung nach Anspruch 3, **dadurch gekennzeichnet, dass** in den Hohlleiterabschluss zwei Antennenelemente hineinragen, welche gegeneinander versetzt angebracht sind und welche jeweils einzeln mit dem Eingang eines aktiven Bauelements elektrisch verbunden sind, so dass aus dem Hohlleiterabschluss zwei unabhängige Polarisationen abgeleitet werden können.

5. Vorrichtung nach einem der vorhergehenden Ansprüche, **dadurch gekennzeichnet, dass** ein Teil der primären Antennenstrukturen aus wenigstens einer der folgenden Strukturen besteht:

   - einem Feld von normalleitenden und/oder supraleitenden Aperturantennen (63),
   - einem Feld von normal leitenden und/oder supraleitenden Patch-Antennen, (66)
   - einer oder mehreren elektromagnetischen Linsen (59),
   - einer oder mehreren Hornantennen (60) oder
   - einer oder mehreren Parabolantennen (64),

   deren Ausgangssignal über eine Hohlleiterstruktur und/oder eine normalleitende und/oder supraleitende Leitungsstruktur zusammengeführt und an wenigstens eines der aktiven Bauelemente angekoppelt ist.

6. Vorrichtung nach einem der vorhergehenden Ansprüche 2 bis 5, **dadurch gekennzeichnet, dass** die Elektroden des supraleitenden Quanten-Interferenz-Filters selbst als die primären Antennenstrukturen ausgelegt sind.

7. Vorrichtung nach einem der vorhergehenden Ansprüche 2 bis 6, **dadurch gekennzeichnet, dass** der supraleitenden Quanten-Interferenz-Filter mit einem Impedanzwandler ausgestattet ist, der die Impedanz des supraleitenden Quanten-Interferenz-Filters auf die Impedanz eines angeschlossenen Wellenleiters oder eines angeschlossenen Verbrauchers transformiert.

8. Vorrichtung nach einem der vorhergehenden Ansprüche 2 bis 7, **dadurch gekennzeichnet, dass** der supraleitende Quanten-Interferenz-Filter derart betrieben wird, dass der gemäß der Josephson-Relation schnell oszillierende Anteil der über dem supraleitenden Quanten-Interferenz-Filter abfallenden elektrischen Spannung auf die Trägerfrequenz der einfallenden elektromagnetischen Welle einlockt, so dass die über dem supraleitenden Quanten-Interferenz-Filter abfallende Spannung das frequenzdemodulierte Signal der einfallenden elektromagnetischen Welle enthält.

9. Vorrichtung nach einem der vorhergehenden Ansprüche 2 bis 8, **dadurch gekennzeichnet, dass** der supraleitende Quanten-Interferenz-Filter und die primäre Antennenstruktur auf einem gemeinsamen Träger aufgebracht sind.

10. Vorrichtung nach einem der vorhergehenden Ansprüche 2 bis 9, **dadurch gekennzeichnet, dass** der supraleitende Quanten-Interferenz-Filter und die primäre Antennenstruktur auf separaten Trägern aufgebracht sind.

11. Vorrichtung nach einem der vorhergehenden Ansprüche 2 bis 10, **dadurch gekennzeichnet, dass** der supraleitende Quanten-Interferenz-Filter auf einem Träger und die primäre Antennenstruktur auf einem anderen Träger aufgebracht sind und beide Träger übereinander liegen.

12. Vorrichtung nach einem der vorhergehenden Ansprüche 2 bis 11, **dadurch gekennzeichnet, dass** der supraleitende Quanten-Interferenz-Filter aus Korngrenzen - Josephsonkontakten aufgebaut ist und die Elektroden aus Hochtemperatursupraleitern bestehen.

13. Vorrichtung nach einem der vorhergehenden Ansprüche, **dadurch gekennzeichnet, dass** die primäre Antennenstruktur aus Hochtemperatursupraleitern besteht.

14. Vorrichtung nach einem der vorhergehenden Ansprüche, **dadurch gekennzeichnet, dass** sich die Antenne auf einem Chip befindet, der auf dem Kühlfinger des aktiven Kühlers angebracht ist und dass das Antennensignal mit einem schlecht wärmeleitenden Wellenleiter von besagtem Antennenchip abgeleitet wird.

15. Vorrichtung nach einem der vorhergehenden Ansprüche 2 bis 14, **dadurch gekennzeichnet, dass** der Betriebsstrom des supraleitenden Quanten-Interferenz-Filters durch den Wellenleiter zu- und abgeführt wird.

16. Vorrichtung nach einem der vorhergehenden Ansprüche, **dadurch gekennzeichnet, dass** die primäre Antennenstruktur aus einer oder einem Feld von Antennenstäben oder anderen elektrischen Leitern besteht deren Länge oder Abmessungen im Bereich der halben Wellenlänge der einfallenden elektromagnetischen Welle liegt.

17. Vorrichtung nach einem der vorhergehenden Ansprüche, **dadurch gekennzeichnet, dass** die primäre Antennenstruktur aus einer oder einem Feld von geschlossenen oder nicht geschlossenen Schlaufenantennen besteht.

18. Vorrichtung nach einem der vorhergehenden Ansprüche, **dadurch gekennzeichnet, dass** die primäre Antennenstruktur aus einer oder mehreren elektrisch kleinen Antennen besteht.

19. Vorrichtung nach einem der vorhergehenden Ansprüche, **dadurch gekennzeichnet, dass** die primäre Antennenstruktur auch oder ausschließlich aus dielektrischen Materialien besteht.

20. Vorrichtung nach einem der vorhergehenden Ansprüche, **dadurch gekennzeichnet, dass** die Antenne in einer resonanten Kavität betrieben wird, welche an geeigneter Stelle eine Öffnung für die mittelbar oder unmittelbar einfallende elektromagnetische Welle besitzt.

21. Vorrichtung nach einem der vorhergehenden Ansprüche, **dadurch gekennzeichnet, dass** die primäre Antennenstruktur mit zusätzlichen Filterelementen derart ausgestattet ist, dass ein oder mehrere Frequenzbänder selektiert werden.

22. Vorrichtung nach einem der vorhergehenden Ansprüche, **dadurch gekennzeichnet, dass** die Antenne zusätzliche elektronische Bauelemente, insbesondere elektrische Widerstände, Kondensatoren, Spulen, Filterbauelemente, Transistoren oder elektronische Verstärker, enthält.

23. Vorrichtung nach einem der vorhergehenden Ansprüche, **dadurch gekennzeichnet, dass** die Antenne auf einem Substrat in Mikrostreifenleitungstechnik aufgebracht wird, so dass eine elektrisch leitende Grundplatte die Gegenelektrode bildet.

24. Vorrichtung nach einem der vorhergehenden Ansprüche 2 bis 24, **dadurch gekennzeichnet, dass** die Antenne mit einer elektronischen Rückkoppelsteuerung ausgestattet ist, welche das Ausgangssignal des supraleitenden Quanten-Interferenz-Filters auf diesen zurückkoppelt.

25. Vorrichtung nach einem der vorhergehenden Ansprüche 2 bis 24, **dadurch gekennzeichnet, dass** der supraleitende Quanten-Interferenz-Filter der primären Antennenstruktur eine zeitveränderliche Spannung aufprägt, so dass in der primären Antennenstruktur ein zeitveränderlicher Antennenstrom fließt und die primäre Antennenstruktur eine elektromagnetische Welle abstrahlt.

26. Antennenfeld mit zwei oder mehr Antennen nach einem der vorhergehenden Ansprüche.

27. Antennenfeld nach Anspruch 26, **dadurch gekennzeichnet, dass** Mittel vorgesehen sind, mit welchen die Signale der im Antennenfeld angeordneten Antennen phasensensitiv zu einem Gesamtsignal überlagert werden können.

**Claims**

1. Aerial (60) for high frequency electromagnetic waves, consisting of a normal-conducting and/or superconducting electric interconnection of at least one transistor (52) suitable for low temperatures and primary aerial structures, means (61) for supplying the interconnection with electrical power, means for supplying the interconnection with a control current and/or a control voltage, means for deriving an electromagnetic wave from the interconnection, **characterised by** an active cooler, which can remove heat from at least one part of the interconnection during operation and a vacuum tank (57), which contains at least one part of the interconnection and the primary aerial structure and by means of which said part can be thermally insulated from the environment, wherein the transistor acts as an active component, the vacuum tank contains the cooling finger (58) of the active cooler, the cooling finger is connected thermally to at least one normal-conducting and/or superconducting hollow conductor terminal of the primary aerial structure, the active component is connected thermally to the cooling finger, the active component is connected electromagnetically to the hollow conductor terminal, the vacuum tank has a window (59) which is penetrable for electromagnetic waves and is designed geometrically so that an electromagnetic wave can be fed into the hollow conductor terminal and the active cooler is designed to cool down at least one part of the interconnection to a relatively low temperature of e.g. 150 Kelvin.

2. Aerial according to claim 1, **characterised in that** a normal-conducting and/or superconducting electric interconnection of at least one superconducting quantum interference filter (51) is provided, which comprises closed, superconducting cells (107...113, 107a....114a) forming a current loop, which each contain several, preferably two Josephson contacts (103, 104), wherein at least three of these cells are in connection in a superconducting and/or non-superconducting manner, the contacts of the at least three cells can be charged with current such that via at least two contacts of a cell a time-variable voltage is released, the time means of which does not disappear, the at least three cells are designed to be geometrically different in such a way that with an existing magnetic field the magnetic fluxes enclosed by the cells differ from one another such that the frequency spectrum of the voltage response function has no significant $F_0$-periodic component in relation to the magnetic flux, or, if there is a discreet frequency spectrum, the proportion of the $F_0$-periodic component of the discreet frequency spectrum is not dominant compared to the non $F_0$-periodic components of the discreet frequency spectrum, wherein the superconducting quantum interference filter and the transistor function as active components, the active components are thermally connected to the cooling finger and at least one active component is electromagnetically connected to the hollow conductor terminal.

3. Device according to one of claims 1 or 2, **characterised in that** a part of the primary aerial structure consists of a hollow conductor terminal, into which at least one elongated aerial element projects, e.g. an aerial pin (54), which is electrically insulated from the hollow conductor, and the at least one aerial element is connected electrically to the input of at least one active component, and the interconnection contains several active components which are connected one behind the other, and the hollow conductor terminal and the part of the interconnection, which contains the active components, are located in a dischargeable tank, and heat can be removed from the hollow conductor terminal and the part of the interconnection which contains the active components.

4. Device according to claim 3, **characterised in that** into the hollow conductor terminal two aerial elements project, which are arranged offset relative to one another and which are each electrically connected individually to the input of an active component, so that from the hollow conductor terminal two independent polarisations can be derived.

5. Device according to one of the preceding claims, **characterised in that** a portion of the primary aerial structures consists of at least one of the following structures:

   - a field of normal-conducting and/or superconducting aperture aerials (63),
   - a field of normal-conducting and/or superconducting patch aerials (66),
   - one or more electromagnetic lenses (59),
   - one or more horn aerials (60) or
   - one or more parabolic aerials (64),

   the output signal of which is brought together via a hollow conductor structure and/or a normal-conducting and/or superconducting line structure and is coupled to at least one of the active components.

6. Device according to one of the preceding claims 2 to 5, **characterised in that** the electrodes of the superconducting quantum interference filter itself are designed as the primary aerial structures.

7. Device according to one of the preceding claims 2 to 6, **characterised in that** the superconducting quantum interface filter is equipped with an impedance transformer, which transforms the impedance of the superconducting quantum interference filter to the impedance of a connected waveguide or a connected consumer unit.

8. Device according to one of the preceding claims 2 to 7, **characterised in that** the superconducting quantum interference filter is operated such that the portion of electric voltage releasing via the superconducting quantum interference filter, which oscillates rapidly in accordance with the Josephson relation, locks onto the carrier frequency of the incidental electromagnetic wave, so that the voltage releasing via the superconducting quantum interference filter contains the frequency-demodulated signal of the incidental electromagnetic wave.

9. Device according to one of the preceding claims 2 to 8, **characterised in that** the superconducting quantum interference filter and the primary aerial structure are attached to a common carrier.

10. Device according to one of the preceding claims 2 to 9, **characterised in that** the superconducting quantum inference filter and the primary aerial structure are attached to separate carriers.

11. Device according to one of the preceding claims 2 to 10, **characterised in that** the superconducting quantum interference filter is attached to a carrier and the primary aerial structure is attached to a different carrier and both carriers lie on top of one another.

12. Device according to one of the preceding claims 2 to 11, **characterised in that** the superconducting quantum interference filter is constructed from grain boundary-Josephson contacts, and the electrodes consist of high temperature superconductors.

13. Device according to one of the preceding claims, **characterised in that** the primary aerial structure consists of high temperature superconductors.

14. Device according to one of the preceding claims, **characterised in that** the aerial is located on a chip, which is attached to the cooling finger of the active cooler, and **in that** the aerial signal with a poor heat-conducting waveguide is derived from said aerial chip.

15. Device according to one of the preceding claims 2 to 14, **characterised in that** the operating current of the superconducting quantum interference filter is supplied and removed by the waveguide.

16. Device according to one of the preceding claims, **characterised in that** the primary aerial structure consists of one or a field of aerial rods or other electric conductors, the length or dimensions of which lie in the region of the half wavelength of the incidental electromagnetic wave.

17. Device according to one of the preceding claims, **characterised in that** the primary aerial structure consists of one or a field of closed or non-closed loop aerials.

18. Device according to one of the preceding claims, **characterised in that** the primary aerial structure consists of one or more electrically small aerials.

19. Device according to one of the preceding claims, **characterised in that** the primary aerial structure consists also or exclusively of dielectric materials.

20. Device according to one of the preceding claims, **characterised in that** the aerial is operated in a resonant cavity, which at a suitable point has an opening for the indirectly or directly incidental electromagnetic wave.

21. Device according to one of the preceding claims, **characterised in that** the primary aerial structure is equipped with additional filter elements so that one or more frequency bands are selected.

22. Device according to one of the preceding claims, **characterised in that** the aerial contains additional electronic components, in particular electric resistors, capacitors, coils, filter components, transistors or electronic amplifiers.

23. Device according to one of the preceding claims, **characterised in that** the aerial is applied to a substrate in a microstrip conducting technique, so that an electrically conducting base plate forms the counterelectrode.

24. Device according to one of the preceding claims 2 to 24, **characterised in that** the aerial is equipped with an electronic feedback control, which loops back the output signal of the superconducting quantum interference filter to the latter.

25. Device according to one of the preceding claims 2 to 24, **characterised in that** the superconducting quantum interference filter of the primary aerial structure impresses a time-variable voltage, so that in the primary aerial structure a time-variable aerial current flows and the primary aerial structure radiates an electromagnetic wave.

26. Aerial field with two or more aerials according to one of the preceding claims.

27. Aerial field according to claim 26, **characterised in that** means are provided by which the signals of the aerials arranged in the aerial field can be superimposed in a phase-sensitive manner to form a complete signal.


**Revendications**

1. Antenne (60) pour ondes électromagnétiques de haute fréquence, composée d'un couplage électrique normal et/ou supraconducteur d'au moins un transistor (52) résistant à basse température et de structures primaires d'antenne, de moyens (61) destinés à l'alimentation du couplage en énergie électrique, de moyens destinés à l'alimentation du couplage avec un courant de commande et/ou une tension de commande, de moyens destinés à dériver une onde électromagnétique du couplage,
   **caractérisée par** un réfrigérateur actif, lequel peut dissiper la chaleur d'au moins une partie du couplage en cours de fonctionnement, et un récipient sous vide (57), lequel contient au moins une partie du couplage et de la structure primaire d'antenne et grâce auquel cette partie peut être isolée thermiquement de l'environnement, le transistor faisant office de composant actif, le récipient sous vide contenant le doigt réfrigérant (58) du réfrigérateur actif, le doigt réfrigérant étant thermiquement couplé à au moins une terminaison de guide d'onde normale et/ou supraconductrice de la structure primaire d'antenne, le composant actif étant thermiquement couplé au doigt réfrigérant, le composant actif étant couplé de manière électromagnétique à la terminaison de guide d'onde, le récipient sous vide possédant une fenêtre (59) perméable aux ondes électromagnétiques et étant géométriquement réalisé de telle façon qu'une onde électromagnétique peut être introduite dans la terminaison de guide d'onde, et le réfrigérateur actif étant conçu afin de refroidir au moins une partie du couplage sous une température relativement basse de par ex. 150 Kelvin.

2. Antenne selon la revendication 1,
   **caractérisée en ce qu'**il est prévu un couplage électrique normal et/ou supraconducteur d'au moins un filtre supraconducteur d'interférence quantique (51), lequel comporte des cellules (107...113, 107a...114a) fermées supraconductrices formant une boucle de courant, lesquelles cellules comportent chacune plusieurs, de préférence deux, contacts Josephson (103, 104), au moins trois de ces cellules étant en liaison de manière supraconductrice et/ou non supraconductrice, les contacts des au moins trois cellules pouvant être excités de telle façon qu'à chaque fois sur au moins deux contacts d'une cellule une tension alternative chute, dont la moyenne dans le temps ne disparaît pas, les au moins trois cellules étant réalisées géométriquement différentes de sorte que les flux magnétiques renfermés par les cellules en cas de présence d'un champ magnétique se différencient de telle façon que le spectre de fréquences de la fonction de réponse en tension ne possède pas de part périodique $\phi_0$ significative par rapport au flux magnétique, ou que, dans le cas où il existe un spectre de fréquences discret, la contribution de la part périodique $\phi_0$ du spectre de fréquences discret n'est pas dominante comparée aux parts non périodiques $\phi_0$ du spectre de fréquences discret, le filtre supraconducteur d'interférence quantique et le transistor faisant office de composants actifs, les composants actifs étant thermiquement couplés au doigt réfrigérant, et au moins un composant actif étant couplé de manière électromagnétique à la terminaison de guide d'onde.

**3.** Dispositif selon l'une des revendications 1 ou 2,
**caractérisé en ce qu'**une partie de la structure primaire d'antenne est composée d'une terminaison de guide d'onde dans laquelle dépasse au moins un élément d'antenne de forme allongée, par ex. une tige d'antenne (54), qui est électriquement isolé(e) par rapport au guide d'onde, et **en ce que** le au moins un élément d'antenne est électriquement relié à l'entrée d'au moins un composant actif, et le couplage comporte plusieurs composants actifs, lesquels sont branchés les uns derrière les autres, et la terminaison de guide d'onde et la partie du couplage qui contient les composants actifs se trouvent dans un récipient pouvant être mis sous vide et la chaleur peut être évacuée de la terminaison de guide d'onde et de la partie du couplage contenant les composants actifs.

**4.** Dispositif selon la revendication 3,
**caractérisé en ce que** dans la terminaison de guide d'onde il dépasse deux éléments d'antenne, lesquels sont agencés de manière décalée l'un par rapport à l'autre et lesquels sont chacun individuellement reliés électriquement à l'entrée d'un composant actif de manière que deux polarisations indépendantes peuvent être dérivées de la terminaison de guide d'onde.

**5.** Dispositif selon l'une des revendications précédentes,
**caractérisé en ce qu'**une partie des structures primaires d'antenne est composée d'au moins une des structures suivantes :

- un champ d'antennes à ouverture (63) normales et/ou supraconductrices,
- un champ d'antennes planaires (66) normales et/ou supraconductrices,
- une ou plusieurs lentilles électromagnétiques (59),
- une ou plusieurs antennes-cornets (60) ou
- une ou plusieurs antennes paraboliques (64),

dont le signal de sortie est concentré et guidé par le biais d'une structure de guide d'onde et/ou une structure de guidage normale et/ou supraconductrice et est couplé à au moins un des composants actifs.

**6.** Dispositif selon l'une des revendications précédentes 2 à 5, **caractérisé en ce que** les électrodes du filtre supraconducteur d'interférence quantique lui-même forment les structures primaires d'antenne.

**7.** Dispositif selon l'une des revendications précédentes 2 à 6,
**caractérisé en ce que** le filtre supraconducteur d'interférence quantique est équipé d'un adaptateur d'impédance, lequel transforme l'impédance du filtre supraconducteur d'interférence quantique en l'impédance d'un guide d'onde connecté ou d'un consommateur connecté.

**8.** Dispositif selon l'une des revendications précédentes 2 à 7,
**caractérisé en ce que** le filtre supraconducteur d'interférence quantique fonctionne de manière que la partie oscillant rapidement selon la relation Josephson de la tension électrique chutant par le biais du filtre supraconducteur d'interférence quantique se bloque sur la fréquence porteuse de l'onde électromagnétique incidente, de sorte que la tension chutant par le biais du filtre supraconducteur d'interférence quantique contient le signal à fréquence modulée de l'onde électromagnétique incidente.

**9.** Dispositif selon l'une des revendications précédentes 2 à 8,

**caractérisé en ce que** le filtre supraconducteur d'interférence quantique et la structure primaire d'antenne sont montés sur un support commun.

10. Dispositif selon l'une des revendications précédentes 2 à 9,
**caractérisé en ce que** le filtre supraconducteur d'interférence quantique et la structure primaire d'antenne sont montés sur des supports séparés.

11. Dispositif selon l'une des revendications précédentes 2 à 10,
**caractérisé en ce que** le filtre supraconducteur d'interférence quantique est monté sur un support et la structure primaire d'antenne sur un autre support et **en ce que** les deux supports sont superposés.

12. Dispositif selon l'une des revendications précédentes 2 à 11,
**caractérisé en ce que** le filtre supraconducteur d'interférence quantique est formé de contacts Josephson sur joints de grains et les électrodes sont en supraconducteurs haute température.

13. Dispositif selon l'une des revendications précédentes,
**caractérisé en ce que** la structure primaire d'antenne est en supraconducteurs haute température.

14. Dispositif selon l'une des revendications précédentes,
**caractérisé en ce que** l'antenne se trouve sur une puce qui est montée sur le doigt réfrigérant du réfrigérateur actif et **en ce que** le signal d'antenne est dérivé de ladite puce d'antenne à l'aide d'un guide d'onde conduisant mal la chaleur.

15. Dispositif selon l'une des revendications précédentes 2 à 14,
**caractérisé en ce que** le courant de fonctionnement du filtre supraconducteur d'interférence quantique est amené et distribué par le guide d'onde.

16. Dispositif selon l'une des revendications précédentes,
**caractérisé en ce que** la structure primaire d'antenne est composée d'une antenne en bâtons ou d'un champ d'antennes en bâtons ou autres conducteurs électriques dont la longueur ou les dimensions sont comprises dans la plage de la demi-longueur d'onde de l'onde électromagnétique incidente.

17. Dispositif selon l'une des revendications précédentes,
**caractérisé en ce que** la structure primaire d'antenne est composée d'une antenne en boucle ou d'un champ d'antennes en boucles fermées ou non fermées.

18. Dispositif selon l'une des revendications précédentes,
**caractérisé en ce que** la structure primaire d'antenne est composée d'une ou plusieurs antennes électriquement petites.

19. Dispositif selon l'une des revendications précédentes,
**caractérisé en ce que** la structure primaire d'antenne est composée, également ou exclusivement, de matériaux diélectriques.

20. Dispositif selon l'une des revendications précédentes,
**caractérisé en ce que** l'antenne fonctionne dans une cavité résonante, laquelle possède à un endroit approprié une ouverture pour l'onde électromagnétique incidente directe ou indirecte.

21. Dispositif selon l'une des revendications précédentes,
**caractérisé en ce que** la structure primaire d'antenne est équipée d'éléments filtrants supplémentaires de manière à sélectionner une ou plusieurs bandes de fréquences.

22. Dispositif selon l'une des revendications précédentes,
**caractérisé en ce que** l'antenne comporte des composants électroniques supplémentaires, notamment des résistances électriques, des condensateurs, des bobines, des composants filtrants, des transistors ou des amplificateurs électroniques.

23. Dispositif selon l'une des revendications précédentes,

**caractérisé en ce que** l'antenne est montée sur un substrat selon la technique des microbandes, de telle sorte qu'une plaque de base électriquement conductrice forme la contre-électrode.

24. Dispositif selon l'une des revendications précédentes 2 à 23,
**caractérisé en ce que** l'antenne est équipée d'une commande de réinjection électronique, laquelle réinjecte le signal de sortie du filtre supraconducteur d'interférence quantique sur celui-ci.

25. Dispositif selon l'une des revendications précédentes 2 à 24,
**caractérisé en ce que** le filtre supraconducteur d'interférence quantique de la structure primaire d'antenne imprime une tension alternative de sorte que la structure primaire d'antenne est traversée par un courant d'antenne alternatif et que la structure primaire d'antenne émet une onde électromagnétique.

26. Champ d'antennes comportant deux antennes ou plus selon l'une des revendications précédentes.

27. Champ d'antennes selon la revendication 26,
**caractérisé en ce qu'**il est prévu des moyens avec lesquels les signaux des antennes agencées dans le champ d'antennes peuvent être superposés de manière sensible à la phase pour former un signal global.

Fig. 1

Fig. 2a

Fig. 2b

Betriebsstrom SQIF

Betriebsstrom SQIF

6

7a

7b

7

7

EP 1 634 351 B1

Fig. 2c

EP 1 634 351 B1

Fig. 2d

Fig. 3

EP 1 634 351 B1

Fig. 4a

EP 1 634 351 B1

Fig. 4b

Fig. 4c

Fig. 5

Fig. 6

Fig. 7a

Fig. 7b

Fig. 8

EP 1 634 351 B1

EP 1 634 351 B1

Fig. 9a

Fig. 9b

46

EP 1 634 351 B1

$|\vec{a_1}|$  $|\vec{a_2}|$  $|\vec{a_3}|$  $|\vec{a_4}|$  $|\vec{a_5}|$  $|\vec{a_6}|$  $|\vec{a_7}|$  $|\vec{a_9}|$

$|\vec{a_8}|$

114

114

$I_0$

$I_0$

< V >

Fig.10

47

Fig.10a

Fig.10b

Fig.10c

Fig.10d

Fig.10e

Fig.10f

Fig.11

Fig.12 a

Fig.12 b

Fig.12 c

Fig. 12 d

Fig.13

Fig. 14

Fig.15

Fig. 16

$I_0$

129

128

126    126

129

Fig. 17a

$I_0$

129

128    127    127

127

129

Fig. 17 b

$I_0$

129

128

129

Fig. 17c

Fig.18 a

Fig.18 b

Fig.18 c

Fig. 19 a

Fig. 19 b

Fig. 19 c

Fig. 19d

Fig. 20

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente

- JP 2003023362 A
- DE 0003034 W
- DE 10043657 A1

### In der Beschreibung aufgeführte Nicht-Patentliteratur

- **VON HANSEN ; BINSLEV J. ; LINDELOF P.E.** Static and dynamic interactions between Josephson junctions. *Reviews of Modern Physics,* Juli 1984, vol. 56 (3), 431-459
- **J.D. KRAUS.** Antennas. Mc Graw-Hill, 1988
- **S. RAMO ; J.R. WHINNERY ; T. VANDUZER.** Fields and waves in communication electronics. John Wiley, 1994
- **A. BARONE ; G. PATERNO.** Physics and Applications of the Josephson Effect. John Wiley, 1982
- **J. HINKEN.** Superconducting Electronics. Springer, 1988
- **K.K. LIKHAREV.** Dynamics of Josephson junctions and circuits. Gordon and Breach, 1991
- **R.D. PARMENTIER ; N.F. PEDERSEN.** Nonlinear superconducting devices and High-Tc materials. World Scientific, 1995
- SQUIDS. **J.C. GALLOP et al.** the Josephson Effect and superconducting electronics. Hilger, 1991
- SQUID Sensors: Fundamentals. Fabrication and Applications. Kluwer Academic Publishers, 1996
- **J. OPPENLÄNDER ; CH. HÄUßLER ; N. SCHOPOHL.** Phys. Rev. B. 2001, vol. 63, 024511
- **CH. HÄUßLER ; J. OPPENLÄNDER ; N. SCHOPOHL.** *J. Appl. Phys.,* 2001, vol. 89, 1875
- **J. OPPENLÄNDER ; T. TRÄUBLE ; CH. HÄUßLER ; N. SCHOPOHL.** *IEEE Trans. Appl. Supercond.,* 2001, vol. 11, 1271
- **J. OPPENLÄNDER ; CH. HÄUßLER ; T. TRÄUBLE ; N. SCHOPOHL.** *Physica C,* 2002, vol. 368, 119
- **V. SCHULTZE ; R. IJSSELSTEIJN ; H.-G. MEYER ; J. OPPENLÄNDER ; CH. HÄUßLER ; N. SCHOPOHL.** *IEEE Trans. Appl. Supercond,* Juni 2003, vol. 13